# EUROPEAN PATENT APPLICATION

(11) **EP 4 546 568 A1**
(43) Date of publication of application: **30.04.2025**
(21) Application number: 23831451.2
(22) Date of filing: 27.06.2023
(51) Int. Cl.: H01Q 15/14, G03F 9/00, H01Q 15/10

(54) **REFLECTION STRUCTURE, METHOD FOR MANUFACTURING REFLECTION STRUCTURE, AND FREQUENCY-SELECTIVE REFLECTION PLATE SET**

(30) Priority: 27.06.2022 JP 2022102694
(71) Applicant: Dai Nippon Printing Co., Ltd., Tokyo 162-8001 (JP)
(72) Inventor: ASAKURA, Hiroyuki, Tokyo 162-8001 (JP); NAKAMURA, Atsuo, Tokyo 162-8001 (JP); MIYAZAKI, Yuichi, Tokyo 162-8001 (JP); ISAWA, Yusuke, Tokyo 162-8001 (JP); ABE, Makoto, Tokyo 162-8001 (JP)
(74) Representative: Müller-Boré & Partner Patentanwälte PartG mbB
(86) International application number: PCT/JP2023/023785
(87) International publication number: WO 2024/005011

(57) **Abstract**

The present disclosure provides a reflecting structure including a frequency selective reflector reflecting electromagnetic waves in a particular frequency band in a direction different from a regular reflection direction, the reflecting structure including: a substrate including a first alignment mark; and a plurality of the frequency selective reflectors disposed side by side on one surface of the substrate, wherein a distance between adjacent the frequency selective reflectors is less than 1/2 of a wavelength of the electromagnetic waves.

## Description

### Technical Field

The present disclosure relates to a reflecting structure including a frequency selective reflector reflecting electromagnetic waves in a particular frequency band in a direction different from a regular reflection direction.

### Background Art

To improve the propagation environment and area in a mobile communication system, the technique of the reflect array has been considered (such as in Patent Documents 1 to 2, Non-Patent Document 1). In particular, high frequency, such as those used in fifth generation communication systems (5G), are strong in straightness, and thus, the resolution of coverage holes, regions to which radio waves does not reach, is an important issue.

It is desired that the reflect array be capable of reflecting electromagnetic waves to a desired direction relative to electromagnetic waves of a particular frequency incident from a base station in a given direction. In such a reflect array, for example, a plurality of reflective elements is arranged. By varying the size and shape of the reflective element, the resonant frequency of each reflective element is varied to control the reflection phase of the electromagnetic wave. A technique for controlling the incident direction and the reflection direction of electromagnetic waves by controlling the reflection phase of electromagnetic waves has been developed.

### Citation List

### Patent Documents

Patent Document 1: Japanese Patent No. 5371633
Patent Document 2: Japanese Patent No. 5162677

### Non-Patent Documents

Non-Patent Document 1: Mayumi YOSHINO et. al. "Received Power Improvement in NLoS Region of L-Shaped Corridor by Utilizing Meta-Surface Reflector", THE INSTITUTE OF ELECTRONICS, INFORMATION AND COMMUNICATION ENGINEERS, IEICE Technical Report, A▪P2020-5(2020-04)

### Summary

### Technical Problem

A reflect array having a large area is necessary to reflect the electromagnetic waves with high intensity in the coverage hole. However, it is difficult to produce the reflect array having a large area due to constraint on the production device.

Incidentally, to allow the reflect array to have large area, for example, a tiling technique of disposing the reflect array side by side is considered. However, in the case of allowing the reflect array to have large area by tiling, deviation of the relative position in a plurality of the reflect arrays is a problem. The deviation of the relative position of the reflect arrays may degrade the reflection intensity of the electromagnetic waves and may change the reflection phase of the electromagnetic waves, and thus the desired reflection properties may not be obtained.

Although it is not in the reflect array, the tiling technique has been developed in the field of a display device. However, while the important issue in the display device is visibility of the seams of each display device, the important object in the reflect array is the relative position accuracy of each reflect array. Also, in the reflect array, it is considered that higher position accuracy is required compared to the display device. For this reason, it is considered difficult to apply the tiling technique of the display device as it is to the reflect array.

The present disclosure has been made in view of the above circumstances, and a main object thereof is to provide a reflecting structure including a frequency selective reflector that reflects electromagnetic waves in a particular frequency band in a direction different from the regular reflection direction, wherein the reflecting structure has excellent reflection properties and can have large area.

### Solution to Problem

The first embodiment of the present disclosure provides a reflecting structure including a frequency selective reflector reflecting electromagnetic waves in a particular frequency band in a direction different from a regular reflection direction, the reflecting structure including: a substrate including a first alignment mark; and a plurality of the frequency selective reflectors disposed side by side on one surface of the substrate, wherein a distance between adjacent the frequency selective reflectors is less than 1/2 of a wavelength of the electromagnetic waves.

Another embodiment of the present disclosure provides a reflecting structure including a frequency selective reflector reflecting electromagnetic waves in a particular frequency band in a direction different from a regular reflection direction, the reflecting structure including: a substrate; and a plurality of the frequency selective reflectors disposed side by side on one surface of the substrate, wherein two adjacent sides in at least one of the frequency selective reflectors are aligned with two adjacent sides in the substrate; and
a distance between adjacent the frequency selective reflectors is less than 1/2 of a wavelength of the electromagnetic waves.

Another embodiment of the present disclosure provides a reflecting structure including a frequency selective reflector reflecting electromagnetic waves in a particular frequency band in a direction different from a regular reflection direction, the reflecting structure including: a substrate including a first alignment mark; and the frequency selective reflector disposed on one surface of the substrate, wherein the frequency selective reflector includes: a reflecting member that is disposed on one surface of the substrate and reflects the electromagnetic waves, and a plurality of dielectric layers that is disposed side by side on the reflecting member side surface of the substrate, and transmits the electromagnetic waves, wherein a distance between adjacent the dielectric layers is less than 1/2 of a wavelength of the electromagnetic waves, the dielectric layer includes a concave and convex structure in which a plurality of unit structures with a thickness distribution of increasing thickness in a predetermined direction is disposed, the unit structures of the dielectric layer include a plurality of cell regions with different thicknesses, in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layer includes, as the unit structure, at least a first unit structure including three or more of the cell regions of which thicknesses differ from one another, and a reflection direction of the electromagnetic waves is controlled by controlling a relative reflection phase distribution of the electromagnetic waves by the thickness distribution of the dielectric layer.

Another embodiment of the present disclosure provides a reflecting structure including a frequency selective reflector reflecting electromagnetic waves in a particular frequency band in a direction different from a regular reflection direction, the reflecting structure including: a substrate; and the frequency selective reflector disposed on one surface of the substrate, wherein the frequency selective reflector includes: a reflecting member that is disposed on one surface of the substrate, and reflects the electromagnetic waves, and a plurality of dielectric layers that is disposed side by side on the reflecting member side surface of the substrate, and transmits the electromagnetic waves, wherein two adjacent sides in at least one of the dielectric layers are aligned with two adjacent sides in the substrate, a distance between adjacent the dielectric layers is less than 1/2 of a wavelength of the electromagnetic waves, the dielectric layers include a concave and convex structure in which a plurality of unit structures with a thickness distribution of increasing thickness in a predetermined direction is disposed, the unit structures of the dielectric layers include a plurality of cell regions with different thicknesses, in each of the unit structures of the dielectric layers, in a graph setting a horizontal axis as a length of the predetermined direction of the unit structures, and setting a vertical axis as a relative reflection phase when the electromagnetic waves are transmitted through the dielectric layers, reflected by the reflecting member and emitted to an incident side of the electromagnetic waves by being transmitted through the dielectric layers again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layers include, as the unit structure, at least a first unit structure including three or more of the cell regions of which thicknesses differ from one another, and a reflection direction of the electromagnetic waves is controlled by controlling a relative reflection phase distribution of the electromagnetic waves by the thickness distribution of the dielectric layers.

Another embodiment of the present disclosure provides a method for producing a reflecting structure producing a reflecting structure including a plurality of frequency selective reflectors reflecting electromagnetic waves in a particular frequency band in a direction different from a regular reflection direction, the method including: a disposing step of disposing the plurality of frequency selective reflectors side by side on one surface of a supporting body including a first alignment mark, so that a distance between adjacent the frequency selective reflectors becomes less than 1/2 of a wavelength of the electromagnetic waves.

Another embodiment of the present disclosure provides a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; and the frequency selective reflectors include a second identification mark configured to identify the frequency selective reflectors.

Another embodiment of the present disclosure provides a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; the frequency selective reflectors include a reflecting member reflecting the electromagnetic waves; in the reflecting member, a plurality of reflective elements with different sizes is arranged; and an arrangement of the reflective elements in the plurality of frequency selective reflectors differs from one another.

Another embodiment of the present disclosure provides a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; the frequency selective reflectors include, in an order from the installation surface side, a reflecting member reflecting the electromagnetic waves, and a dielectric layer transmitting the electromagnetic waves; in the dielectric layer, a plurality of cell regions with different thicknesses is arranged; and an arrangement of the cell regions in the plurality of frequency selective reflectors differs from one another.

### Advantageous Effects of Disclosure

The reflecting structure in the present disclosure exhibits an effect such that the reflection properties are excellent, and it is capable of having a large area.

### Brief Description of Drawings

FIG. 1 is a schematic plan view exemplifying the reflecting structure in the present disclosure.
FIG. 2 is a schematic plan view exemplifying the reflecting structure in the present disclosure.
FIG. 3 is a schematic plan view and cross-sectional view exemplifying the reflecting structure in the present disclosure.
FIG. 4 is a schematic plan view and cross-sectional view exemplifying the reflecting structure in the present disclosure.
FIG. 5 is a schematic plan view and cross-sectional view exemplifying the reflecting structure in the present disclosure, and a schematic diagram for explaining a relative reflection phase of electromagnetic waves in each cell region of a unit structure of a dielectric layer in the frequency selective reflector in the present disclosure.
FIG. 6 is a schematic diagram exemplifying reflection properties in the frequency selective reflector in the present disclosure.
FIG. 7 is a schematic perspective view and a plan view exemplifying the unit structure of the dielectric layer in the frequency selective reflector in the present disclosure.
FIG. 8 is a schematic plan view exemplifying the unit structure of the dielectric layer in the frequency selective reflector in the present disclosure.
FIG. 9 is a schematic plan view exemplifying the frequency selective reflector in the present disclosure.
FIG. 10 is a schematic cross-sectional view exemplifying the frequency selective reflector in the present disclosure, and a schematic diagram for explaining the relative reflection phase of electromagnetic waves in each cell region of the unit structure of the dielectric layer in the frequency selective reflector in the present disclosure.
FIG. 11 is a schematic diagram exemplifying reflection properties in the frequency selective reflector in the present disclosure.
FIG. 12 is a schematic plan view exemplifying the frequency selective reflector in the present disclosure.
FIG. 13 is a schematic cross-sectional view exemplifying the frequency selective reflector in the present disclosure, and a schematic diagram for explaining the relative reflection phase of electromagnetic waves in each cell region of the unit structure of the dielectric layer in the frequency selective reflector in the present disclosure.
FIG. 14 is a schematic diagram exemplifying reflection properties in the frequency selective reflector in the present disclosure.
FIG. 15 is a schematic cross-sectional view exemplifying the frequency selective reflector in the present disclosure.
FIG. 16 is a schematic plan view and a cross-sectional view exemplifying the frequency selective reflector in the present disclosure.
FIG. 17 is a schematic plan view and a cross-sectional view exemplifying the frequency selective reflector in the present disclosure.
FIG. 18 is a schematic cross-sectional view exemplifying the frequency selective reflector in the present disclosure.
FIG. 19 is a schematic plan view exemplifying the reflecting structure in the present disclosure.
FIG. 20 is a schematic plan view exemplifying the reflecting structure in the present disclosure.
FIG. 21 is a schematic plan view exemplifying the reflecting structure in the present disclosure.
FIG. 22 is a schematic plan view exemplifying the reflecting structure in the present disclosure.
FIG. 23 is a schematic cross-sectional view exemplifying the reflecting structure in the present disclosure.
FIG. 24 is a schematic plan view exemplifying the reflecting structure in the present disclosure.
FIG. 25 is a schematic plan view exemplifying the reflecting structure in the present disclosure.
FIG. 26 is a schematic plan view exemplifying the reflecting structure in the present disclosure.
FIG. 27 is a schematic plan view exemplifying the reflecting structure in the present disclosure.
FIG. 28 is a schematic cross-sectional view exemplifying the reflecting structure in the present disclosure.
FIG. 29 is a schematic plan view and cross-sectional view exemplifying the reflecting structure in the present disclosure.
FIG. 30 is a schematic plan view exemplifying the reflecting structure in the present disclosure.
FIG. 31 is a schematic plan view and cross-sectional view exemplifying the reflecting structure in the present disclosure.
FIG. 32 is a schematic plan view exemplifying the reflecting structure in the present disclosure.
FIG. 33 is a received power distribution diagram showing the simulation result of Comparative Example 1.
FIG. 34 is a received power distribution diagram showing the simulation result of Example 1.
FIG. 35 is a schematic perspective view showing the simulation model of Reference Example 1 and a graph showing the simulation result.
FIG. 36 is a schematic perspective view showing the simulation model of Reference Example 2 and a graph showing the simulation result.

### Description of Embodiments

An embodiment of the present disclosure is explained as below with reference to, for example, drawings. However, the present disclosure is enforceable in a variety of different forms, and thus should not be taken as is limited to the contents described in the embodiment exemplified as below. Also, the drawings may show the features of the invention such as width, thickness, and shape of each part schematically in order to explain the invention more clearly in some cases comparing to the actual form; however, it is merely an example, and thus does not limit the interpretation of the present disclosure. Also, in the present description and each drawing, for the factor same as that described in the figure already explained, the same reference sign is indicated and the explanation thereof may be omitted.

In the present description, upon expressing an aspect of arranging one member on the other member, when it is expressed simply "on" or "below", both of when the other member is directly arranged on or below the one member so as to contact with each other, and when the other member is arranged on or below the one member further interposing an additional member, can be included unless otherwise described. Upon expressing an aspect of arranging one member above the other member, when it is expressed simply "in upper side" or "down side", any of when the other member is directly arranged on or below the one member so as to contact with each other, when the other member is arranged above or below the one member interposing an additional member, and when the other member is arranged upward or downward of the one member interposing a space, can be included unless otherwise described. Furthermore, in the present description, upon expressing an aspect of arranging the other member in a surface of one member, when expressed simply "in a surface", both of when the other member is directly arranged on or below the one member so as to contact with each other, and when the other member is arranged on or below the one member further interposing an additional member, can be included unless otherwise described.

The reflecting structure, the method for producing the reflecting structure, and the frequency selective reflector set in the present disclosure will be hereinafter described in details.

### A. Reflecting structure

The reflecting structure in the present disclosure has four embodiments. In the following, each embodiment will be explained separately.

### I. First embodiment of reflecting structure

The first embodiment of the reflecting structure in the present disclosure is a reflecting structure including a frequency selective reflector reflecting electromagnetic waves in a particular frequency band in a direction different from a regular reflection direction, the reflecting structure including: a substrate including a first alignment mark; and a plurality of the frequency selective reflectors disposed side by side on one surface of the substrate, wherein a distance between adjacent the frequency selective reflectors is less than 1/2 of a wavelength of the electromagnetic waves.

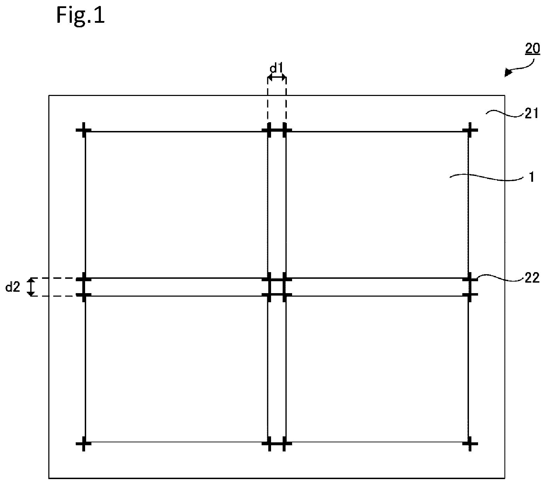

FIG. 1 is a schematic plan view showing an example of the reflecting structure of the present embodiment. As shown in FIG. 1, the reflecting structure 20 includes a frequency selective reflector 1 reflecting electromagnetic waves in a particular frequency band in a direction different from a regular reflection direction, and includes a substrate 21 including a first alignment mark 22, and a plurality of the frequency selective reflectors 1 disposed side by side on one surface of the substrate 21. A distance d1, d2 between adjacent the frequency selective reflectors 1 is less than 1/2 of a wavelength of the electromagnetic waves in a particular frequency band.

For example, in FIG. 1, the substrate 21 includes the first alignment mark 22 in a cross shape, and on the basis of the first alignment mark 22 of the substrate 21, the position of the edge of the frequency selective reflector 1 is adjusted to adjust the position of the plurality of the frequency selective reflectors 1.

Here, although it is not in the reflect array, in a phased array antenna in which a plurality of sub arrays is disposed side by side, the distance between adjacent sub arrays is usually set to less than 1/2 of the wavelength of the electromagnetic waves in order to align the phase of electromagnetic waves in each sub arrays and increase the intensity of the electromagnetic waves.

For this reason, also in the reflecting structure in which a plurality of frequency selective reflectors is disposed side by side, in order to inhibit the disturbance of the wavefront of the reflected wave in the whole reflecting structure by, for example, aligning the phase of the reflected wave in each frequency selective reflectors and increasing the intensity of the reflected wave, it is considered that the distance between the adjacent frequency selective reflectors is desired to be less than 1/2 of the wavelength of the electromagnetic waves.

In the present embodiment, since the substrate includes the first alignment mark, positional matching of a plurality of the frequency selective reflectors can be performed accurately. Thus, the accuracy of the distance between the adjacent frequency selective reflectors can be secured. As a result, it is possible to perform tiling of a plurality of frequency selective reflectors with high positional accuracy so as to set the distance between the adjacent frequency selective reflectors to less than 1/2 of the wavelength of the electromagnetic waves in the particular frequency band. Therefore, the disturbance of the wavefront of the reflected wave in the whole reflecting structure can be inhibited to obtain the desired reflection properties, and the reflecting structure can have large area .

Hereinafter, each configuration of the reflecting structure in the present embodiment will be described.

### 1. Substrate

The substrate in the present embodiment is a member that supports a frequency selective reflector, and includes a first alignment mark.

### (1) Substrate

The substrate is no particularly limited if it is a substrate that can support the frequency selective reflector, and examples thereof may include a resin substrate and a metal substrate. The resin substrate may be, for example, any of a resin film, a resin sheet, and a resin plate. Also, the resin substrate may be one including a hollow structure such as a plastic cardboard, or may be one including a multilayer structure. Examples of the metal substrate may include a metal plate such as aluminum and stainless, and a plywood such as an aluminum plywood.

Since the metal substrate is excellent in rigidity and resistance, and reflects electromagnetic waves, it is suitably used when the frequency selective reflector includes a ground layer on the substrate side surface as described later. When the frequency selective reflector does not include the ground layer, the later described interference mitigating layer may be disposed between the substrate and the frequency selective reflector, or a reflecting member of the frequency selective reflector may be designed in consideration of the properties of the metal substrate.

The shape of the substrate is not particularly limited, but is generally a rectangle. When the reflecting structure is installed on an installation surface, the direction of the surface of the reflecting structure on the installation surface is often decided in advanced, but when it is difficult to recognize the direction of the surface due to the design of the reflecting structure, the substrate may include a part showing the direction of the surface such as a corner chamfer in which one corner part of the substrate is cut off, an incision part like a so-called notch, or a part in which a part of a curved line part is cut off such as an orientation flat. By giving such an asymmetric shape to the reflecting structure, up and down, left and right, and front and back of the reflecting structure can be easily identified, and thus the reflecting structure can be installed in the correct direction.

The substrate may include a light transmittance and may include a light non-transmittance. These optical properties of the substrate are appropriately selected in accordance with factors such as the detecting method of the first alignment mark and the position of the first alignment mark. For example, in the case of detecting the first alignment mark by a transmitted light, the substrate includes the light transmittance. Also, for example, in the case of detecting the first alignment mark by the reflected light, the substrate may include the light transmittance, and may include the light non-transmittance. Also, as described later, for example, when the first alignment mark is disposed on the surface of the substrate that is opposite side to the frequency selective reflector, the substrate includes the light transmittance.

Note that the "light transmittance" in the present specification means a transmittance to visible light. Also, the "light non-transmittance" means a non-transmittance to visible light.

Also, the substrate may include an X-ray transmittance. When the substrate includes the X-ray transmittance, the first alignment mark can be detected by the transmitted X-ray.

The transmittance rate of the substrate is not particularly limited if the first alignment mark can be detected by the transmitted light or the reflected light, and it can be appropriately set depending on the factors such as the material and the thickness of the substrate.

The resin configuring the resin substrate is not particularly limited, and examples thereof may include an engineering plastic.

Also, the resin substrate may contain an additive such as an ultraviolet absorber, a light stabilizer, an antioxidant, and a coloring agent, as required.

There are no particular limitations on the thickness of the substrate.

### (2) First alignment mark

The first alignment mark is a mark for performing the positional matching of the frequency selective reflector.

The first alignment mark may include the light non-transmittance. Also, the first alignment mark may include the light reflecting properties. These optical properties of the first alignment mark are appropriately selected in accordance with the detection method of the first alignment mark which is by the transmitted light or by the reflected light. For example, in the case of detecting the first alignment mark by the transmitted light, the first alignment mark includes the light non-transmittance. Also, for example, in the case of detecting the first alignment mark by the reflected light, the first alignment mark includes light reflecting properties.

Note that the "light reflecting properties" in the present specification means reflecting properties to the visible light.

Also, the first alignment mark may include an X-ray transmittance. When the substrate and the first alignment mark include the X-ray transmittance, the first alignment mark can be detected by the transmitted X-ray.

The transmittance rate and the reflection rate of the first alignment mark are not particularly limited if the first alignment mark can be detected by the transmitted light or the reflected light, and they can be appropriately set depending on the factors such as the material and the thickness of the first alignment mark.

Also, the first alignment mark may be a penetration hole that penetrates the substrate.

The plan view shape of the first alignment mark is not particularly limited, and is the same as the plan view shape of general alignment marks. Examples of the plan view shape of the first alignment mark may include, a cross shape, an X- shape, a crossed square shape, a parallel crosses shape, a circle shape, a square shape, a triangle shape, a double circle shape, a double square shape, a hollow circle shape, a hollow square shape, and a combination of these.

The size and the line width of the first alignment mark are not particularly limited if the first alignment mark can be detected, and if it does not inhibit the distance between the adjacent frequency selective reflectors to be in the specified range.

The number of the first alignment mark is not particularly limited if the positional matching of a plurality of the frequency selective reflectors is possible.

The position of the first alignment mark in the substrate is appropriately set depending on the desired position where the plurality of the frequency selective reflectors is disposed.

The first alignment mark may be disposed on the frequency selective reflector side surface of the substrate, and may be disposed on a surface of the substrate that is opposite side to the frequency selective reflector. Also, as long as the detection of the first alignment mark is not inhibited, any covering layer such as a protective layer may be disposed on the first alignment mark.

The thickness of the first alignment mark is not particularly limited if the first alignment mark can be accurately formed, and is appropriately adjusted depending on the factors such as the optical properties of the first alignment mark.

Examples of the material of the first alignment mark may include a metal material such as a metal, an alloy, a metal oxide, and a metal nitride, and a resin. In the case of the resin, a coloring agent can be added. Among those, the resin is preferable in consideration of the influence of the reflection of the electromagnetic waves by the first alignment mark.

The method for forming the first alignment mark is appropriately selected depending on the factors such as the material of the first alignment mark. In the case of the metal material, examples of the method for forming the first alignment mark may include a photo lithography method, a mask vapor deposition method, a lift-off method, and a printing method. Also, in the case of the resin, examples of the method for forming the first alignment mark may include a photo lithography method and a printing method. As the printing method, general methods such as an ink-jet method, a silk screen printing method, and a transferring method can be used.

### (3) First identification mark

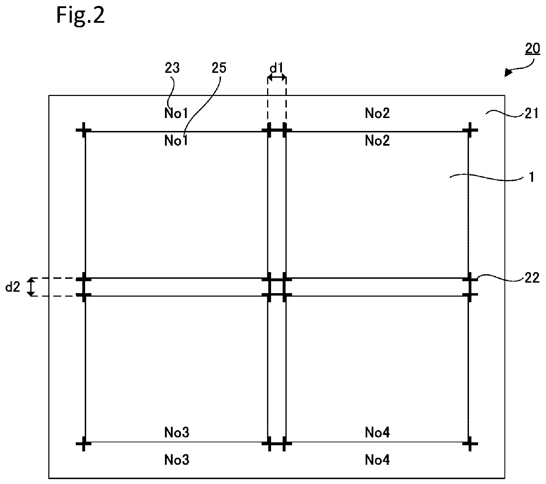

In the present embodiment, for example, as shown in FIG. 2, the substrate 21 may include a first identification mark 23 for identifying the position of the frequency selective reflector 1. For example, in FIG. 2, the substrate 21 includes first identification marks 23 "No 1", "No 2", "No 3", and "No 4". When the substrate includes the first identification mark, the position of each frequency selective reflectors can be easily identified, and thus each frequency selective reflectors can be accurately and easily disposed in the correct position. In particular, as described later, it is useful when the reflection properties of a plurality of the frequency selective reflectors differ from one another.

The first identification mark may include the light non-transmittance. Also, the first identification mark may include the light reflecting properties. These optical properties of the first identification mark are appropriately selected depending on the detection method of the first identification mark which is by the transmitted light or by the reflected light, similarly to the first alignment mark.

The transmittance rate and the reflection rate of the first identification mark are not particularly limited if the first identification mark can be detected by the transmitted light or the reflected light, and they can be appropriately set depending on the factors such as the material and the thickness of the first identification mark.

The first identification mark is not particularly limited if it is a mark that can be identified, and examples thereof may include letters, symbols, and shapes. Specific examples thereof may include codes. Also, the first identification mark may be data capable of optical character recognition (OCR).

The size and the line width of the first identification mark are not particularly limited if the first identification mark can be detected.

The position of the first identification mark in the substrate is not particularly limited if the position of each frequency selective reflectors can be identified.

The first identification mark may be disposed on the frequency selective reflector side surface of the substrate, and may be disposed on a surface of the substrate that is opposite side to the frequency selective reflector. Also, as long as the detection of the first identification mark is not inhibited, any covering layer such as a protective layer may be disposed on the first identification mark.

The thickness, the material, and the forming method of the first identification mark are the same as the thickness, the material, and the forming method of the first alignment mark.

When the material of the first identification mark is the same as the material of the first alignment mark, the first alignment mark and the first identification mark can be formed at the same time.

### 2. Frequency selective reflector

The frequency selective reflector in the present embodiment is a member reflecting electromagnetic waves in a particular frequency band in a direction different from a regular reflection direction.

### (1) Distance between adjacent frequency selective reflectors

In the present embodiment, the distance between the adjacent frequency selective reflectors is less than 1/2 of the wavelength of the electromagnetic waves in a particular frequency band, preferably 1/5 or less thereof, and more preferably 1/10 or less thereof. When the distance between the adjacent frequency selective reflectors is in the above range, the disturbance of the wavefront of the reflected wave in the whole reflecting structure can be inhibited. As described later, the frequency band of the electromagnetic waves is preferably 2.5 GHz or more, and more preferably 24 GHz or more. In other words, the wavelength of the electromagnetic waves in the air is preferably 119.92 mm or less, and more preferably 12.49 mm or less. For this reason, the distance between the adjacent frequency selective reflectors is, in specific, preferably about 59.96 mm or less, and more preferably about 6.245 mm or less. Also, the shorter the distance between the adjacent frequency selective reflectors, the more preferable, and there are no particular limitations on the lower limit value.

### (2) Embodiment of frequency selective reflector

The frequency selective reflector is not particularly limited if it is a member reflecting the electromagnetic waves in a particular frequency band in a direction different from a regular reflection direction, and for example, it may include a reflecting member reflecting the electromagnetic waves, and the reflecting member may include a reflection phase controlling function controlling a reflection phase of the electromagnetic waves, or may include, in an order from the substrate side, a reflecting member reflecting the electromagnetic waves, and a dielectric layer that includes a concave and convex structure in which a plurality of unit structures with a thickness distribution of increasing thickness in a predetermined direction is disposed, and that transmits the electromagnetic waves.

The first aspect wherein the frequency selective reflector includes a reflecting member reflecting the electromagnetic waves, and the reflecting member includes a reflection phase controlling function controlling a reflection phase of the electromagnetic waves; and the second aspect wherein the frequency selective reflector includes, in an order from the substrate side, a reflecting member reflecting the electromagnetic waves, and a dielectric layer that includes a concave and convex structure in which a plurality of unit structures including a thickness distribution of increasing thickness in a predetermined direction is disposed, and that transmits the electromagnetic waves, will be hereinafter separately explained.

### (2-1) First aspect of frequency selective reflector

The first aspect of the frequency selective reflector in the present embodiment includes a reflecting member reflecting the electromagnetic waves, and the reflecting member includes a reflection phase controlling function controlling a reflection phase of the electromagnetic waves.

### (a) Reflecting member

The reflecting member in the present aspect is a member that reflects the electromagnetic waves in a particular frequency band, and includes a reflection phase controlling function controlling the reflection phase of the electromagnetic waves.

In the present aspect, the reflecting member usually includes a wavelength selecting function reflecting only the electromagnetic waves in a particular frequency band. Examples of such a reflecting member may include a frequency selective plate.

The frequency selective plate includes a frequency selective surface (FSS) that controls reflection and transmission of electromagnetic waves in a particular frequency band, and when functioning as a reflector for electromagnetic waves in a particular frequency band, a plurality of reflective elements (scattering elements) is arranged in a plane. Examples of the frequency selective plate may include, for example, one including a dielectric substrate and a plurality of reflective elements arranged on a surface of the dielectric substrate that is an incident side of the electromagnetic waves.

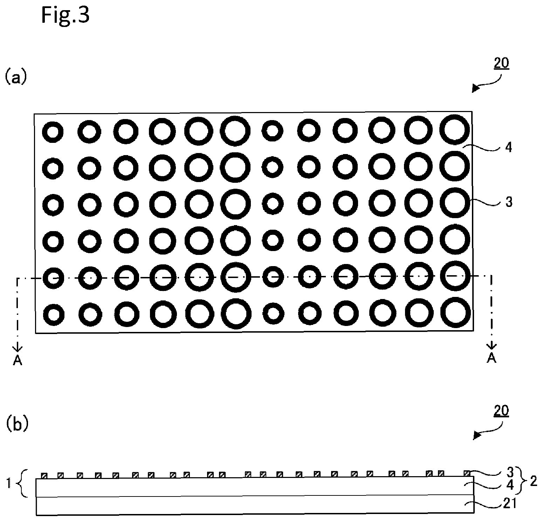

FIG. 3 (a), (b) are a schematic plan view and a cross-sectional view showing an example of the reflecting structure including the frequency selective reflector of the present aspect, and FIG. 3 (b) is a cross-sectional view of A-A line in FIG. 3 (a). As shown in FIG. 3 (a), (b), the frequency selective reflector 1 includes a reflecting member 2 reflecting the electromagnetic waves in a particular frequency band, and the reflecting member 2 is the one in which a plurality of ring-shaped reflective elements 3 is disposed, and includes a dielectric substrate 4, and a plurality of reflective elements 3 arranged on a surface (electromagnetic wave incident side surface) of the dielectric substrate 4 that is opposite side to the substrate 21. FIG. 3 (a), (b) are examples in which the reflecting member 2 is a frequency selective plate. The reflecting member 2 has a reflection phase control function controlling the reflection phase of the electromagnetic wave, and for example, in the reflecting member 2 shown in FIG. 3 (a), (b), by varying the size of the reflective element 3, the resonance frequency can be varied per reflective element 3 to control the reflection phase of the target electromagnetic wave. As a result, the reflection direction of the electromagnetic waves with respect to the predetermined incident direction can be controlled in any direction.

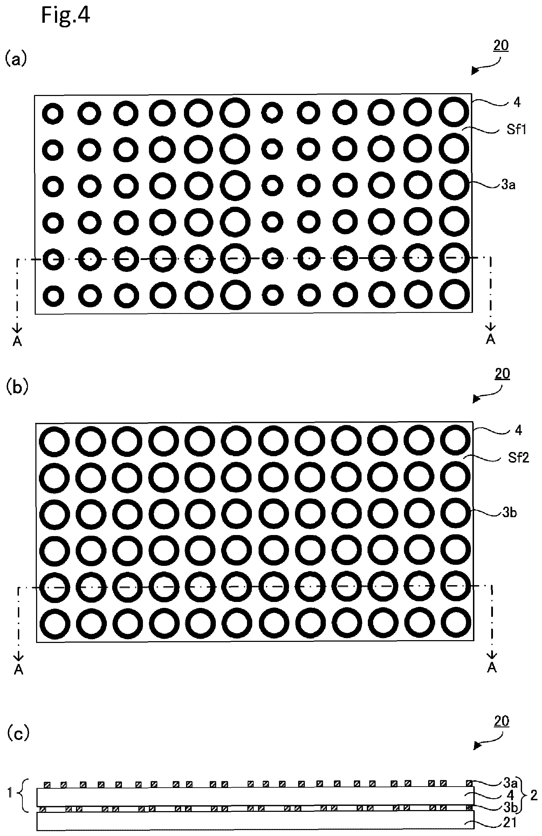

FIG. 4 (a) to (c) are schematic plan views and a cross-sectional view showing another example of the reflecting structure including the frequency selective reflector of the present aspect, and FIG. 4 (a) is a plan view observed from one surface Sf1 of the frequency selective reflector, FIG. 4 (b) is a plan view observed from the other surface Sf2 of the frequency selective reflector, and FIG. 4 (c) is a cross-sectional view of A-A line in FIG. 4 (a) and FIG. 4 (b). As shown in FIG. 4 (a) to (c), the frequency selective reflector 1 includes a reflecting member 2 reflecting the electromagnetic waves in a particular frequency band, and the reflecting member 2 is the one in which a plurality of ring-shaped reflective elements 3 is arranged, and includes a dielectric substrate 4, and a plurality of reflective elements 3a disposed on a surface (electromagnetic waves incident side surface) of the dielectric substrate 4 that is opposite side to the substrate 21, and a plurality of reflective elements 3b disposed on the substrate 21 side surface of the dielectric substrate 4. FIG. 4 (a) to (c) are examples in which the reflecting member 2 is a frequency selective plate. The reflecting member 2 has a reflection phase controlling function controlling the reflection phase of the electromagnetic waves, and for example, in the reflecting member 2 shown in FIG. 4 (a) to (c), by varying the size of the reflective elements 3a, the resonant frequency per reflective elements 3a can be varied to control the reflection phase of the target electromagnetic wave. As a result, the reflection direction of the electromagnetic waves with respect to the predetermined incident direction can be controlled in any direction.

The frequency selective plate may be appropriately selected from conventionally known frequency selective plates.

The shape of the reflective element forming the frequency selective surface is not particularly limited, and examples thereof may include any shapes such as a ring shape, a cross shape, a square shape, a rectangle shape, a circle shape, an ellipse shape, a bar shape, a planar pattern such as a pattern divided into a plurality of adjacent regions, and a three-dimensional structure such as a through-hole via.

Also, the reflective element may be, for example, a single layer or multiple layers. If the reflective element is a single layer, examples of the frequency selective plate may include the one in which a plurality of reflective elements is arranged on one side of the dielectric substrate as shown in FIG. 3 (a) to (b). Also, when the reflective element is multiple layers, for example, examples of the frequency selective plate may include the one in which a plurality of reflective elements is arranged on both surfaces of the dielectric substrate, one in which a dielectric substrate, a plurality of reflective elements, a dielectric substrate, and a plurality of reflective elements are arranged in the order, and one in which a conductor is disposed on entire surface of the surface farthest from the surface of the incident side of the electromagnetic wave as shown in FIG. 4 (a) to (c). This conductor disposed on entire surface includes a function of the later described ground layer, but a plurality of the reflective elements on the incident side surface of the electromagnetic waves on the basis of the ground layer is designed on the premise that the ground layer is present.

In the present aspect, the reflecting member includes a reflection phase controlling function controlling a reflection phase of the electromagnetic waves. In such a reflecting member, by varying the size and the shape of the reflective element, the resonance frequency can be varied per each reflective element, and the reflection phase of the electromagnetic wave can be controlled; thereby the reflection direction of the electromagnetic wave incident from the predetermined direction can be controlled.

As the reflecting member including the reflection phase controlling function, a general frequency selective surface can be applied. Although there are advantages and disadvantages in the design of these, it is possible to vary the reflection phase of the electromagnetic wave by varying the size and shape of these reflective element.

The different sizes of the reflective element are appropriately selected depending on the shape of the reflective element.

The dielectric substrate may include the light transmittance, and may include the light non-transmittance.

### (b) Other configurations

The frequency selective reflector of the present aspect may include configurations other than the reflecting member as required.

### (i) Protective member

The frequency selective reflector of the present embodiment may include a protective member on a surface of the reflecting member that is opposite side to the substrate. The reflecting member can be protected by the protective member. Design can also be imparted by the protective member.

### (ii) Ground layer

The frequency selective reflector of the present aspect may include a ground layer on the substrate side surface of the reflecting member. The ground layer can block interference with objects present on the backside of the frequency selective reflector and suppress the occurrence of noise. The ground layer may be the one that is conductive, and for example, a common conductive layer such as a metal layer, a metal mesh, a carbon film, an ITO film, or the like can be used.

### (iii) Planarizing layer

The frequency selective reflector of the present aspect may include a planarizing layer on a surface of the reflecting member that is opposite side to the substrate. When the reflecting member is a member in which a plurality of reflective elements is arranged, the planarizing layer can flatten the unevenness of the reflective elements, and can suppress the influence of the unevenness due to the reflective elements when the protective member is disposed on the reflecting member. Examples of the planarizing layer may include an ionizing radiation cured resin layer disposed in the state of embedding the reflective element. Further, when a space is provided between the reflecting member and the protective member, the planarizing layer may be provided with a function of protecting the reflective element.

### (2-2) Second aspect of frequency selective reflector

The second aspect of the frequency selective reflector in the present embodiment includes, in an order from the substrate side, a reflecting member reflecting the electromagnetic waves, and a dielectric layer that includes a concave and convex structure in which a plurality of unit structures with a thickness distribution of increasing thickness in a predetermined direction is disposed, and that transmits the electromagnetic waves. In the frequency selective reflector of the present aspect, the unit structure of the dielectric layer includes a plurality of cell regions with different thicknesses, in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layer includes, as the unit structure, at least a first unit structure including three or more of the cell regions of which thicknesses differ from one another, and a reflection direction of the electromagnetic waves is controlled by controlling a relative reflection phase distribution of the electromagnetic waves by the thickness distribution of the dielectric layer.

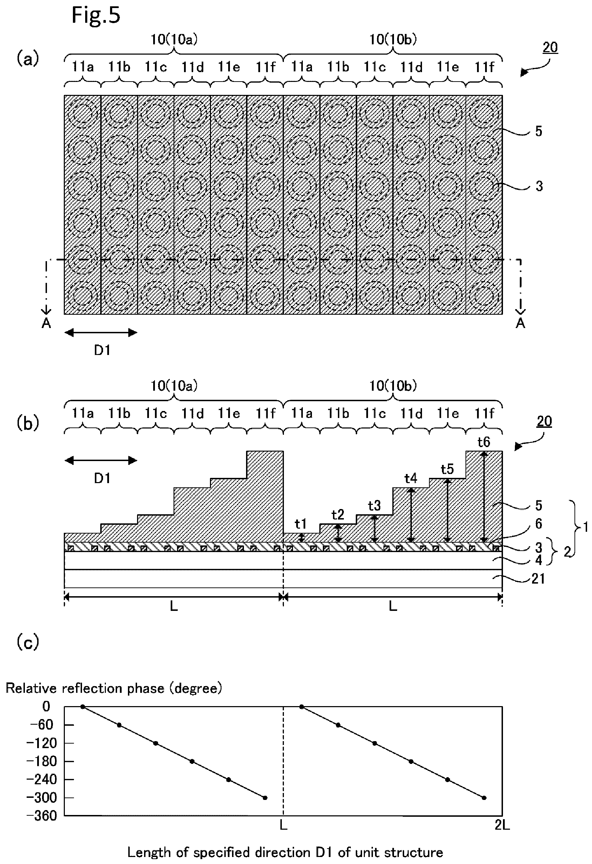

FIG. 5 (a), (b) are a schematic plan view and a cross-sectional view showing an example of the reflecting structure including the frequency selective reflector of the present aspect, and FIG. 5 (b) is a cross-sectional view of A-A line in FIG. 5 (a). As shown in FIG. 5 (a), (b), the frequency selective reflector 1 includes, in an order from the substrate 21 side, a reflecting member 2 reflecting particular electromagnetic waves, and a dielectric layer 5 that includes a concave and convex structure in which a plurality of unit structures 10 including a thickness distribution of which thicknesses t1 to t6 increase in predetermined direction D1 is disposed, and that transmits particular electromagnetic waves. Also, the frequency selective reflector 1 may include an adhesive layer 6 between the reflecting member 2 and the dielectric layer 5. The unit structure 10 of the dielectric layer 5 includes a plurality of cell regions 11a to 11f of which thicknesses t1 to t6 differ from one another. For example, in FIG. 5 (b), the unit structure 10 of the dielectric layer 5 has a stepped shape in which the thicknesses t1 to t6 stepwisely increase in the predetermined direction D1, the number of steps in the stepped shape is six stages, and the unit structure 10 of the dielectric layer 5 includes six cell regions 11a to 11f. In each cell regions 11a to 11f of the unit structure 10 of the dielectric layer 5, since the thicknesses t1 to t6 are different, the round-trip optical path length when the electromagnetic wave is transmitted through the dielectric layer 5, reflected by the reflecting member 2 and is emitted to the incident side of the electromagnetic wave by being transmitted through the dielectric layer 5 again, is different, and these differences in the round-trip optical path length in the dielectric layer, that is the optical path difference, will produce a relative reflection phase difference.

Here, the term "optical path length" is used in the present description to refer to the effective distance when the electromagnetic wave passes through the dielectric layer in practice because the wavelength of the frequency band targeted in the present disclosure is more easily explained when described as behavior similar to the light since the wavelength of the frequency band targeted in the present disclosure is closer to that of the light as compared to the frequency band of a conventional LTE and is high in straightness.

Then, in the unit structure 10 of the dielectric layer 5, in a graph setting a horizontal axis as a length L of the predetermined direction D1 of the unit structure 10, and setting a vertical axis as a relative reflection phase when the electromagnetic waves are transmitted through the dielectric layer 5, reflected by the reflecting member 2 and emitted to the incident side of the electromagnetic wave by being transmitted through the dielectric layer 5 again, in the graph, a value of the relative reflection phase of the electromagnetic waves is over -360° and 0° or less, when a point corresponding to a central position of the predetermined direction D1 in each cell region and corresponding to the relative reflection phase of the electromagnetic waves in each cell region are plotted, and a straight line passing through a point corresponding to a minimum thickness cell region having a minimum thickness is drawn, each point is on a same straight line.

FIG. 5 (c) is a graph setting a horizontal axis as the length L of the unit structure 10 of the dielectric layer 5 in the predetermined direction D1, and setting a vertical axis as a relative reflection phase when the electromagnetic waves are transmitted through the dielectric layer 5, reflected by the reflecting member 2 and emitted to the incident side of the electromagnetic wave by being transmitted through the dielectric layer 5 again, wherein a value of the relative reflection phase of the electromagnetic waves is over -360° and 0° or less; and it is an example of the relative reflection phase of electromagnetic waves in each cell region of the unit structure of the dielectric layer in the frequency selective reflector shown in FIG. 5 (a), (b). As shown in FIG. 5 (c), the relative reflection phases of electromagnetic waves in each cell regions 11a to 11f of the unit structure 10 of the dielectric layer 5 are respectively 0°, -60°, -120°, -180°, -240°, and -300°, and the absolute value of the difference between the relative reflection phases of electromagnetic waves in neighboring cell regions is 60°. In this case, thicknesses t1 to t6 of six cell regions 11a to 11f of the unit structure 10 of the dielectric layer 5 are designed so that the absolute value of the difference between the relative reflection phases of the electromagnetic waves in neighboring cell regions become 360° divided by 6, that is 60°. Then, as shown in FIG. 5 (c), when a point corresponding to a central position of the predetermined direction D1 in each cell regions 11a to 11f of the unit structure 10 of the dielectric layer 5 and corresponding to the relative reflection phase of the electromagnetic waves in each cell regions 11a to 11f are plotted, and among each cell regions 11a to 11f, a straight line (a solid line in the graph) passing through a point corresponding to minimum thickness cell region 11a having the minimum thickness t1 is drawn, each point is on a same straight line.

Here, in the present specification, "reflection phase" is referred to the amount of change in phase of the reflected wave with respect to phase of the incident wave incident to a surface, but in the frequency selective reflector including the reflecting member and the dielectric layer of the present aspect, it is referred to as the amount of change in phase of the reflected wave when the incident wave is transmitted through the dielectric layer, reflected by the reflecting member and is emitted through the dielectric layer by being transmitted through the dielectric layer again, with respect to the phase of the incident wave.

Also, in the present specification, the term "relative reflection phase" is one in which, in one unit structure of the dielectric layer, when the reflection phase in the cell region where the delay of the reflection phase is the smallest is used as a reference, the delay of the reflection phase in a certain cell region with respect to the reflection phase of the reference is shown as a negative value. For example, in one unit structure of the dielectric layer, when the reflection phase in the cell region where the delay of the reflection phase is the smallest is -10°, the relative reflection phase in the cell region where the reflection phase is -40°, is -30°.

When the reflecting member has a reflection phase controlling function as described below, the relative reflection phase of the electromagnetic wave in the cell region is a value obtained by synthesizing also the reflection phase at the reflecting member.

Also, in the present specification, a "cell region" refers to a region in which the relative reflection phase of an electromagnetic wave is the same in the unit structure of the dielectric layer.

Note that the reflection phase is in the range of over -360° to less than +360° unless otherwise noted, and -360° and +360° return to 0°. Also, the relative reflection phase is in the range of over -360° to 0°or less, unless otherwise noted, and -360° returns to 0°.

In a conventional reflect array in which a plurality of reflective elements arranged, for example, by adjusting the size and shape of the reflective element, the reflection phase can be delayed or the reflection phase can be advanced, but in the frequency selective reflector of the present aspect, the reflection phase is basically delayed by adjusting the thickness of each cell region of the unit structure of the dielectric layer. For this reason, the relative reflection phase is based on the reflection phase in the cell region where the delay of the reflection phase is the smallest.

Also, usually, in one unit structure of the dielectric layer, the cell region where the delay of the reflection phase is the smallest is a minimum thickness cell region having a minimum thickness in a predetermined direction in which the thickness increases. Thus, in the above graph, a straight line is drawn through a point corresponding to the minimum thickness cell region having the minimum thickness.

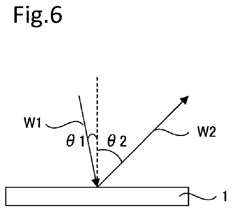

As described above, in each cell regions 11a to 11f of the unit structure 10 of the dielectric layer 5, the thicknesses t1 to t6 vary, thereby the round-trip optical path length in the dielectric layer 5 varies and the relative reflection phase of the electromagnetic wave varies; thus, the incident wave W1 of the electromagnetic wave can be reflected to a direction different from the regular reflection (specular reflection) direction, as exemplified in FIG. 6. In this case, the incident angle θ1 of the incident wave W1 of the electromagnetic wave is different from the reflection angle θ2 of the reflected wave W2 of the electromagnetic wave.

Therefore, in the frequency selective reflector of this aspect, by varying the thickness of each cell region of the unit structure of the dielectric layer, the round-trip optical path length in the dielectric layer can be varied per cell region, and the reflection phase of the electromagnetic wave can be controlled. As a result, the reflection direction of the electromagnetic waves with respect to the predetermined incident direction can be controlled in any direction.

Further, the concave and convex structure of the dielectric layer in the present aspect can be formed by, for example, various techniques such as cutting, laser processing, using a mold, 3D printer, and joining small piece parts. Thus, there is no need for a photomask unlike photolithographic processing of a metal layer in a conventional reflect array. Thus, when the thickness of each cell region of the unit structure of the dielectric layer is designed and the dielectric layer can be formed so as to obtain reflection properties with the desired incident angle and reflection angle in accordance with the situation, the desired dielectric layer can be formed with comparatively low cost and short term, which easily meets a small quantity and variety of needs. In addition, for the thickness of the dielectric layer and the size of the unit structure of the dielectric layer that affect the control of the reflection properties, the range of possible processing is relatively wide, and thus, for example, the incident angle and the reflection angle of the electromagnetic waves can be increased, and the control region of the reflection properties can be widened. Furthermore, with respect to the thickness of the dielectric layer and the pitch of the cell region of the unit structure of the dielectric layer, the margin of dimensional processing accuracy for achieving the desired reflection phase is relatively wide, and thus the desired reflection properties can be easily obtained and the influence of dimensional variations can be reduced. Accordingly, it is easy to customize the reflection properties of the frequency selective reflector.

Also, in the frequency selective reflector of the present aspect, the reflecting member may be a frequency selective plate that reflects only a particular electromagnetic waves. For example, in FIG. 5 (a), (b), the reflecting member 2 is the one in which a plurality of ring-shaped reflective elements 3 is arranged, and it includes dielectric substrate 4, and a plurality of reflective elements 3 disposed on the dielectric layer 5 side surface of the dielectric substrate 4.

Further, in the frequency selective reflector of the present aspect, the reflecting member may be a frequency selective plate that reflects only a particular electromagnetic waves, as well as a member including a reflection phase controlling function that controls the reflection phase of the electromagnetic waves. In such a reflecting member, by varying the size and shape of the reflective element, the resonant frequency per reflective element can be varied and the targeted reflection phase of the electromagnetic waves can be controlled. In this case, the reflection phase of the electromagnetic wave can be controlled not only by the thickness of the dielectric layer but also by the size and shape of the reflective element, and the degree of freedom of design for controlling the reflection properties can be improved.

Thus, in the frequency selective reflector of the present aspect, when such a reflecting member is used, the degree of freedom in controlling the reflection properties can be widened by combining with the dielectric layer. Therefore, customization of the reflection properties of the frequency selective reflector can be made easier. For example, an operation where the reflection properties in top and bottom directions may be prepared with multiple types of reflecting members and combined with a dielectric layer that adjusts the reflection properties in horizontal direction is one example.

The inventors of the present disclosure also simulate the reflection properties of electromagnetic waves in a particular frequency band when the reflecting member is a frequency selective plate including a reflective element that reflects only a particular electromagnetic wave in the frequency selective reflector including the reflecting member and the dielectric layer of the present disclosure, and found that when the thickness of the cell region of the unit structure of the dielectric layer is varied to vary the round-trip optical path length in the dielectric layer per cell region, the deviation of the reflection phase was greater compared to the deviation of the reflection phase in the reflective element due to the proximity of the dielectric layer to the reflecting member (the frequency selective plate), and the design of substantial reflection properties can be substantially determined by the design of the concave and convex structure of the dielectric layer. At this time, the resonant frequency of the reflective element varies depending on the presence or absence of the adjacent dielectric layer, but if the design is performed on the premise that the dielectric layer is present, the practical problem is solved. Furthermore, the in-plane arrangement of the concave and convex structure of the dielectric layer to achieve an in-plane distribution design of the reflection phase in the frequency selective reflector need not be in a fixed positional relationship with respect to the in-plane arrangement of the reflective element of the reflecting member, and it has been found out that even if the concave and convex structure of the dielectric layer is shifted and arranged with respect to the in-plane arrangement of the reflective element, there is no significant effect on the reflection properties.

Thus, when the dielectric layer and the reflecting member as described above are combined and used in the frequency selective reflector of the present aspect, it is possible to design each of the dielectric layer and the reflecting member independently, and combine the two. In this case, a dielectric layer for achieving reflection properties according to the use environment may be made each time and a plurality of specifications may be prepared in advance. As a result, it is possible to more easily customize the design of the reflection direction of the frequency selective reflector that changes according to the use environment, and it becomes easy to apply to various situations. Incidentally, as described above, in the case of adjusting the total reflection properties of the frequency selective reflector by the combination of the respective reflection phase distributions of the reflecting member and the dielectric layer, the accuracy of the misalignment of the reflecting member and the dielectric layer according to the required specification is required, but when the reflection properties of the frequency selective reflector are adjusted only by the reflection phase distribution of the dielectric layer, the accuracy of the misalignment of the reflecting member and the dielectric layer is not required so much.

Also, when the dielectric layer is formed by using a 3D printer for example, a plurality of the frequency selective reflectors can be produced at the same time by using a plurality of 3D printers. Thus, by tiling the frequency selective reflectors, the production time of the reflecting structure can be shortened.

Also, the frequency selective reflector of the present aspect has advantages such that the degree of freedom of the thickness and the size of the substrate is higher compared to when the reflecting member includes a reflective layer disposed in contact with the substrate, or when the reflecting member includes a plurality of reflective elements disposed in contact with the substrate, in the reflecting structure of the later described second embodiment.

In the following, each configuration of the frequency selective reflector of the present aspect will be described.

### (a) Dielectric layer

The dielectric layer in the present embodiment is a member that includes a concave and convex structure in which a plurality of unit structures including a thickness distribution of increasing thickness in a predetermined direction is disposed, and that transmits the electromagnetic waves in a particular frequency band. Also, the unit structure of the dielectric layer includes a plurality of cell regions of which thickness differs from one another; and in each of the unit structure of the dielectric layer, in a graph setting a horizontal axis as a length of the predetermined direction of the unit structure, and setting a vertical axis as a relative reflection phase when the electromagnetic waves are transmitted through the dielectric layer, reflected by the reflecting member and emitted to the incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell region and corresponding to the relative reflection phase of the electromagnetic waves in each cell region are plotted, and a straight line passing through a point corresponding to a minimum thickness cell region having a minimum thickness is drawn, each point is on a same straight line. Also, the dielectric layer includes, as the unit structure, at least a first unit structure including three or more of the cell regions of which thickness differs from one another.

### (i) Structure of dielectric layer

The dielectric layer includes a concave and convex structure in which a plurality of a unit structures including a thickness distribution of increasing thickness in a predetermined direction is arranged.

The unit structure of the dielectric layer includes a plurality of cell regions of which thickness differs from one another; and in each of the unit structure of the dielectric layer, in a graph setting a horizontal axis as a length of the predetermined direction of the unit structure, and setting a vertical axis as a relative reflection phase when the electromagnetic waves are transmitted through the dielectric layer, reflected by the reflecting member and emitted to the incident side of the electromagnetic wave by being transmitted through the dielectric layer again, in the graph, a value of the relative reflection phase of the electromagnetic waves is over -360° and 0° or less, when a point corresponding to a central position of the predetermined direction in each cell region and corresponding to the relative reflection phase of the electromagnetic waves in each cell region are plotted, and a straight line passing through a point corresponding to a minimum thickness cell region having a minimum thickness is drawn, each point is on a same straight line.

It should be noted that when each point is on the same straight line, the difference in the vertical axis direction of each point with respect to the straight line is within ±72°. The difference in the vertical axis direction of each point relative to the straight line is preferably within ±54°, more preferably within ±36°, and further more preferably within ±18°. In the case where each point includes a deviation in the vertical axis direction with respect to the straight line, and a straight line passing through each point is difficult to be drawn, "a straight line connecting a point (relative reflection phase 0 degree) corresponding to a minimum thickness cell region having a minimum thickness and a point (relative reflection phase -360 degree) corresponding to a minimum thickness cell region having a minimum thickness in a unit structure adjacent to the unit structure" may be considered.

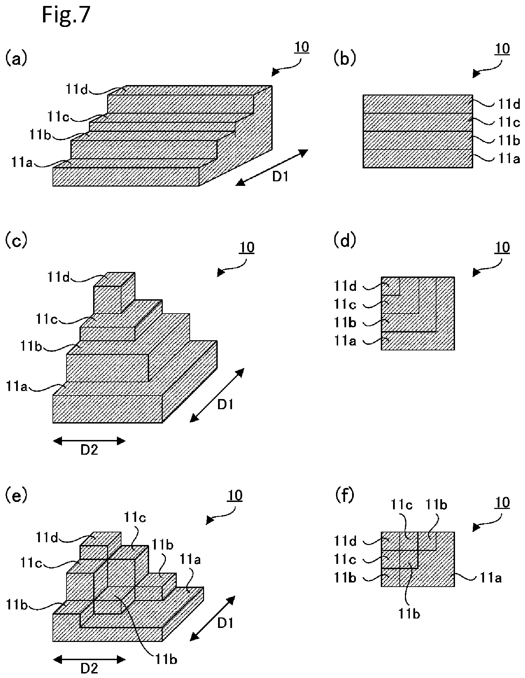

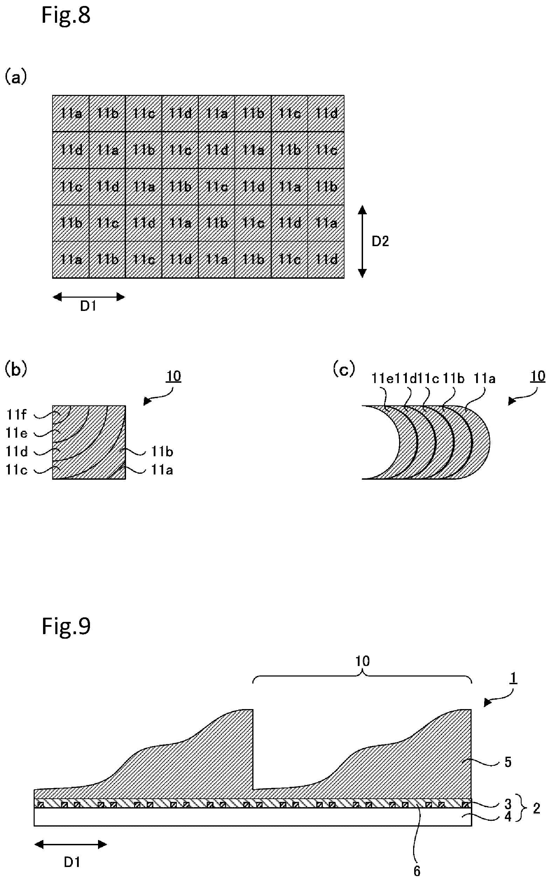

The unit structure of the dielectric layer includes a thickness distribution of increasing thickness in a predetermined direction. The unit structure of the dielectric layer may, for example, include a thickness distribution in which the thickness increases in only one direction, or may include a thickness distribution in which the thickness increases in two directions of a first direction and a second direction perpendicular to the first direction. For example, FIG. 7 (a) is an example in which the unit structure 10 of the dielectric layer includes a thickness distribution in which the thickness increases only in the first direction D1, and FIG. 7 (c), (e), and FIG. 8 (a) are examples of a thickness distribution in which the thickness of the unit structure 10 of the dielectric layer increases in the first direction D1 and the second direction D2.

If the unit structure of the dielectric layer includes a thickness distribution that increases in thickness only in one direction, then each point will be on the same straight line when plotting the above points in the graph with the length of the unit structure in one direction as the horizontal axis. Also, when the unit structure of the dielectric layer includes a thickness distribution in which the thickness increases in two directions perpendicular to each other, each point is on the same straight line in each graph when the points are plotted in the graph in which the length of the unit structure in the two directions is respectively the horizontal axis.

In one unit structure of the dielectric layer, the absolute value of the relative reflection phase difference of the electromagnetic waves in neighboring cell regions is less than 180°, preferably 120° or less, and more preferably 60° or less. The smaller the absolute value of the difference in the relative reflection phase of the electromagnetic waves in neighboring cell regions, the smoother the wavefront of the reflected waves. Also, the absolute value of the difference of the relative reflection phase of the electromagnetic waves in neighboring the cell regions is over 0°.

When the maximum thickness cell region having the maximum thickness in one unit structure and the minimum thickness cell region having the minimum thickness in the other unit structure are adjacent to each other in the adjacent unit structure, on the basis of reflection phase in the cell region where the delay of reflection phase in one unit structure is the smallest, when the relative reflection phase of the electromagnetic wave in the minimum thickness cell region having the minimum thickness in the other unit structure is set to be over -720° and -360° or less shifted by one cycle, the absolute value of the difference between the relative reflection phase of the electromagnetic wave in the maximum thickness cell region having the maximum thickness in one unit structure and the relative reflection phase of the electromagnetic wave in the minimum thickness cell region having the minimum thickness in the other unit structure is less than 180°, preferably 120° or less, and more preferably 60° or less. The smaller the absolute value of the difference in the relative reflection phase of the electromagnetic waves in these neighboring cell regions, the smoother the wavefront of the reflected waves. Also, the absolute value of the difference in the relative reflection phase of electromagnetic waves in these neighboring cell regions is over 0°. For example, in FIG. 5 (c), in the adjacent unit structures 10a and 10b, the relative reflection phase of the electromagnetic wave in the maximum thickness cell region 11f having the maximum thickness t6 of one unit structure 10a is -300°, and the relative reflection phase of the electromagnetic wave in the minimum thickness cell region 11a having the minimum thickness t1 of the other unit structure 10b is -360°, and the absolute value of a difference between the relative reflection phase of the electromagnetic waves in the maximum thickness cell region 11f having the maximum thickness t6 of one unit structure 10a and the relative reflection phase of the electromagnetic waves in the minimum thickness cell region 11a having the minimum thickness t1 of the other unit structure 10b, is 60°.

Also, in one unit structure of the dielectric layer, the difference of the relative reflection phase of the electromagnetic waves in neighboring cell regions is preferably equal. For example, as shown in FIG. 5 (b), if the unit structure 10 of the dielectric layer 5 includes six cell regions, each of the difference of the relative reflection phases of the electromagnetic waves in the neighboring cell regions 11a and 11b, the difference of the relative reflection phases of the electromagnetic waves in the neighboring cell regions 11b and 11c, the difference of the relative reflection phases of the electromagnetic waves in the neighboring cell regions 11c and 11d, the difference of the relative reflection phases of the electromagnetic waves in the neighboring cell regions 11d and 11e, and the difference of the relative reflection phases of the electromagnetic waves in the neighboring cell regions 11e and 11f, are preferably equal. For example, in FIG. 5 (c), all of the absolute values of differences in the relative reflection phases of electromagnetic waves in neighboring cell regions are 60° and equal.

In addition, when the maximum thickness cell region having the maximum thickness in one unit structure and the minimum thickness cell region having the minimum thickness in the other unit structure are adjacent to each other in the adjacent unit structure, on the basis of the reflection phase in the cell region where the delay of the reflection phase in one unit structure is the smallest, when the relative reflection phase of the electromagnetic wave in the minimum thickness cell region having the minimum thickness in the other unit structure is set to be over - 720° and -360° or less shifted by one cycle, the difference in the relative reflection phases of the electromagnetic waves in neighboring cell regions are preferably equal not only in all the cell regions in one unit structure but also including the minimum thickness cell region having the minimum thickness in the other unit structure. For example, in FIG. 5 (c), in adjacent unit structures 10a and 10b, the relative reflection phases of electromagnetic waves in each cell region 11a to 11f of one unit structure 10a are respectively 0°, -60°, -120°, -180°, -240°, and -300°, and the relative reflection phase of electromagnetic waves in the minimum thickness cell region 11a having the minimum thickness t1 of the other unit structure 10b is -360°and in all the cell regions 11a to 11f in one unit structure 10a, and including the minimum thickness cell region 11a having the minimum thickness t1 in the other unit structure 10b, the absolute values of difference in the relative reflection phases of the electromagnetic waves in neighboring cell regions are all 60° and equal.

Also, in one unit structure of the dielectric layer, an absolute value of a difference between the relative reflection phase of the electromagnetic waves in the minimum thickness cell region having the minimum thickness, and the relative reflection phase of the electromagnetic waves in the maximum thickness cell region having the maximum thickness, is less than 360°. Also, in one unit structure of the dielectric layer, an absolute value of a difference between the relative reflection phase of the electromagnetic waves in the minimum thickness cell region having the minimum thickness, and the relative reflection phase of the electromagnetic waves in the maximum thickness cell region having the maximum thickness needs to be more than 180°, and is preferably 300° or more and less than 360°. For example, as shown in FIG. 5 (b), when the unit structure 10 of the dielectric layer 5 includes six cell regions, in one unit structure 10, an absolute value of a difference between the relative reflection phase of the electromagnetic waves in the minimum thickness cell region 11a having the minimum thickness t1, and the relative reflection phase of the electromagnetic waves in the maximum thickness cell region 11f having the maximum thickness t6, is preferably less than 360°. For example, in FIG. 5 (c), in one unit structure 10 of the dielectric layer 5, the relative reflection phase of the electromagnetic wave in the minimum thickness cell region 11a having the minimum thickness t1 is 0°, the relative reflection phase of the electromagnetic wave in the maximum thickness cell region 11f having the maximum thickness t6 is -300°, and the absolute value of the difference between the relative reflection phase of the electromagnetic wave in the minimum thickness cell region 11a having the minimum thickness t1 and the relative reflection phase of the electromagnetic wave in the maximum thickness cell region 11f having the maximum thickness t6 is 300°.

The size of the unit structure of the dielectric layer, specifically the length of the unit structure in a predetermined direction in which the thickness increases, is appropriately set according to the target reflection properties. The length of the unit structure in a predetermined direction in which the thickness increases allows the reflection angle to be adjusted because the one wavelength (phase difference: 360°) will be shifted. For example, by shortening the length of the unit structure in a predetermined direction in which the thickness increases, the difference of the reflection angle with respect to the regular reflection angle can be increased, while the difference of the reflection angle with respect to the regular reflection angle can be reduced by increasing the length of the unit structure in a predetermined direction in which the thickness increases.

Also, the cross-sectional shape of the unit structure of the dielectric layer may be, for example, a stepped shape in which the thickness stepwisely increases in a predetermined direction, or a tapered shape in which the thickness gradually increases in a predetermined direction. For example, FIG. 5 (b) is an example in which the unit structure 10 of the dielectric layer 5 has a stepped shape, and FIG. 9 is an example in which the unit structure 10 of the dielectric layer 5 has a tapered shape.

The unit structure of the dielectric layer includes a plurality of cell regions having different thicknesses, but if the cross-sectional shape of the unit structure of the dielectric layer has a tapered shape, the number of cell regions in the unit structure can be considered to be infinite. In this case, the thickness distribution of the unit structure is designed so that the relative reflection phase of the electromagnetic wave in each cell region is set as described above.

Further, since the dielectric layer includes a plurality of unit structures including a thickness distribution, the pattern shape in a planar view of the unit structure may be a shape that can be arranged without a gap, and examples of the shape may include a rectangular shape, a regular hexagon shape. For example, FIG. 7 (a) to (f) and FIG. 8 (a) are examples in which the pattern shape in the planar view of the unit structure 10 of the dielectric layer is rectangular.

In the unit structure of the dielectric layer, the difference in the round-trip optical path lengths in neighboring cell regions is designed such that the relative reflection phase of the electromagnetic waves in each cell region is set as described above, and the thickness of each cell region is set such that the difference in thickness of neighboring cell regions is the difference in the round-trip optical path lengths in the neighboring cell regions described above. The thickness of each cell region is appropriately set according to the wavelength of the electromagnetic wave, the dielectric constant of the material of the dielectric layer, and the intended reflection properties. For example, if the effective wavelength of the electromagnetic wave passing through the dielectric layer is λ_{g} and the thickness of the base is α, the thickness of each cell region is preferably about α + 0λ_{g} or more and α + 2λ_{g} or less. The thickness α of the base may be the same as the minimum thickness of the minimum thickness cell region having the minimum thickness in one unit structure of the dielectric layer. Although the thickness α of the base is appropriately set in consideration of the overall strength, ease of formation, etc., it is preferable that the thickness α of the base is typically about 0.1 λ_{g} or less, in view of the influence to the electromagnetic waves. Specifically, when the wavelength λ₀ in the air of the electromagnetic wave is 10 mm and the dielectric constant of the dielectric layer is 2.57, the thickness of each cell region is preferably 0 mm or more and 8.6 mm or less. When the thickness of the cell region is 0 mm, it means that the cell region located on the reflecting member is not formed with a dielectric layer.

Here, the effective wavelength of the electromagnetic wave means the wavelength when the electromagnetic wave passes through materials other than air, such as a dielectric layer. It should be noted that the wavelength is simply referred to as the wavelength in the air.

In the unit structure of the dielectric layer, the pitch and width of the cell region are appropriately set.

Also, when the reflecting member is a member in which a plurality of reflective elements is arranged, the pitch of the cell region of the unit structure of the dielectric layer may be the same as or different from the pitch of the reflective element of the reflecting member. If the pitch of the cell region of the unit structure of the dielectric layer is the same as the pitch of the reflective element of the reflecting member, the designing is easy. Also, for example, by narrowing the pitch of the cell region of the unit structure of the dielectric layer while keeping the difference in the relative reflection phase of the electromagnetic wave in the neighboring cell regions, the control region of the reflection properties can be widened regardless of the pitch of the reflective element of the reflecting member.

Also, in one unit structure of the dielectric layer, the pitch of the cell regions is preferably equal.

The pitch of the cell region refers to the distance from the center of one cell region to the center of the neighboring cell region.

Also, in one unit structure of the dielectric layer, the width of the cell regions in a predetermined direction in which the thickness increases, is preferably equal.

In the unit structure of the dielectric layer, the pattern shape of the cell region in plan view includes, for example, a stripe shape, one shape of the concentric square divided into four equal parts by straight lines perpendicular to each other and parallel to the sides, a microarray shape, a concentric quadrant, which is one shape of a concentric circle divided into four equal parts by diameter perpendicular to each other, a curved stepped shape, or the like. FIG. 7 (b) is an example of the stripe shape, FIG. 7 (d) is an example of one shape of the concentric square divided into four equal parts by straight lines perpendicular to each other and parallel to the sides, FIG. 7 (f) and FIG. 8 (a) are examples of the microarray shape, FIG. 8 (b) is an example of the concentric quadrant, and FIG. 8 (c) is an example of the curved stepped shape. Note that FIG. 7 (b) is a top view of FIG. 7 (a), FIG. 7 (d) is a top view of FIG. 7 (c), and FIG. 7 (f) is a top view of FIG. 7 (e). Further, when these illustrated unit structures are arranged without gaps, there is no particular restriction in the direction of the arrangement; for example, a rectangular unit structure may be arranged on the entire surface in a state of being rotated clockwise by 30 degrees in a plan view, and the unit structure may be selected and arranged at an appropriate angle and an appropriate arrangement direction according to the required reflection properties' design.

The unit structure of the dielectric layer includes a plurality of cell regions. In one unit structure of the dielectric layer, the number of cell regions is, for example, 3 or more and preferably 6 or more. The greater the number of cell regions in one unit structure of the dielectric layer, the smaller the difference in the relative reflection phase of the electromagnetic waves in neighboring cell regions, and the wavefront of the reflected waves can be smoothed. Also, the larger the number of cell regions in one unit structure of the dielectric layer, the more preferable, and there is no upper limit thereto. When the cross-sectional shape of the unit structure is stepped shape, the number of cell regions corresponds to the number of steps in the stepped shape. Also, when the cross-sectional shape of the unit structure is tapered shape, the tapered shape can be regarded as having an infinite number of cell regions, as described above.

The dielectric layer includes, as the unit structure, at least a first unit structure including three or more cell regions of which thickness differs from one another.

Also, the dielectric layer may include only the first unit structure as the unit structure, and may further include a second unit structure different from the first unit structure. In other words, the dielectric layer may include only the same unit structure as the unit structure and may include different unit structures. If the dielectric layer is one in which a plurality of different unit structures is arranged, the total reflection properties of the frequency selective reflector can be influenced. Specifically, the adjustment of polarization characteristics, the effect on the beam profile (such as highly directional, diffusive, and multi-beam and the like) are to be influenced.

In the first unit structure and the second unit structure, the reflection properties can be varied, and for example, at least one of the length of the unit structure in the direction in which the thickness increases, the thickness distribution, the number of cell regions, the width of the cell region, the pitch of the cell region, the pattern shape in the plan view of the unit structure, and the pattern shape in the plan view of the cell region can be varied.

Also, when the dielectric layer includes unit structures different from each other as the unit structure, the number of types of unit structures is not particularly limited.

In the dielectric layer, a plurality of unit structures is arranged by appropriately selecting the thickness distribution of the dielectric layer so that the normal vector of the same phase surface of the reflected wave relative to the incident wave incident at a certain incident angle becomes the desired reflection direction, but for example, when the incident wave is reflected as a so-called plane wave which reflects the incident wave to a single direction, it is preferable that the dielectric layer is the one in which a plurality of only the same unit structures is arranged, the length of the unit structure in the direction in which the thickness increases is the same, and the pattern shape in the planar view of the cell region is more preferably striped. For example, in FIG. 5 (a) to (c), the dielectric layer 5 includes a plurality of only the same unit structures, the length L of the unit structures 10a and 10b in the predetermined direction D1 is the same, and the pattern shape of the cell regions 11a to 11f in the planar view is striped. In this case, as exemplified in FIG. 5, the incident wave W1 incident at a predetermined incident angle θ1 can be reflected at a single reflection angle θ2, and the reflected wave W2 can be a plane wave that does not spread. Also, although FIG. 5 (a) shows an arrangement in which the longitudinal direction of the stripes of the cell region is parallel to the shorter direction of the frequency selective reflector, but the arrangement is not limited thereto; in an actual frequency selective reflector, the longitudinal and shorter directions of the stripes of the cell region can be arbitrary set according to the design of the reflection properties.

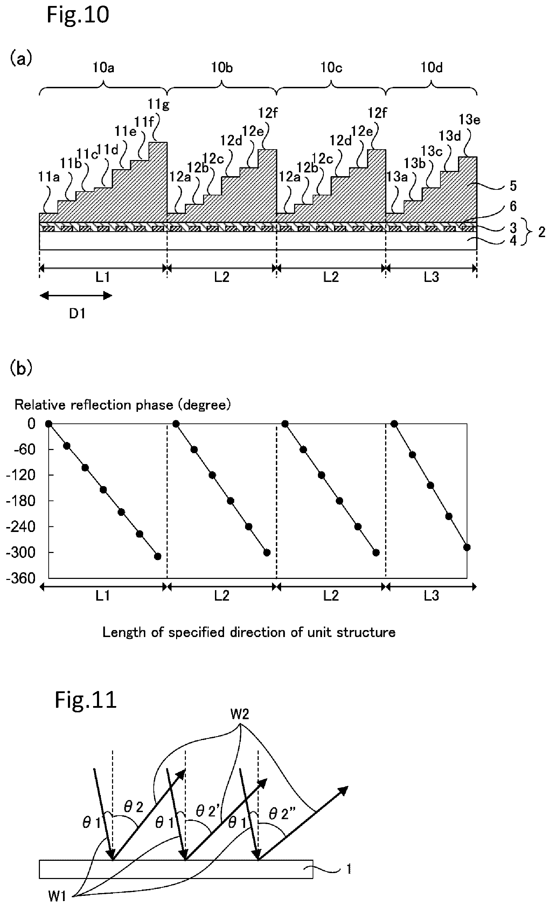

Also, for example, when spreading the electromagnetic waves, that is when reflected as a cylindrical wave, examples of the aspect of the dielectric layer is preferably the one that includes a plurality of mutually different unit structures arranged therein, the length of the unit structure in the direction in which the thickness increases is different, and the pattern shape in the planar view of the cell region is striped. For example, in FIG. 10 (a), the dielectric layer 5 includes unit structures 10a, 10b, 10c and 10d, which differ from one another, and in the unit structures 10a, 10b, 10c and 10d, the length L1, L2, and L3 of the unit structure in the predetermined direction D1 are different from each other, and the number of cell regions 11a to 11g, 12a to 12f, and 13a to 13e are different from each other. Thus, as shown in FIG. 10 (b), the relative reflection phases of the electromagnetic waves in each cell region 11a to 11g of the unit structure 10a are 0°, -51.4°, -103°, -154°, -206°, -257°, -309°, respectively; the relative reflection phases of the electromagnetic waves in each cell regions 12a to 12f of the unit structures 10b and 10c are 0°, -60°, -120°, -180°, -240°, -300°, respectively; the relative reflection phases of the electromagnetic waves in each cell regions 13a to 13e of the unit structure 10d are 0°, -72°, -144°, -216°, -288°, respectively; and the unit structures 10a, 10b, 10c and 10d have different reflection properties. Also, although not illustrated, the pattern shapes in the planner view of the cell regions 11a to 11g, 12a to 12f, and 13a to 13e are striped. In this case, as exemplified in FIG. 11, the incident wave W1 incident at a predetermined incident angle θ1 can be reflected at the reflection angles θ2, θ2', and θ2" depending on the unit structures, can be reflected with a spread, and the wavefront of the reflected wave W2 can be widened.

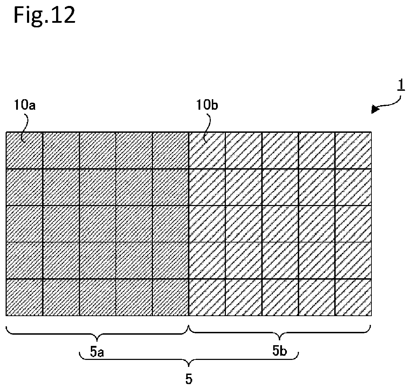

Further, when the dielectric layer includes unit structures different from each other as the unit structure, a plurality of types of unit structures having mutually different reflection properties may be used, a plurality of unit structures may be arranged for each type, and a region in which the plurality of unit structures of the same type is arranged may be arranged in a plane. For example, in FIG. 12, two types of unit structures 10a and 10b including different reflection properties are used to form a dielectric layer 5, in which a first region 5a where a plurality of unit structures 10a of one type is arranged and a second region 5b where a plurality of unit structures 10b of the other type is arranged, are arranged in a plane. In such an aspect, a plurality of coverage holes may be associated.

Further, for example, when the reflecting member described below is a frequency selective plate and includes a plurality of kinds of frequency selective surfaces (FSS) for selectively reflecting electromagnetic waves in mutually different frequency bands, the reflection properties of the unit structures may be respectively designed according to the frequency selectivity of the frequency selective surfaces, and the dielectric layer may include unit structures including different reflection properties as the unit structure. In this case also, for example, it can be arranged as shown in FIG. 12. In such an aspect, the dual band or more of the bands can be corresponded.

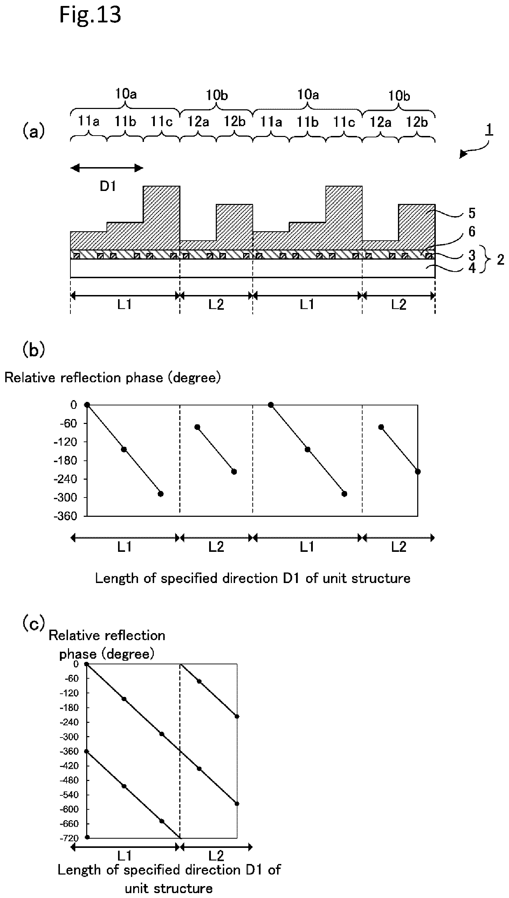

Also, when the dielectric layer includes unit structures different from each other as the unit structure, for example, the relative reflection phase of the electromagnetic waves in each cell region of n pieces of unit structures may be set so as to be shifted by n wavelengths (phase difference: n * 360 degree) by the n pieces of unit structures. Note that n is an integer greater than or equal to 2. For example, FIG. 13 (a) to (c) are examples in which the dielectric layer 5 includes two types of unit structures 10a and 10b different from each other, and the relative reflection phases of the electromagnetic waves in the cell regions 11a to 11c, 12a to 12b of the two unit structures 10a and 10b are set so as to be shifted by two wavelengths (phase difference: 720°) by the two unit structures 10a and 10b. FIG. 13(b) is a graph in which the range of the relative reflection phase of the electromagnetic wave is denoted as over -360° and 0° or less, and FIG. 13 (c) is a graph in which the range of the relative reflection phase of the electromagnetic wave is over -720° and 0° or less, and a point that the substantially the same phase of the relative reflection phase shifted by 360° is complimented. In these unit structures 10a and 10b, the length L1 and L2 of the unit structure in a predetermined direction D1 are different from each other, and the number of cell regions 11a to 11c, 12a to 12b are different from each other.

In the above case, one unit structure 10a includes three cell regions 11a to 11c, while the other unit structure 10b includes two cell regions 12a and 12b. In this manner, when the dielectric layer includes unit structures different from each other as the unit structure, at least one unit structure may include three or more cell regions including different thicknesses, and in other types of unit structures, the number of cell regions may not be three or more, but may be two.

When the incident wave and the reflected wave are plane waves, the dielectric layer includes a periodic structure in which the unit structure is repeatedly arranged. The term "periodic structure" refers to a structure in which a unit structure is periodically repeatedly arranged. In the unit structure in the periodic structure, in the unit structure having the same reflection properties, the length of the unit structure in the direction in which the thickness increases, the thickness distribution, the number of cell regions, the width of cell region, the pitch of cell region, the pattern shape in the plan view of the unit structure, the pattern shape in the plan view of the cell region, and the like can be made the same. Also, in the case where the dielectric layer has a periodic structure, the unit structures including different reflection properties can be combined as described above. In that case, the reflection properties of the unit structure to be combined are appropriately designed according to the target reflection properties, and specifically, the length of the unit structure in a direction in which the thickness increases, thickness distribution, the number of cell regions, the width of cell region, the pitch of cell region, the pattern shape of the unit structure in plan view, the pattern shape of the cell region in plan view, etc. in the unit structure to be combined are appropriately set according to the target reflection properties.

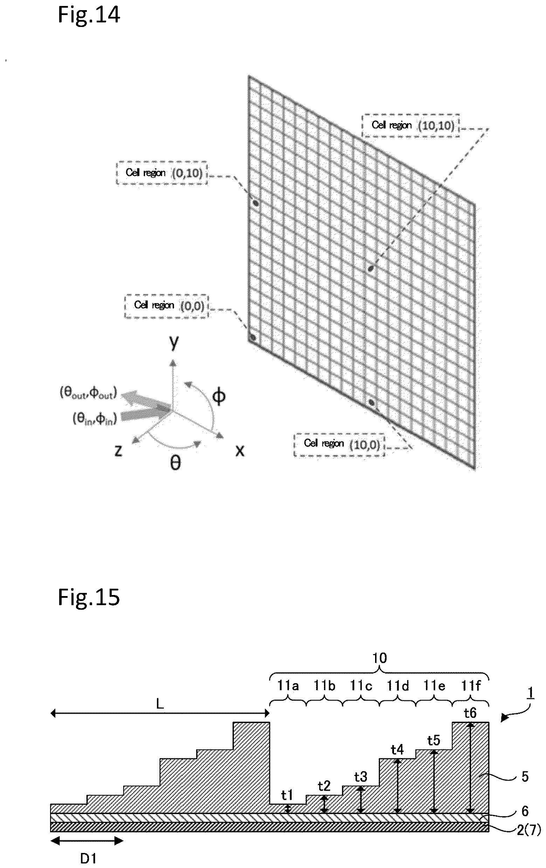

In general, a reflective characteristic design in which a plane wave is reflected as a plane wave to a direction different from the regular reflection direction, for example, can be designed by, after resolving into incident and reflection properties as the in-plane x-direction and in-plane y-direction of the reflective plate, converting them to a reflective phase distribution in the x-direction and the y-direction, and incorporating them as the thickness distribution of the unit structure. For example, as shown in FIG. 14, a part of the frequency selective reflector in which a cell region of the same size capable of individually adjusting a reflection phase is arranged to 10 * 10 (i = 10, j = 10), is described as an example. It should be noted that at this time, the magnitude of 10 * 10 of the cell region is not necessarily the size of the unit structure. The reflection phase δ_{i,j} determined in the cell region of the (i,j) position when the plane wave incident from the direction of the incident angle (θᵢₙ, φᵢₙ) is reflected by the plane wave in the direction of the reflection angle (θₒᵤₜ, φₒᵤₜ) is given by following equation. δi,j = 2π {p * i * (sinθout*cosφout - sinθin*cosφin) + p*j* (sinθout*sinφout - sinθin*sinφin)} / λ Here, in the above equation, indicated are:
δ_{i,j}: the reflection phase of the cell region in the (i,j) position with respect to phase center (0, 0)
λ: wavelength [m] of the reflected wave
p: size of the cell region [m]
θᵢₙ: θ slope of incident wave
φᵢₙ: φ slope of incident wave
θₒᵤₜ: θ slope of reflected wave
φₒᵤₜ: φ slope of reflected wave.

The dielectric layer may be, for example, a single layer or multiple layers. The dielectric layer may also include a substrate layer that can be a base and a concave and convex layer disposed on the substrate layer. Also, the dielectric layer may be, for example, a single member in which all cell regions are integrally formed, and may be one in which the individual cell regions are formed separately, and the block-like cell regions are arranged.

### (ii) Properties of the dielectric layer

The dielectric layer transmits electromagnetic waves in a particular frequency band and may or may not transmit electromagnetic waves in other frequency bands.

The dielectric loss tangent of the dielectric layer is preferably relatively small. The low dielectric loss tangent of the dielectric layer can reduce dielectric loss and reduce high frequency losses. Specifically, the dielectric loss tangent of the dielectric layer with respect to the electromagnetic wave of the target frequency is preferably 0.01 or less. Also, the dielectric loss tangent of the dielectric layer is the smaller the more preferable, and the lower limit value is not particularly limited.

Also, the dielectric constant of the dielectric layer is preferably relatively high. With the high dielectric constant of the dielectric layer, the effect of reducing the thickness of the dielectric layer can be expected. Specifically, the dielectric constant of the dielectric layer in the electromagnetic wave of the target frequency is preferably 2 or more, more preferably 2.5 or more, and further more preferably 3 or more when the difference in the reflection angle with respect to the regular reflection angle is increased.

Here, the dielectric loss tangent and the dielectric constant of the dielectric layer can be measured by a resonator method.

### (iii) Material of dielectric layer

The material of the dielectric layer is not particularly limited if it is a dielectric capable of transmitting a predetermined electromagnetic wave, and for example, a resin, glass, quartz, ceramics, or the like can be used. In view of the ease of forming the concave and convex structure, the resin is suitable among them.

Although the resin is not particularly limited if it is capable of transmitting a predetermined electromagnetic wave, it is preferably the one that absorption of the electromagnetic wave is relatively low and the transmittance of the electromagnetic wave is relatively high. Also, the resin preferably satisfies the aforementioned dielectric loss tangent, and more preferably satisfies the aforementioned dielectric constant. Examples of such resins may include polycarbonates, acrylic resins, ABS resins, PLA resins, olefinic resins, and copolymers thereof. In particular, the polycarbonate is suitable since it is excellent in dimensional stability and low in high frequency loss.

Also, the dielectric layer may further contain a filler.

The dielectric layer may contain a filler to adjust the dielectric constant and mechanical strength of the dielectric layer. The dielectric constant of the filler is preferably higher than the dielectric constant of the resin. This can increase the dielectric constant of the dielectric layer and reduce the thickness of the required dielectric layer. The high dielectric constant filler is not particularly limited, and examples thereof may include inorganic particles such as glass and silica, and fine fibers.

The filler material, shape, size, and content may be appropriately chosen from the desired dielectric constant, mechanical strength, and difficulty of dispersibility, etc. The size of the filler needs to be sufficiently smaller than the effective wavelength of the electromagnetic wave that passes through the dielectric layer, and if the effective wavelength of the electromagnetic wave is λ_{g}, the diameter of the filler sphere is preferably 0.01 λ_{g} or less. However, it tends to be difficult to uniformly disperse as the size of the filler approaches the nanometer order, the load of the processing process may increase. In addition, the content of the filler in the dielectric layer varies depending on the combination of the material of the dielectric and the filler, the shape of the filler, the size of the filler, and the like, and is appropriately adjusted.

When the concave and convex structure of the dielectric layer is formed by molding or the like using a mold, for example, a release agent, an antistatic agent, or the like may be added to the dielectric layer. These can be used as appropriately selected from those generally used. In addition, it is preferable that the dielectric layer does not contain additives or fillers such as carbon black and metal particles that impart electrical conductivity.

The dielectric layer usually includes the light transmittance.

### (iv) Method for forming dielectric layer

The method for forming the dielectric layer is not particularly limited if a predetermined concave and convex structure can be formed, and examples thereof may include cutting a resin sheet, laser processing, using a mold and vacuum casting, a 3D printer, and joining small piece parts. In the case of a forming method that does not use a mold, such as cutting, laser processing, and 3D printers, since customization according to the target reflection angle is easy, and thus it can be suitably used for tuning the design when designing and developing a large-scaled frequency selective reflector of which a special installation simulation and simulation are difficult. In the case of using a mold, it may be shaped on a substrate made of a dielectric, where the substrate and the shaped resin in this case may be materials that are different from each other if they are materials that transmit a predetermined electromagnetic wave. Also, for example, in the case of designing and manufacturing the reflecting member and the dielectric layer separately, by preparing a plurality of types of dielectric layers having reflection properties to have a predetermined incident angle and reflection angle in advance, selecting the type of the dielectric layer according to the situation, and rotating the dielectric layer in the plane with the normal direction as an axis with respect to the reflecting member, when a fine adjustment of the reflection direction of the electromagnetic wave is performed, the dielectric layer of the same specification can be made more cost effectively, and in that case, the method of using a mold is suitable.

### (b) Reflecting member

The reflecting member in the present aspect is a member that reflects electromagnetic waves in a particular frequency band.

The reflecting member is not particularly limited if it reflects electromagnetic waves in a particular frequency band, and for example, it may reflect only electromagnetic waves in a particular frequency band, or it may reflect not only electromagnetic waves in a particular frequency band but also electromagnetic waves in other frequency bands. In particular, the reflecting member preferably includes a wavelength selecting function that reflects only electromagnetic waves in a particular frequency band.

The reflecting member that reflects electromagnetic waves in a particular frequency band as well as other frequency bands may include, for example, a reflective layer disposed on the entire surface of the frequency selective reflector. For example, FIG. 15 is an example in which the reflecting member 2 is a reflective layer 7. In FIG. 15, the reflective layer 7 is disposed on the entire surface of the frequency selective reflector 1.

The material of the reflective layer is not particularly limited if it is a material capable of reflecting electromagnetic waves in a particular frequency band, and examples thereof may include a conductive material such as a metal material, carbon, and ITO.

The thickness of the reflective layer is not particularly limited if a thickness is capable of reflecting electromagnetic waves in a particular frequency band, and it is appropriately set.

In addition, the reflecting member that reflects only the electromagnetic waves of a particular frequency band may be the one that includes a wavelength selecting function that reflects only electromagnetic waves in the electromagnetic waves of a particular frequency band, and examples thereof may include a frequency selective plate.

Incidentally, the frequency selective plate is in the same contents as those described in the first embodiment above. For example, FIG. 5 (b) is an example in which the reflecting member 2 is a frequency selective plate, and the reflecting member 2 includes a dielectric substrate 4 and a plurality of reflective elements 3 arranged on a surface of the dielectric substrate 4 that is the dielectric layer 5 side.

The shape and the configuration of the reflective element are also in the same contents as those described in the first embodiment above.

The frequency reflective plate, that is, the reflecting member preferably includes a reflection phase control function controlling a reflection phase of the electromagnetic waves. In such a reflecting member, the reflection phase of the electromagnetic waves can be controlled by varying the resonant frequency per reflective element by varying the size and shape of the reflective element. Therefore, when the frequency selective plate has a reflection phase control function, the reflection properties of the electromagnetic wave can be controlled by controlling the reflection phase distribution of the electromagnetic wave by the thickness of the dielectric layer and the size and shape of the reflective element. Thus, for example, the reflection properties in two orthogonal directions (such as x-axis direction and y-axis direction) in the plane of the frequency selective reflector can be individually designed with the frequency selective plate and the dielectric layer, and the reflection properties of the desired electromagnetic wave can be obtained while suppressing the thickness of the dielectric layer.

General frequency selective surfaces may be applied as a frequency selective plate having a reflection phase control function. Although there are advantages and disadvantages in the design of these, it is possible to vary the reflection phase of the electromagnetic wave by varying the size and shape of these reflective element.

The sizes of the reflective element is appropriately selected depending on the shape of the reflective element.

In addition, the dielectric substrate may include the light transmittance, and may include the light non-transmittance.

### (c) Control of reflection direction of electromagnetic waves

In the frequency selective reflector of the present aspect, by varying the thickness of each cell region of the unit structure of the dielectric layer, the reciprocal optical path length in the dielectric layer can be varied per cell region, and the relative reflection phase of the electromagnetic wave can be controlled. Thereby, by adjusting the size and the plan view pattern of the unit structure of the dielectric layer as well as the number and thickness of the cell regions of the unit structure of the dielectric layer, the reflection direction of the electromagnetic wave incident from the predetermined direction can be controlled.

In addition, when the reflecting member is a frequency selective plate and is a member having a reflection phase control function, by varying the thickness of each cell region of the unit structure of the dielectric layer, the round-trip optical path length in the dielectric layer can be varied per cell region, and also, by varying the size and shape of the reflective element of the reflecting member, the resonance frequency per reflective element can be varied to control the reflection phase of the electromagnetic wave; thereby, the degree of freedom of design related to the reflection characteristic control can be increased.

In this case, it is also possible to divide the reflection control direction in the reflecting member and the reflection control direction in the dielectric layer, and perform two-dimensional reflection direction control in the entire frequency selective reflector. Also, when the reflection control directions in the reflecting member and the dielectric layer are overlapped, for example, a reflection phase distribution to be reflected in a certain direction to some degree can be achieved by the reflecting member, and further fine adjustment can be performed in the dielectric layer. In this case, there is an advantage that the thickness of the dielectric layer can be reduced.

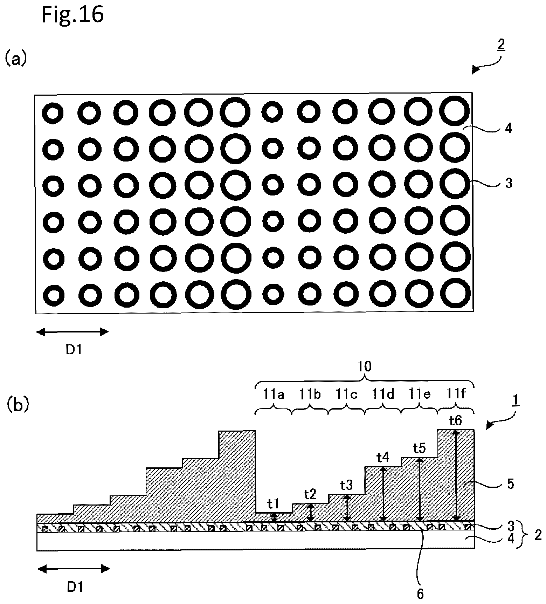

As the arrangement of the thickness distribution of the dielectric layer and the size distribution of the reflective element of the reflecting member, for example, as shown in FIG. 16 (a), (b), the dielectric layer 5 and the reflecting member 2 can be arranged so that the thickness of the cell regions 11a to 11f of the unit structure 10 of the dielectric layer 5 becomes thicker as the size of the reflective element 3 of the reflecting member 2 increases. In such an aspect, the thickness of the dielectric layer can be reduced. This makes it possible to reduce the weight and cost of the frequency selective reflector because the dielectric layer is thin, and to make the reflected wave less likely to hit the concave and convex structure side surface of the dielectric layer even when the reflection angle increases.

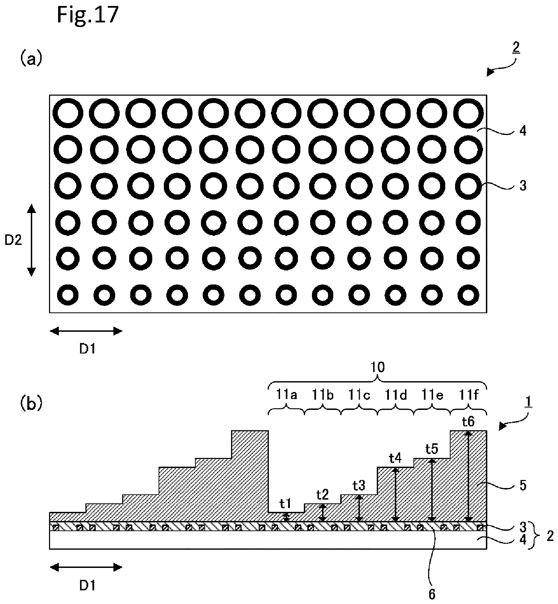

As an arrangement of the thickness distribution of the dielectric layer and the size distribution of the reflective element of the reflecting member, for example, as shown in FIG. 17 (a), (b), the dielectric layer 5 and the reflecting member 2 may be arranged such that the size of the reflective element 3 of the reflecting member 2 is increased along the direction D2, and the thickness of the cell regions 11a to 11f of the unit structure 10 of the dielectric layer 5 becomes thicker along a direction D1 perpendicular to the direction D2.

Incidentally, in FIG. 17 (a), (b), since the sizes of the reflective element are different in one cell region, the relative reflection phase of the electromagnetic wave in one cell region is partially different according to the sizes of the reflective element. Even in such a case, when cut out in a predetermined direction D1 in which the thickness increases, each point is on the same straight line in the graph described above.

Also, in the case of a specification in which the reflecting member and the dielectric layer are separately designed and combined, the reflection direction of the electromagnetic wave can be finely adjusted by rotating the dielectric layer in the plane with the normal direction as an axis with respect to the reflecting member to adjust the orientation of the cell region of the unit structure of the dielectric layer relative to the reflecting member.

Also, as described above, in the unit structure of the dielectric layer, the reflection properties can be controlled by adjusting the length of the unit structure in a predetermined direction in which the thickness increases. For example, by shortening the length of the unit structure in a predetermined direction in which the thickness increases, the reflection angle of the electromagnetic wave can be increased, while the reflection angle of the electromagnetic wave can be reduced by increasing the length of the unit structure in a predetermined direction in which the thickness increases.

The length of the unit structure in a predetermined direction in which the thickness increases in the unit structure of the dielectric layer refers to the length of the unit structure in the predetermined direction when the unit structure of the dielectric layer includes a thickness distribution in which the thickness increases in the predetermined direction. For example, in FIG. 15, in the unit structure 10 of the dielectric layer **5,** the thickness increases in a predetermined direction D1, and the length of the unit structure 10 in this predetermined direction D1 **is** L.

Incidentally, as described above, the in-plane arrangement of the concave and convex structure of the dielectric layer that achieves the in-plane distribution design of the reflection phase in the frequency selective reflector does not need to be in a fixed positional relationship with respect to the in-plane arrangement of the reflective element of the reflecting member, and even if the concave and convex structure of the dielectric layer is shifted and arranged relative to the in-plane arrangement of the reflective element, there is no significant effect on the reflection properties. Thus, when the reflecting member is a frequency selective plate and is a member having a reflection phase control function, it is possible to independently design the dielectric layer and the reflecting member, respectively.

### (d) Other configurations

The frequency selective reflector of the present aspect may include other configurations as required in addition to the reflecting member and the dielectric layer described above.

### (i) Adhesive layer

The frequency selective reflector of the present aspect may include an adhesive layer between the reflecting member and the dielectric layer. The adhesive layer may bond the reflecting member and the dielectric layer. Further, when the reflecting member is a member in which a plurality of reflective elements arranged, the adhesive layer may flatten the unevenness of the reflective element, and may suppress the influence of unevenness caused by the reflective element when the dielectric layer is laminated on the reflecting member. For example, in FIG. 5 (b), an adhesive layer 6 is disposed between the reflecting member 2 and the dielectric layer 5.

The adhesive layer may be, for example, an adhesive agent or a pressure-sensitive adhesive agent, and may be appropriately selected from known adhesive agents and pressure-sensitive adhesive agents. In that case, the adhesive agent or the pressure-sensitive adhesive agent needs to be a non-conductor. In addition, when the adhesive agent or the pressure-sensitive adhesive agent is in a liquid state, it is preferable that the one can be uniformly spread and have a fluidity to the extent capable of removing the biting of bubbles. In addition, when the adhesive agent or the pressure-sensitive adhesive agent is in the form of a sheet, the thickness is preferably uniform, and it is preferable to have flexibility to the extent capable of following the unevenness of the bonding interface and suppressing the biting of bubbles.

The thickness of the adhesive layer is preferably uniform and in thickness to provide the desired adhesive force. Also, when the reflecting member is a member in which a plurality of reflective elements arranged, the thickness of the adhesive layer is preferably equal to or greater than the thickness of the reflective element from the point of planarization. In this case, when the adhesive layer is thicker than the thickness of the reflective element, the reflective element is embedded in the adhesive layer. Preferably, the thickness of the adhesive layer is sufficiently smaller than the effective wavelength of the target electromagnetic wave, and when the effective wavelength of the electromagnetic wave is λ_{g}, specifically, it is preferably 0.01 λ_{g} or less.

### (ii) Space

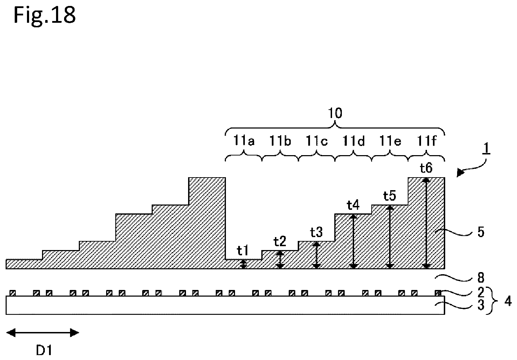

The frequency selective reflector of the present aspect may include a space between the reflecting member and the dielectric layer. For example, in FIG. 18, a space 8 is arranged between the reflecting member 2 and the dielectric layer 5.

When a space is arranged between the reflecting member and the dielectric layer, the distance between the reflecting member and the dielectric layer is preferably constant. This makes it possible to align the optical path lengths in the space.

### (iii) Protective member

The frequency selective reflector of the present aspect may include a protective member on a surface of the dielectric layer that is opposite side to the reflecting member. The protective member can protect the dielectric layer. Design can also be imparted by the protective member.

### (iv) Ground layer

The frequency selective reflector of the present aspect may include a ground layer on a surface of the reflecting member that is opposite to the dielectric layer. The ground layer can block interference with objects present on the backside of the frequency selective reflector and suppress the occurrence of noise. The ground layer may also be a part of the reflecting member that does not have wavelength selectivity. As the ground layer, a common conductive layer such as a metal layer, a metal mesh, a carbon film, an ITO film, or the like can be used.

### (v) Planarizing layer

The frequency selective reflector of the present aspect may include a planarizing layer between the reflecting member and the dielectric layer. When the reflecting member is a member in which a plurality of reflective elements arranged, the planarizing layer can flatten the unevenness of the reflective elements, and can suppress the influence of the unevenness due to the reflective elements when the dielectric layer is laminated on the reflecting member. It should be noted that the planarizing layer referred to herein is the one disposed separately from the adhesive layer. Example thereof may be an ionizing radiation cured resin layer disposed in the state of embedding the reflective element. Further, when a space is provided between the reflecting member and the dielectric layer, the planarizing layer may be provided with a function of protecting the reflective element.

### (vi) Anti-reflective layer

Because of the impact of reflections at the dielectric layer interface in the case of high frequencies, in the frequency selective reflector of the present aspect, an anti-reflective layer may be disposed in the interface between the dielectric layer and the air. The anti-reflective layer may have, for example, a multilayer structure having a different dielectric constant, and may include a concave and convex structure smaller than the effective wavelength of the electromagnetic wave.

### (3) Positional matching of frequency selective reflectors

In the present embodiment, it is possible to match the positions of a plurality of frequency selective reflectors by using the first alignment mark of the substrate. For example, the positions of the frequency selective reflectors may be matched by matching the positions of the edges of the frequency selective reflectors on the basis of the first alignment mark of the substrate. Also, for example, the frequency selective reflectors may include a second alignment mark, and the positions of the frequency selective reflectors may be matched by matching the position of the second alignment mark of the frequency selective reflectors on the basis of the first alignment mark of the substrate.

For example, in FIG. 1, the substrate 21 includes a first alignment mark 22 in a cross shape, and the positions of the frequency selective reflectors 1 are matched by matching the positions of the edges of the frequency selective reflectors on the basis of the first alignment mark 22 of the substrate 21. In specific, when the outer periphery region of the frequency selective reflector includes the light non-transmittance, the substrate 21 includes the light transmittance, and the first alignment mark 22 includes the light non-transmittance, the first alignment mark 22 of the substrate 21 and the edge of the frequency selective reflector 1 are detected by the transmitted light, and thereby the positions of the frequency selective reflectors 1 can be matched. Also, when the outer periphery region of the frequency selective reflector 1 includes the light reflecting properties, and the first alignment mark 22 includes the light reflecting properties, the first alignment mark 22 of the substrate 21 and the edge of the frequency selective reflector 1 are detected by the reflected light, and thereby the positions of the frequency selective reflectors 1 can be matched.

When the outer periphery region of the frequency selective reflector includes the light non-transmittance, for example, in the case of the frequency selective reflector of the first aspect, by making the dielectric substrate of the reflecting member have the light non-transmittance, by disposing a ground layer on the entire surface of the substrate side surface of the reflecting member, or by disposing a light shielding layer containing a metal material or a resin on the entire surface of the substrate side surface of the reflecting member or only in the outer periphery region, the outer periphery region of the frequency selective reflector may have light non-transmittance.

Also, when the outer periphery region of the frequency selective reflector includes the light non-transmittance, for example, in the case of the frequency selective reflector of the second aspect, by making the dielectric substrate of the reflecting member have the light non-transmittance, by disposing a ground layer on the entire surface of the substrate side surface of the reflecting member, by using the reflecting member as a reflective layer disposed on the entire surface of the frequency selective reflector, or by disposing a light shielding layer containing a metal material or a resin on the entire surface of the substrate side surface of the reflecting member or only in the outer periphery region, the outer periphery region of the frequency selective reflector may have the light non-transmittance.

Also, when the outer periphery region of the frequency selective reflector includes the light reflecting properties, for example, in the case of the frequency selective reflector of the first aspect, by disposing a ground layer on the entire surface of the substrate side surface of the reflecting member, or by disposing a light shielding layer containing a metal material on the entire surface of the substrate side surface of the reflecting member or only in the outer periphery region, the outer periphery region of the frequency selective reflector may have the light reflecting properties.

Also, when the outer periphery region of the frequency selective reflector includes the light reflecting properties, for example, in the case of the frequency selective reflector of the second aspect, by disposing a ground layer on the entire surface of the substrate side surface of the reflecting member, by using the reflecting member as a reflective layer disposed on the entire surface of the frequency selective reflector, or by disposing a light shielding layer containing a metal material on the entire surface of the substrate side surface of the reflecting member or only in the outer periphery region, the outer periphery region of the frequency selective reflector may have the light reflecting properties.

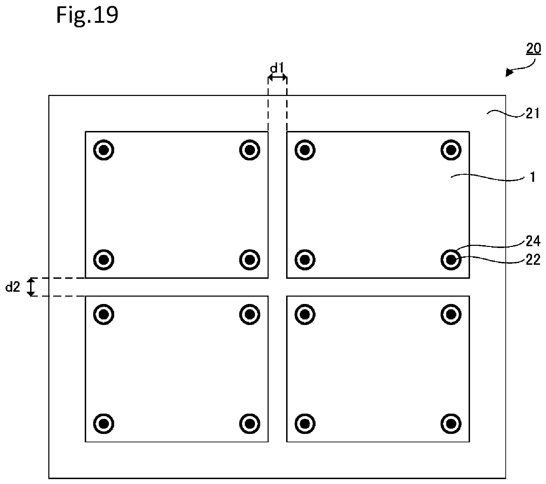

Also, for example, in FIG. 19, the substrate 21 includes first alignment mark 22 in a circle shape, and the frequency selective reflector 1 includes a second alignment mark 24 in a hollow circle shape, thereby the positional matching of the frequency selective reflectors 1 is performed by matching the positions of the second alignment mark 24 of the frequency selective reflector 1 on the basis of the first alignment mark 22 of the substrate 21. In specific, when the substrate 21 includes the light transmittance, the first alignment mark 22 includes the light non-transmittance, and the second alignment mark 24 includes the light non-transmittance, as well as when the dielectric substrate of the reflecting member of the frequency selective reflector 1 includes the light transmittance, the first alignment mark 22 of the substrate 21 and the second alignment mark 24 of the frequency selective reflector 1 are detected by the transmitted light, and the positions of the frequency selective reflectors 1 can be matched. Also, when the first alignment mark 22 includes the light reflecting properties, and the second alignment mark 24 includes the light reflecting properties, as well as when the dielectric substrate of the reflecting member of the frequency selective reflector 1 includes the light transmittance, the first alignment mark 22 of the substrate 21 and the second alignment mark 24 of the frequency selective reflector 1 are detected by the reflected light, and the positions of the frequency selective reflectors 1 can be matched.

Note that the reflective element configuring the reflecting member of the frequency selective reflector may include the light non-transmittance and the light reflecting properties. Even in such a case, for example, by making the size of the reflective element largely different from the sizes of the first alignment mark and the second alignment mark, the transmitted light or the reflected light by the first alignment mark and the second alignment mark can be distinguished from the transmitted light or the reflected light by the reflective element. Also, even in the above described case, for example, in the frequency selective reflector, by not disposing the reflective element around the second alignment mark, the transmitted light or the reflected light by the first alignment mark and the second alignment mark can be distinguished from the transmitted light or the reflected light by the reflective element. Thereby, the positional matching of the frequency selective reflectors is possible.

It should be noted that, when the reflective element is not disposed around the second alignment mark in the frequency selective reflector, since the total area of the region where the reflective element is not disposed is sufficiently small with respect to the area of the whole frequency selective reflector, it is considered to hardly influence to the reflecting properties.

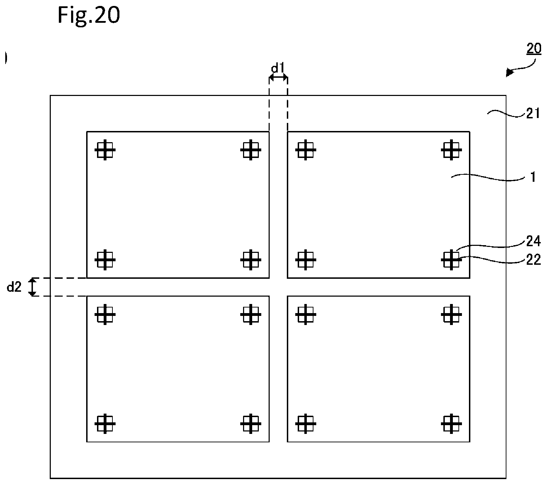

Also, for example, in FIG. 20, the substrate 21 includes the first alignment mark 22 in a cross shape, and the frequency selective reflector 1 includes the second alignment mark 24 that is a penetration hole in a square shape, thereby the positional matching of the frequency selective reflectors 1 is performed by matching the position of the second alignment mark 24 of the frequency selective reflector 1 on the basis of the first alignment mark 22 of the substrate 21. In specific, when the substrate 21 includes the light transmittance, and the first alignment mark 22 includes the light non-transmittance, the first alignment mark 22 of the substrate 21 is detected by the transmitted light through the penetration hole (second alignment mark 24) of the frequency selective reflector 1, and the positions of the frequency selective reflectors 1 are matched. Also, when the first alignment mark 22 includes the light reflecting properties, the first alignment mark 22 of the substrate 21 is detected by the reflected light through the penetration hole (second alignment mark 24) of the frequency selective reflector 1, and the positions of the frequency selective reflectors 1 are matched.

Also, although not illustrated, when the substrate includes a first alignment mark that is a penetration hole, and when the frequency selective reflector includes a second alignment mark that is a penetration hole, the position of the second alignment mark of the frequency selective reflector is matched on the basis of the first alignment mark of the substrate, and the positions of the frequency selective reflectors are matched. In specific, the penetration hole (second alignment mark) of the frequency selective reflector and the penetration hole (first alignment mark) of the substrate are detected by the transmitted light, and the positions of the frequency selective reflectors can be matched. Also, the positions of the frequency selective reflectors can be matched by inserting a pin to the penetration hole (first alignment mark) of the substrate, and fitting the penetration hole (second alignment mark) of the frequency selective reflector to the pin. In this case, the frequency selective reflector can be fixed on the substrate by the pin.

When the second alignment mark is the penetration hole, in the frequency selective reflector, there is no reflective element in the part of the second alignment mark. In this case, in the frequency selective reflector, since the total area of the penetration hole that is the second alignment where the reflective element is not present is sufficiently small with respect to the area of the whole frequency selective reflector, it is considered to hardly influence to the reflecting properties.

### (a) Second alignment mark

In the present embodiment, the frequency selective reflector may include a second alignment mark. The second alignment mark is a mark to perform the positional matching of the frequency selective reflectors.

The second alignment mark may include the light non-transmittance. Also, the second alignment mark may include the light reflecting properties. These optical properties of the second alignment mark are appropriately selected depending on the detection method of the second alignment mark, by the transmitted light or by the reflected light.

The transmittance rate and the reflection rate of the second alignment mark are not particularly limited if the second alignment mark can be detected by the transmitted light or by the reflected light, and are appropriately set depending on the factors such as the material and the thickness of the second alignment mark.

Also, the second alignment mark may be a penetration hole that penetrates the frequency selective reflector.

The plan view shape of the second alignment mark is not particularly limited, and is the same as the plan view shape of general alignment marks. Specific examples of the plan view shape of the second alignment mark are the same as those of the first alignment mark above.

The size and the line width of the second alignment mark are not particularly limited if the second alignment mark can be detected.

The number of the second alignment mark is not particularly limited if the positions of the frequency selective reflectors can be matched.

The position of the second alignment mark in the frequency selective reflector is not particularly limited, but the second alignment mark is usually disposed in the outer periphery region of the frequency selective reflector.

The second alignment mark may be disposed on the substrate side surface of the frequency selective reflector, and may be disposed on a surface of the frequency selective reflector that is opposite side to the substrate.

The thickness of the second alignment mark is not particularly limited if it is a thickness capable of forming the second alignment mark accurately, and it is appropriately adjusted depending on the factors such as the optical properties of the second alignment mark.

The material and the method for forming the second alignment mark are the same as those of the first alignment mark above.

Also, if the positional matching of the frequency selective reflectors is possible, a part of the reflective element configuring the reflecting member of the frequency selective reflector may be used as the second alignment mark.

### (b) Second identification mark

In the present embodiment, for example, as shown in FIG. 2, the frequency selective reflector 1 may include a second identification mark 25 to identify the frequency selective reflector 1. For example, in FIG. 2, the frequency selective reflector 1 includes the second identification marks 25 of "No 1", "No 2", "No 3" and "No 4". When the frequency selective reflector includes the second identification mark, each frequency selective reflectors can be easily identified, and up and down, left and right, and front and back of the frequency selective reflector can also be easily identified, and thus each frequency selective reflectors can be accurately and easily disposed in the correct position. In particular, it is useful when the reflection properties of a plurality of the frequency selective reflectors are different from one another.

The second identification mark may include the light non-transmittance. Also, the second identification mark may include the light reflecting properties. These optical properties of the second identification mark are appropriately selected depending on the detection method of the second identification mark, by the transmitted light or by the reflected light, similarly to the second alignment mark.

The transmittance rate and the reflection rate of the second identification mark are not particularly limited if the second identification mark can be detected by the transmitted light or the reflected light, and they can be appropriately set depending on the factors such as the material and the thickness of the second identification mark.

The second identification mark is not particularly limited if it is a mark that can be identified, and examples thereof may include letters, symbols, and shapes. Specific examples thereof may include codes. Also, examples thereof may include "top", "bottom", "upper right", "upper left", "lower right", "lower left", "UR", "UL", "LR", and "LL" in addition to "No 1", "No 2", "No 3", "No 4", "1", "2", "3" and "4". Also, the second identification mark may be a data capable of optical character recognition (OCR).

The size and the line width of the second identification mark are not particularly limited if the second identification mark can be detected.

The position of the second identification mark in the frequency selective reflector is not particularly limited if each frequency selective reflectors can be identified. Also, up and down, and left and right of the frequency selective reflector can be identified by the position of the second identification mark in the frequency selective reflector.

Also, when the second identification mark is disposed on a side facing to each frequency selective reflectors, or disposed in a position close to a corner part of each frequency selective reflectors, whether each frequency selective reflectors is disposed in the correct position can be easily detected or recorded. As an example, when four pieces of the frequency selective reflectors are disposed in the positions of upper left, upper right, lower left, and lower right, in each of the frequency selective reflectors, by disposing the second identification marks gathering around the corner near the central part of whole four frequency selective reflectors, whether each of the frequency selective reflectors is correctly disposed can be detected or recorded by photographing once.

The second identification mark may be disposed in the substrate side surface of the frequency selective reflector, and may be disposed on a surface of the frequency selective reflector that is opposite side to the substrate.

The thickness, the material, and the method for forming the second identification mark are the same as the thickness, the material, and the method for forming of the second alignment mark.

When the material of the second identification mark is the same as the material of the second alignment mark, the second alignment mark and the second identification mark can be formed at the same time.

When the frequency selective reflector includes the second identification mark, the substrate may or may not include the first identification mark. When the number of the frequency selective reflectors is little, by using the second identification mark, with which the position of each frequency selective reflectors can be known, each frequency selective reflectors can be disposed in the correct positions even when the substrate does not include the first identification mark. Examples of such a second identification mark may include "top", "bottom", "upper right", "upper left", "lower right", "lower left", "UR", "UL", "LR" and "LL". When the frequency selective reflector includes the second identification mark and the substrate does not include the first identification mark, the number of the frequency selective reflectors is preferably 3 lines or less and 3 columns or less.

### (c) Cut part

The frequency selective reflector may include a cut part in which a part of the frequency selective reflector is cut. In this case, the frequency selective reflector may include the cut part instead of the second identification mark, or may include the cut part in addition to the second identification mark. The cut part is a mark that shows the direction of a surface of the frequency selective reflector. When the frequency selective reflector includes the cut part, up and down, left and right, and front and back of the frequency selective reflector can be easily identified, and thus each frequency selective reflectors can be easily disposed in the correct positions.

The cut part is not particularly limited if it is a part that can show the direction of a surface of the frequency selective reflector by imparting an asymmetric shape to the frequency selective reflector, and examples thereof may include a corner chamfer in which one corner part of the frequency selective reflector is cut off, an incision part like a so-called notch, or a part in which a part of a curved line part is cut off such as an orientation flat. There are not particular limitations on the plan view shape of the cut part, and examples thereof may include V-shape and U-shape.

### (d) Concave and convex part

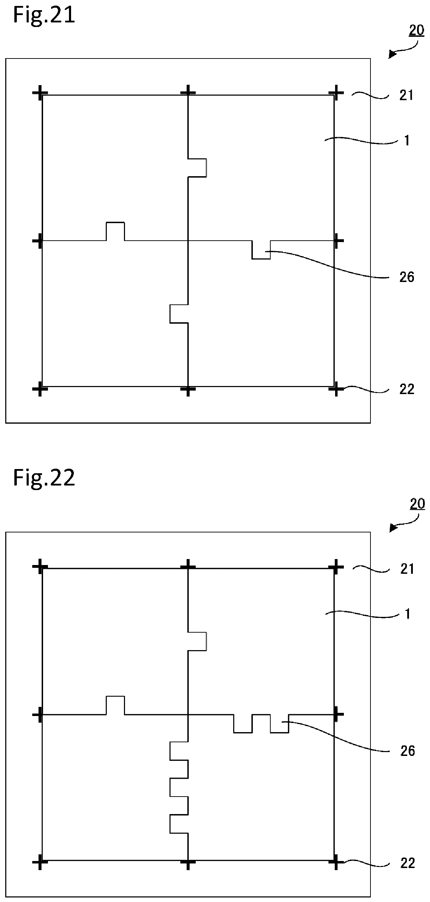

In the present embodiment, for example, as shown in FIG. 21 and FIG. 22, each of the adjacent the frequency selective reflectors 1 may include a concave and convex part 26 capable of fitting each other on side surfaces facing to each other, and the adjacent frequency selective reflectors 1 may be disposed so that the concave and convex part 26 fits each other. By fitting the concave and convex part, the positional matching of a plurality of the frequency selective reflectors can be easily performed. Also, since the contact area of adjacent frequency selective reflectors increases, the strength can be improved.

Also, for example, in FIG. 22, in each frequency selective reflectors 1, the number of the concave and convex part 26 differs from one another. In this manner, when the number, the shape, the size and the like of the concave and convex part differ from one another in each frequency selective reflectors, the frequency selective reflectors can be identified. For this reason, in the case where the reflection properties of a plurality of the frequency selective reflectors are different, when the frequency selective reflector includes the second identification mark, each of the frequency selective reflectors can be easily identified, and also, up and down, left and right, and front and back of the frequency selective reflector can be easily identified, and thus each of the frequency selective reflectors can be accurately and easily disposed in the correct positions.

The shape of the concave and convex part is not particularly limited if it is a shape capable of fitting.

The number and the size of the concave and convex part are not particularly limited if it is capable of forming the concave and convex part on the side surface of the frequency selective reflector.

In the adjacent frequency selective reflectors, the thicknesses of the concave and convex part are preferably equal. The positional matching of the adjacent frequency selective reflectors will be easy.

Note that the concave and convex part may not fit without a gap on the side surfaces of the adjacent frequency selective reflectors facing to each other. In other words, there may be a space between the fitting concave and convex parts.

### (4) Variations

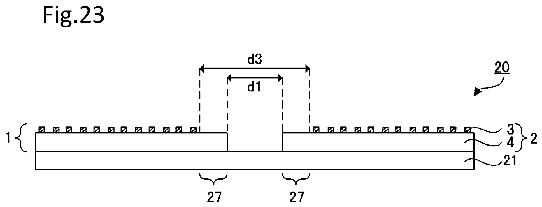

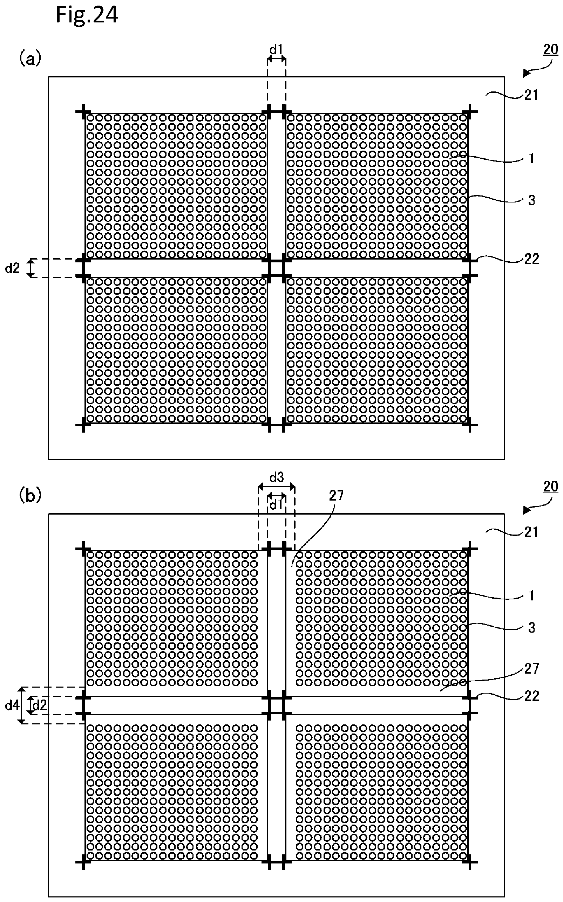

In the present embodiment, in the case of the frequency selective reflector of the first aspect, the reflective elements may not be disposed on an end part region where the adjacent frequency selective reflectors face to each other. For example, in FIG. 23 and FIG. 24 (b), the reflective elements 3 are not disposed on a dielectric substrate 4 in an end part region 27 where the adjacent frequency selective reflectors 1 face to each other.

In this manner, when the reflective elements are not disposed in the end part region where the adjacent frequency selective reflectors face to each other, compared to when the reflective elements are disposed in the end part region where the adjacent frequency selective reflectors face to each other, the margin of the positional deviation upon disposing the frequency selective reflector on one surface of the substrate can be decreased. As a result, the positional deviation of the frequency selective reflector can be inhibited.

For example, FIG. 24 (a) is an example in which the reflective elements 3 are disposed in the end part region 27 where the adjacent frequency selective reflectors 1 face to each other. Meanwhile, for example, FIG. 24 (b) is an example in which the reflective elements 3 are not disposed in the end part region 27 where the adjacent frequency selective reflectors 1 face to each other. Here, in FIG. 24 (a), (b), the region where the reflective elements 3 are disposed is focused. In FIG. 24 (a), in the end part region 27 where the adjacent frequency selective reflectors 1 face to each other, the reflective elements 3 are disposed, and the distance between the regions where the reflective elements 3 are disposed in the adjacent frequency selective reflectors is distance d1, d2 between the adjacent frequency selective reflectors 1. In contrast, in FIG. 24 (b), the reflective elements 3 are not disposed in the end part region 27 where the adjacent frequency selective reflectors 1 face to each other, and the distance d3, d4 between the regions where the reflective elements 3 are disposed in the adjacent frequency selective reflectors 1 is larger than the distance d1, d2 between the adjacent frequency selective reflectors 1.

In these examples, a case in which the distance between the regions where the reflective elements 3 are disposed in the adjacent frequency selective reflectors 1 is designed to be, for example, 1 mm is considered.

In FIG. 24 (a), when the distance between the regions where the reflective elements 3 are disposed in the adjacent frequency selective reflectors, that is the distance d1, d2 between the adjacent frequency selective reflectors 1 is designed to be, for example, 1 mm, the frequency selective reflectors 1 can deviate from the designed position by up to 1 mm, when trying to dispose the adjacent frequency selective reflectors 1 not to overlap.

In contrast, in FIG. 24 (b), when distance d3, d4 between the regions where the reflective elements 3 are disposed in the adjacent frequency selective reflectors 1 is designed to be, for example, 1 mm, since there is the end part region 27, the margin of the positional deviation from the designed position will be less than 1 mm when trying to dispose the adjacent frequency selective reflectors 1 not to overlap. In this case, when the distance d1, d2 between the adjacent frequency selective reflectors 1 is designed to be 0.5 mm, the frequency selective reflectors 1 can deviate from the designed position by up to 0.5 mm, when trying to dispose the adjacent frequency selective reflectors 1 not to overlap.

Thus, when the reflective elements are not disposed in the end part region where the adjacent frequency selective reflectors face to each other, the margin of the positional deviation from the designed position of the frequency selective reflector can be decreased compared to when the reflective elements are disposed in the end part region where the adjacent frequency selective reflectors face to each other. Thereby, the positional deviation of the frequency selective reflectors can be inhibited.

Here, when the reflection properties of a plurality of the frequency selective reflectors differ from one another, for example, a reflection beam by the whole reflecting structure can be formed when the reflection beams of each frequency selective reflectors overlap. For this reason, when the reflection properties of a plurality of the frequency selective reflectors differ from one another, influence of the positional deviation of the frequency selective reflectors to the reflection beam profile of the whole reflecting structure is greater compared to when the reflection properties of a plurality of the frequency selective reflectors are the same. Thus, when the reflection properties of a plurality of the frequency selective reflectors differ from one another, there is a possibility that the reflection beam profile of the whole reflecting structure may be disturbed due to the positional deviation of the frequency selective reflectors.

Therefore, when the reflection properties of a plurality of the frequency selective reflectors differ from one another, the positional deviation of the frequency selective reflectors can be inhibited by not disposing the reflective elements in the end part region where the adjacent frequency selective reflectors face to each other, and as a result, the reflection beam profile by the whole reflecting structure can be prevented from being disturbed.

When the reflective elements are not disposed in the end part region where the adjacent frequency selective reflectors face to each other, the reflection intensity of the electromagnetic waves in the whole reflecting structure decreases compared to when the reflective elements are disposed in the end part region where the adjacent frequency selective reflectors face to each other. When the reflection intensity of the electromagnetic waves in a reflecting structure in which the reflective elements are disposed in the end part region where the adjacent frequency selective reflectors face to each other is regarded as 100%, a reflection intensity of the electromagnetic waves in the reflecting structure in which the reflective elements are not disposed in the end part region where the adjacent frequency selective reflectors face to each other is, for example, preferably over 85%. Thereby, it is possible to inhibit the decrease in the reflection intensity of the electromagnetic waves due to not disposing the reflecting elements in the end part region.

### (5) Other points of frequency selective reflector

The size of the frequency selective reflector in the present embodiment is appropriately selected depending on the factors such as the size of the substrate and applications of the reflecting structure. Above all, in the case of the frequency selective reflector of the first aspect, the size of the frequency selective reflector is, for example, preferably 150 mm square or more, and more preferably 200 mm square or more. For example, in the case of the frequency selective reflector of the first aspect, when processing the frequency selective reflector into a desired size, the reflective elements may be deficient in the end part. In such a case, the ratio of the region where the reflective elements are deficient with respect to the whole frequency selective reflector can be decreased by comparatively increasing the size of the frequency selective reflector as described above, and thereby the influence of the defect of the reflective elements to the reflection properties can be reduced.

In the present embodiment, the reflection properties of a plurality of the frequency selective reflectors may be the same and may be different from one another.

When the reflection properties of a plurality of the frequency selective reflectors differ from one another, the reflection properties of each of the frequency selective reflectors may be, for example, designed so that the electromagnetic waves spread, or designed so that the electromagnetic waves converge. Also, the reflection properties of each of the frequency selective reflectors may be designed so as to convert the spherical wave into the plane wave. Also, the reflection properties of each of the frequency selective reflectors may be designed so as to be the reflecting structure of multi beam.

In the first aspect of the frequency selective reflector, a plurality of reflective elements with different sizes are arranged in the reflecting member, and when the arrangements of the reflective elements in a plurality of the frequency selective reflectors differ from one another, the reflection properties of the plurality of the frequency selective reflectors will be different from one another is arranged.

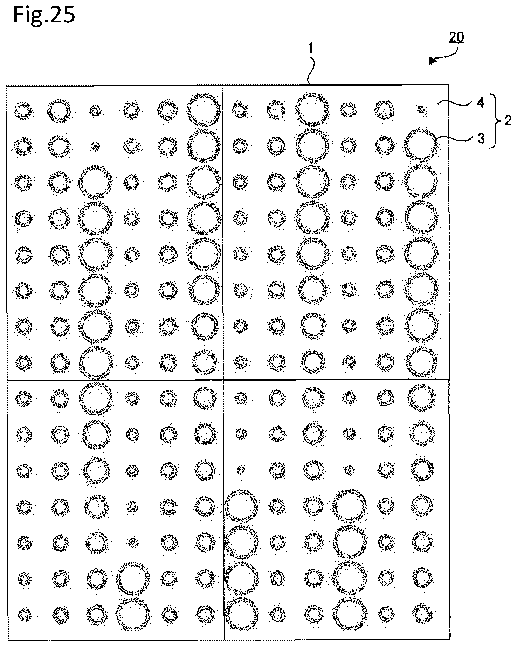

For example, as shown in FIG. 25, the frequency selective reflector 1 includes a reflecting member 2 in which a plurality of ring shaped reflective elements 3 of which outer diameters differ from one another. In four frequency selective reflectors 1, the arrangements of the reflective elements 3 are different from one another. In such a case, the reflection properties of a plurality of the frequency selective reflectors will be different from one another.

Also, in the second aspect of the frequency selective reflector, a plurality of cell regions with different thicknesses is arranged in the dielectric layer, and when the arrangements of the cell regions in a plurality of the frequency selective reflectors differ from one another, the reflection properties of the plurality of the frequency selective reflectors will be different from one another.

When the reflection properties of a plurality of the frequency selective reflectors differ from one another, WO2023/027195 publication can be used as a reference.

The frequency selective reflector in the present embodiment reflects electromagnetic waves in a particular frequency band in a direction different from a regular reflection direction. The frequency band of the electromagnetic waves is preferably a frequency band of microwave or more of which straightness is strong. The frequency band of the electromagnetic waves is, for example, preferably 2.5 GHz or more, more preferably 24 GHz or more, and further preferably 24 GHz or more and 300 GHz or less. If the frequency band of the electromagnetic waves is in the above range, the reflecting structure of the present embodiment can be utilized for the fifth generation mobile communication system, so-called 5G.

The frequency selective reflector of the present embodiment can be used, for example, as a frequency selective reflector for communication, and is suitable as a frequency selective reflector for mobile communication, among others.

### 3. Other configurations

The reflecting structure of the present embodiment may include configurations other than the frequency selective reflector and the substrate as required.

### (1) Adhesive part

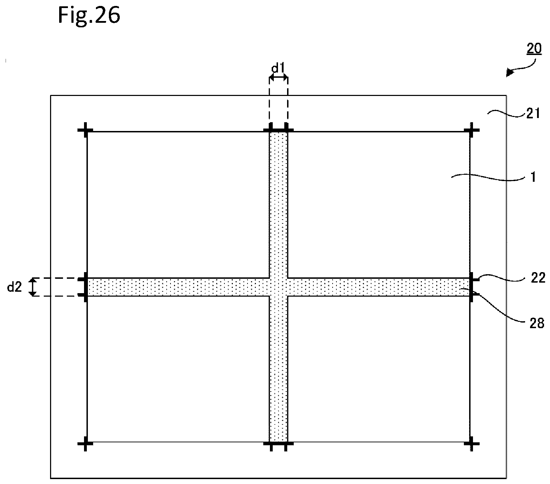

In the reflecting structure of the present embodiment, for example, as shown in FIG. 26, an adhesive part 28 may be disposed between the adjacent frequency selective reflectors 1. The adhesive part reinforces between the adjacent frequency selective reflectors, and the strength as a whole can be improved.

The adhesive part may be, for example, an adhesive agent or a pressure-sensitive adhesive agent, and may be appropriately selected from known adhesive agents and pressure-sensitive adhesive agents. The adhesive agent and the pressure sensitive adhesive agent may be a liquid and may be a sheet.

The thickness of the adhesive part is not particularly limited if the desired adhesive force can be obtained.

### (2) Second adhesive layer

In the reflecting structure of the present embodiment, a second adhesive layer may be disposed between the substrate and the frequency selective reflector. The second adhesive layer is a layer configured to directly or indirectly adhere the frequency selective reflector to the substrate. It should be noted that the second adhesive layer is omitted in FIG. 3 (b) and FIG. 4 (c).

The second adhesive layer may be, for example, an adhesive agent or a pressure-sensitive adhesive agent, and may be appropriately selected from known adhesive agents and pressure-sensitive adhesive agents.

The thickness of the second adhesive layer is not particularly limited if the desired adhesive force can be obtained.

### (3) Fixing member

When the reflecting structure of the present embodiment is used by being attached to a wall or the like, a fixing member having a mechanism for attaching the reflecting structure may be disposed on a surface of the frequency selective reflector that is opposite side to the substrate. In order to inhibit interference between the fixing member and the frequency selective reflector, a metal layer may also be disposed between the fixing member and the frequency selective reflector, and the fixing member may also serve as a metal layer. In addition, when the reflecting structure of the present embodiment is attached to a wall or the like, the fixing member may have a mechanism of making the angle in the normal direction of the frequency selective reflector variable so that the deviation between the designed incident direction and reflection direction of the electromagnetic wave and the actual incident direction and reflection direction of the electromagnetic wave can be corrected.

### (4) Interference mitigating layer

The reflecting structure of the present embodiment may include, on a surface of the substrate that is opposite side to the frequency selective reflector, an interference mitigating layer for mitigating properties change due to mutual operation with a surface where the reflecting structure is installed. The interference mitigating layer is not particularly limited if it has a dielectric constant close to that of air, and if it can secure the appropriate distance with which the mutual operation of the installation surface with the reflecting member decreases, and for example, a foam body such as urethane foam of which dielectric constant is close to that of air, or a plastic cardboard including a lot of air can be used.

Also, when the frequency selective reflector does not include the ground layer, in order to inhibit interference between the substrate and the frequency selective reflector, the interference mitigating layer may be disposed between the substrate and the frequency selective reflector, and the substrate itself may be used as the interference mitigating layer. When the interference mitigating layer is disposed between the substrate and the frequency selective reflector, general countermeasures such as adjusting the shape or the light transmittance or the like of the interference mitigating layer, and disposing an additional alignment mark in the interference mitigating layer can be taken in order not to interfere the first alignment mark of the substrate.

### II. Second embodiment of reflecting structure

The second embodiment of the reflecting structure in the present disclosure is a reflecting structure including a frequency selective reflector reflecting electromagnetic waves in a particular frequency band in a direction different from a regular reflection direction, the reflecting structure including: a substrate including a first alignment mark; and the frequency selective reflector disposed on one surface of the substrate, wherein the frequency selective reflector includes: a reflecting member that is disposed on one surface of the substrate and reflects the electromagnetic waves, and a plurality of dielectric layers that is disposed side by side on the reflecting member side surface of the substrate, and transmits the electromagnetic waves, wherein a distance between adjacent the dielectric layers is less than 1/2 of a wavelength of the electromagnetic waves, the dielectric layer includes a concave and convex structure in which a plurality of unit structures with a thickness distribution of increasing thickness in a predetermined direction is disposed, the unit structures of the dielectric layer include a plurality of cell regions with different thicknesses, in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layer includes, as the unit structure, at least a first unit structure including three or more of the cell regions of which thicknesses differ from one another, and a reflection direction of the electromagnetic waves is controlled by controlling a relative reflection phase distribution of the electromagnetic waves by the thickness distribution of the dielectric layer.

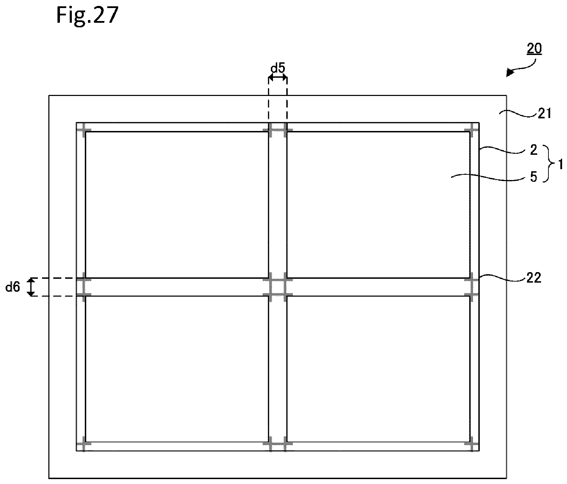

FIG. 27 is a schematic plan view showing an example of the reflecting structure of the present embodiment. As shown in FIG. 27, the reflecting structure 20 is the one that includes a frequency selective reflector 1 reflecting electromagnetic waves in a particular frequency band in a direction different from a regular reflection direction; and includes a substrate 21 including a first alignment mark 22 and the frequency selective reflector 1 disposed on one surface of the substrate 21. The frequency selective reflector 1 includes a reflecting member 2 that is disposed on one surface of the substrate 21 and that reflects the electromagnetic waves, and a plurality of dielectric layers 5 that is disposed side by side on the reflecting member 2 side surface of the substrate 21 and that transmits the electromagnetic waves. The distance d5, d6 between the adjacent dielectric layers 5 is less than 1/2 of a wavelength of the electromagnetic waves in the particular frequency band.

For example, in FIG. 27, the substrate 21 includes a first alignment mark 22 in a cross shape, and the positions of the plurality of the dielectric layers 5 are matched by matching the edges of the dielectric layers 5 on the basis of the first alignment mark 22 of the substrate 21.

Here, as described above, although it is not a reflect array, in a phased array antenna in which a plurality of sub arrays is disposed side by side, in order to align the phases of the electromagnetic waves in each sub arrays and increase the intensity of the electromagnetic waves, the distance between the adjacent sub arrays is usually less than 1/2 of the wavelength of the electromagnetic waves.

For this reason, also in the reflecting structure including the frequency selective reflector in which a plurality of dielectric layers is disposed side by side, for example, in order to inhibit the disturbance of the wave front of the reflected wave by the whole reflecting structure by aligning phases of the reflected waves in each dielectric layers and increasing the intensity of the reflected wave and the like, the distance between the adjacent dielectric layers is considered to be preferably less than 1/2 of the wavelength of the electromagnetic waves.

In the present embodiment, the substrate includes the first alignment mark, and thus the positional matching of the plurality of the dielectric layers can be accurately performed. As a result, the accuracy of the distance between the adjacent dielectric layers can be secured. Thus, it is possible to perform tiling of the plurality of the dielectric layers with high positional accuracy so that the distance between the adjacent dielectric layers becomes less than 1/2 of the wavelength of the electromagnetic waves in the particular frequency band. Therefore, the disturbance of the wavefront of the reflected wave in the whole reflecting structure can be inhibited to obtain the desired reflection properties, and the reflecting structure can have large area.

Hereinafter, each configuration of the reflecting structure in the present embodiment will be described.

### 1. Substrate

The substrate in the present embodiment is a member that supports a frequency selective reflector, and includes a first alignment mark. The substrate is the same as that of the first embodiment described above.

The first alignment mark is a mark for matching the positions of the dielectric layers. The first alignment mark is the same as that of the first embodiment described above.

Also, as described later, when the reflecting member includes a reflective layer and when the reflecting member includes a dielectric substrate and a reflective layer disposed on an entire surface of the dielectric substrate, the dielectric substrate may also work as the substrate, and the dielectric substrate may include the first alignment mark.

Also, as described later, when the reflecting member includes a plurality of reflective elements, and the reflecting member includes a dielectric substrate, and a plurality of reflective elements disposed on at least one surface of the dielectric substrate, the dielectric substrate may also work as the substrate, and the dielectric substrate may include the first alignment mark.

In the present embodiment, the substrate may include a third identification mark for identifying the position of the dielectric layers. When the substrate includes the third identification mark, the positions of each dielectric layers can be easily identified, and thus each dielectric layers can be accurately and easily disposed on the correct positions. In particular, in the frequency selective reflector, it is useful when the reflection properties differ from one another in the plurality of the dielectric layers.

The third identification mark is the same as the first identification mark in the first embodiment described above.

### 2. Frequency selective reflector

The frequency selective reflector in the present embodiment is a member reflecting electromagnetic waves in a particular frequency band in a direction different from a regular reflection direction. Also, the frequency selective reflector in the present embodiment includes a reflecting member that is disposed on one surface of the substrate and that reflects the electromagnetic waves, and a plurality of dielectric layers that is disposed side by side on the reflecting member side surface of the substrate, and that transmits the electromagnetic waves. In the present embodiment, a distance between the adjacent dielectric layers is less than 1/2 of a wavelength of the electromagnetic waves. Also, in the frequency selective reflector in the present embodiment, the dielectric layer includes a concave and convex structure in which a plurality of unit structures with a thickness distribution of increasing thickness in a predetermined direction is disposed, the unit structures of the dielectric layer include a plurality of cell regions with different thicknesses, in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layer includes, as the unit structure, at least a first unit structure including three or more of the cell regions of which thicknesses differ from one another, and a relative reflection phase distribution of the electromagnetic waves is controlled by the thickness distribution of the dielectric layer.

### (1) Distance between adjacent dielectric layers

In the present embodiment, the distance between the adjacent dielectric layers is less than 1/2 of the wavelength of the electromagnetic waves in a particular frequency band, is preferably 1/5 or less thereof, and more preferably 1/10 or less thereof. When the distance between the adjacent dielectric layers is in the above range, the disturbance of the wavefront of the reflected wave in the whole reflecting structure can be inhibited. As described later, the frequency band of the electromagnetic wave is preferably 2.5 GHz or more, and more preferably 24 GHz or more. In other words, the wavelength of the electromagnetic waves in the air is preferably 119.92 mm or less, and more preferably 12.49 mm or less. For this reason, the distance between the adjacent dielectric layers is, in specific, preferably about 59.96 mm or less, and more preferably about 6.245 mm or less. Also, the distance between the adjacent dielectric layers is the shorter the more preferable, and there are no particular limitations on the lower limit value.

### (2) Dielectric layer

The dielectric layer is the same as the dielectric layer of the frequency selective reflector of the second aspect in the reflecting structure of the first embodiment described above.

The dielectric layer may include the light transmittance, and may include the light non-transmittance. Also, the dielectric layer may include the light reflecting properties. The optical properties of the dielectric layer are appropriately selected depending on the factors such as a method for matching the positions of the dielectric layers using the first alignment mark.

In the case the dielectric layer includes the light non-transmittance, for example, the dielectric layer may include the light non-transmittance when the dielectric layer contains a coloring agent or a filler. As the coloring agent and the filler, ones not having conductivity nor magnetic properties may be used.

Also, in the case the dielectric layer includes the light reflecting properties, for example, the dielectric layer may have light scattering properties when the surface of the dielectric layer is roughened, or when the dielectric layer contains fine particles with refraction factor different from that of the resin configuring the dielectric layer. Also, the light reflecting properties may be imparted to a part of the dielectric layers for matching the positions of the dielectric layers. Examples of a part of the dielectric layers may include an outer periphery part of the dielectric layer, and a part near the first alignment mark of the dielectric layer. Examples of the method for imparting the light reflecting properties to a part of the dielectric layers may include a method in which a white pigment ink or a non-conductive metallic ink is printed.

### (3) Reflecting member

The reflecting member is the same as the reflecting member of the frequency selective reflector of the second aspect in the reflecting structure of the first embodiment described above.

When the reflecting member includes the reflective layer, for example, the reflecting member may include, in an order from the substrate side, a dielectric substrate, and a reflective layer disposed on an entire surface of the dielectric substrate, or the reflecting member may include a reflective layer disposed in contact with the substrate. Also, when the reflecting member includes the dielectric substrate and the reflective layer, the dielectric substrate may be a member different from the substrate, or the dielectric substrate may also work as the substrate. In the case the dielectric substrate also works as the substrate, the dielectric substrate may include the first alignment mark. Also, in the case the dielectric substrate also works as the substrate, the substrate may include, in an order from the reflecting member side, a dielectric substrate, and a supporting substrate supporting the frequency selective reflector. In specific, the reflecting member may include a dielectric substrate and a reflective layer, the dielectric substrate may be a member different from the substrate, and a reflecting member including the dielectric substrate and the reflective layer may be disposed on one surface of the substrate. Also, the reflecting member may include a dielectric substrate and a reflective layer, the dielectric substrate may also work as the substrate, the substrate may include a dielectric substrate and a supporting substrate, the dielectric substrate may include the first alignment mark, and a reflective layer may be disposed on the dielectric substrate side surface of the substrate including the supporting substrate and the dielectric substrate. Also, the reflective layer may be disposed in contact with the substrate.

When the reflecting member includes the dielectric substrate and the reflective layer, and when the dielectric substrate is a different member from the substrate, there is an advantage in the degree of freedom in the thickness and the size of the substrate. Also, in this case, the production step is simpler compared to the frequency selective reflector of the second aspect in the reflecting structure of the first embodiment described above.

Also, when the reflecting member includes the dielectric substrate and the reflective layer, the dielectric substrate also works as the substrate, the substrate includes the dielectric substrate and the supporting substrate, the dielectric substrate includes the first alignment mark, and the reflective layer is disposed on the dielectric substrate side surface of the substrate, there is an advantage in the degree of freedom in the thickness and the size of the supporting substrate configuring the substrate. Also, in this case, the production step is simpler compared to the frequency selective reflector of the second aspect in the reflecting structure of the first embodiment described above. Also, in this case, the reflective layer and the first alignment mark can be disposed on one surface of the dielectric substrate, in other words, the reflective layer and the first alignment mark can be disposed on the same plane. For this reason, in this case, the first alignment mark and the reflective layer can be disposed not to overlap each other, and thus the visibility of the first alignment mark can be improved. Also, in this case, the reflective layer and the first alignment mark can be formed at the same time on the dielectric substrate using the same material for the reflective layer and the first alignment mark.

Also, when the reflecting member includes the reflective layer disposed in contact with the substrate, although the degree of freedom of the substrate is reduced, since the dielectric substrate is unnecessary, the production step can be further simpler. Also, in this case, the reflective layer and the first alignment mark can be disposed on one surface of the substrate, in other words, the reflective layer and the first alignment mark can be disposed on the same plane. For this reason, in this case, similarly to above, the first alignment mark and the reflective layer can be disposed not to overlap each other, and thus the visibility of the first alignment mark can be improved. Also, in this case, the reflective layer and the first alignment mark can be formed at the same time using the same material for the reflective layer and the first alignment mark.

Also, when the reflecting member includes the reflective layer, in the region between the adjacent dielectric layers, the reflective layer may or may not be disposed. Note that even when the reflective layer is disposed in the region between the adjacent dielectric layers, since the total area of the region between the adjacent dielectric layers is sufficiently small with respect to the area of the whole frequency selective reflector, it is considered to hardly influence the reflection properties.

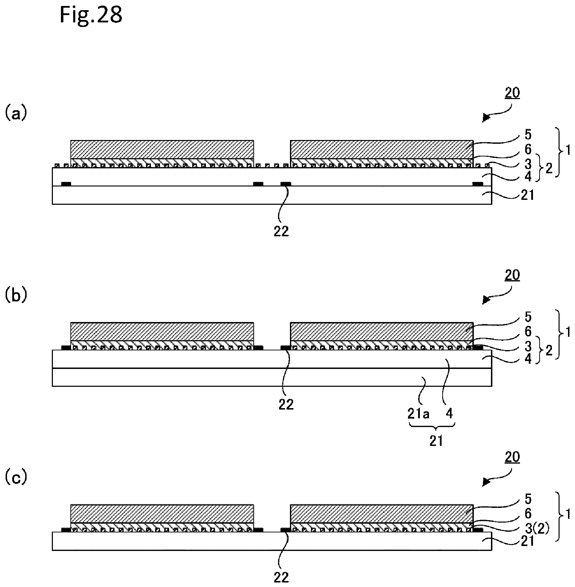

Also, when the reflecting member includes a plurality of the reflective elements, for example, the reflecting member may include the dielectric substrate, and a plurality of the reflective elements disposed on at least one surface of the dielectric substrate, or the reflecting member may include a plurality of the reflective elements disposed in contact with the substrate. Also, when the reflecting member includes the dielectric substrate and a plurality of the reflective elements, the dielectric substrate may be a different member from the substrate, or the dielectric substrate may also work as the substrate. In the case the dielectric substrate also works as the substrate, the dielectric substrate may include the first alignment mark. Also, in the case the dielectric substrate also works as the substrate, the substrate may include, in an order from the reflecting member side, a dielectric substrate, and a supporting substrate supporting the frequency selective reflector. For example, as shown in FIG. 28 (a), the reflecting member 2 may include a dielectric substrate 4 and a plurality of reflecting elements 3, the dielectric substrate 4 and the substrate 21 may be different members, and the reflecting member 2 including a dielectric substrate 4 and a plurality of reflective elements 3 may be disposed on one surface of the substrate 21. Also, for example, as shown in FIG. 28 (b), the reflecting member 2 may include the dielectric substrate 4 and a plurality of the reflective elements 3, the dielectric substrate 4 may also work as the substrate 21, the substrate 21 may include the dielectric substrate 4 and the supporting substrate 21a, the dielectric substrate 4 may include the first alignment mark 22, and the plurality of the reflective elements 3 may be disposed on the dielectric substrate 4 side surface of the substrate 21 including the supporting substrate 21a and the dielectric substrate 4. Also, as shown in FIG. 28 (c), a plurality of the reflective elements 3 may be disposed in contact with the substrate 21.

When the reflecting member includes the dielectric substrate and a plurality of the reflective elements, and when the dielectric substrate is a different member from the substrate, there is an advantage in the degree of freedom in the thickness and the size of the substrate. Also, in this case, the production step is simpler compared to the frequency selective reflector of the second aspect in the reflecting structure of the first embodiment described above.

Also, when the reflecting member includes the dielectric substrate and a plurality of the reflective elements, the dielectric substrate also works as a substrate, the substrate includes the dielectric substrate and the supporting substrate, the dielectric substrate includes the first alignment mark, and the plurality of the reflective elements are disposed on the dielectric substrate side surface of the substrate, there is an advantage in the degree of freedom in the thickness and the size of the supporting substrate configuring the substrate. Also, in this case, the production step is simpler compared to the frequency selective reflector of the second aspect in the reflecting structure of the first embodiment described above. Also, in this case, for example, as shown in FIG. 28 (b), a plurality of the reflective elements 3 and the first alignment mark 22 can be disposed on one surface of the dielectric substrate 4, in other words, a plurality of the reflective elements 3 and the first alignment mark 22 can be disposed in the same plane. For this reason, in this case, the first alignment mark and the plurality of the reflective elements can be disposed not to overlap each other, and thus the visibility of the first alignment mark can be improved. Also, in this case, the plurality of the reflective elements and the first alignment mark can be formed at the same time on the dielectric substrate using the same material for the plurality of the reflective elements and the first alignment mark.

Also, when the reflecting member includes a plurality of the reflective elements disposed in contact with the substrate, although the degree of freedom of the substrate decreases, since the dielectric substrate is unnecessary, the production step can be further simpler. Also, in this case, for example, as shown in FIG. 28 (c), the plurality of the reflective elements 3 and the first alignment mark 22 can be disposed on one surface of the substrate 21, in other words, the plurality of the reflective elements 3 and the first alignment mark 22 can be disposed in the same plane. For this reason, in this case, similarly to the above, the first alignment mark and the plurality of the reflective elements can be disposed not to overlap each other, and thus the visibility of the first alignment mark can be improved. Also, in this case, the plurality of the reflective elements and the first alignment mark can be formed at the same time on the substrate using the same material for the plurality of the reflective elements and the first alignment mark.

Also, when the reflecting member includes a plurality of the reflective elements, the reflective elements may or may not be disposed in the region between the adjacent dielectric layers. Note that even when the reflective elements are disposed in the region between the adjacent dielectric layers, since the total area of the region between the adjacent dielectric layers is sufficiently small with respect to the area of the whole frequency selective reflector, it is considered to hardly influence the reflection properties.

### (4) Control of reflection direction of electromagnetic waves

In the frequency selective reflector in the present embodiment, the control of the reflection direction of electromagnetic waves is the same as that of the frequency selective reflector of the second aspect in the reflecting structure of the first embodiment described above.

### (5) Other configurations

The frequency selective reflector in the present embodiment may include other configurations as required in addition to the reflecting member and the dielectric layer described above. Examples of the other configurations may include an adhesive layer, a space, a protective member, a ground layer, a planarizing layer, and an anti-reflective layer. The other configurations are the same as those of the frequency selective reflector of the second aspect in the reflecting structure in the first embodiment described above.

In the frequency selective reflector in the present embodiment, a second adhesive part may be disposed between the adjacent dielectric layers. In other words, the frequency selective reflector may include, between the adjacent dielectric layers, a second adhesive part similar to the adhesive part 28 shown in FIG. 26 in the first embodiment above. The second adhesive part reinforces between the adjacent dielectric layers, and the strength as a whole can be improved.

The second adhesive part is the same as the adhesive part in the reflecting structure of the first embodiment described above.

### (6) Positional matching of dielectric layers

In the present embodiment, the positions of the plurality of the dielectric layers can be matched using the first alignment mark of the substrate. For example, the positions of the edges of the dielectric layers may be matched on the basis of the first alignment mark of the substrate, and thereby the positions of the dielectric layers may be matched. Also, for example, the dielectric layer may include a third alignment mark, and the positions of the dielectric layers may be matched by matching the positions of the third alignment mark of the dielectric layer on the basis of the first alignment mark of the substrate.

For example, in FIG. 27, the substrate 21 includes the first alignment mark 22 in a cross shape, and the positions of the dielectric layers 5 are matched by matching the positions of the edges of the dielectric layers 5 on the basis of the first alignment mark 22 of the substrate 21. In specific, when the dielectric layer includes the light non-transmittance, the substrate includes the light transmittance, and the first alignment mark includes the light non-transmittance, the first alignment mark of the substrate and the edges of the dielectric layers are detected by the transmitted light, and thereby the positions of the dielectric layers can be matched. Also, when the dielectric layer includes the light reflecting properties, and the first alignment mark includes the light reflecting properties, the first alignment mark of the substrate and the edges of the dielectric layers are detected by the reflected light, and thereby the positions of the dielectric layers can be matched.

Also, for example, when the substrate includes a first alignment mark in a circle shape, and the dielectric layer includes a third alignment mark in a hollow circle shape, the positions of the dielectric layers can be matched by matching the position of the third alignment mark of the dielectric layer on the basis of the first alignment mark of the substrate.

Also, for example, when the substrate includes a first alignment mark in a cross shape and the dielectric layer includes a third alignment mark that is a penetration hole in a square shape, the positions of the dielectric layers can be matched by matching the position of the third alignment mark of the dielectric layer on the basis of the first alignment mark of the substrate.

The specific examples of the positional matching of the dielectric layers are the same as the positional matching of the frequency selective reflectors in the reflecting structure in the first embodiment described above.

### (a) Third alignment mark

In the present embodiment, the dielectric layer may include a third alignment mark. The third alignment mark is a mark for performing the positional matching of the dielectric layers.

The third alignment mark is the same as the second alignment mark of the reflecting structure of the first embodiment described above.

### (b) Fourth identification mark

In the present embodiment, the dielectric layer may include a fourth identification mark for identifying the dielectric layer. When the dielectric layer includes the fourth identification mark, each dielectric layers can be easily identified, and up and down, left and right, and front and back of the dielectric layer can be easily identified, and thus each dielectric layers can be accurately and easily disposed in the correct position. In particular, in the frequency selective reflector, it is useful when the reflection properties differ from one another in the plurality of the dielectric layers.

The fourth identification mark is the same as the second identification mark of the reflecting structure of the first embodiment described above.

### (c) Concave and convex part

In the present embodiment, the adjacent dielectric layers may include a concave and convex part capable of fitting each other on side surfaces facing to each other, and the adjacent dielectric layers may be disposed so that the concave and convex part fits each other. In other words, the adjacent dielectric layers may include, on side surfaces facing to each other, a concave and convex part similar to the concave and convex part 26 shown in FIG. 21 and FIG. 22 in the first embodiment described above. Fitting of the concave and convex part may facilitate the positional matching of a plurality of the dielectric layers. Also, since the contact area of the adjacent dielectric layers increases, the strength can be improved.

The concave and convex part is the same as the concave and convex part of the reflecting structure of the first embodiment described above.

### (7) Other points of frequency selective reflector

In the present embodiment, the size of the dielectric layer is appropriately selected depending on the factors such as the size of the substrate and the applications of the reflecting structure. The size of the dielectric layer is, for example, preferably 150 mm square or more, and more preferably 200 mm square or more.

In the present embodiment, the reflection properties in a plurality of the dielectric layers may be the same or different from one another.

When the reflecting properties in a plurality of the dielectric layers differ from one another, the reflection properties in each of the dielectric layers may be, for example, designed so that the electromagnetic waves spread, or designed so that the electromagnetic waves converge. Also, the reflection properties in each of the dielectric layers may be designed so as to convert the spherical wave into the plane wave. Also, the reflection properties in each of the dielectric layers may be designed to be a reflecting structure of multi beam.

In the dielectric layer, a plurality of cell regions with different thicknesses is arranged, and when the arrangements of the cell regions in a plurality of the dielectric layers differ from one another, the reflection properties in the plurality of the dielectric layers will be different from one another.

WO2023/027195 publication can be referred to for the case where the reflection properties in a plurality of dielectric layers are different from one another.

The frequency selective reflector in the present embodiment reflects electromagnetic waves in a particular frequency band in a direction different from a regular reflection direction. The frequency band of the electromagnetic waves is the same as that in the first embodiment described above.

The frequency selective reflector in the present embodiment can be used, for example, as a frequency selective reflector for communication, and is suitable as a frequency selective reflector for mobile communication, among others.

### 3. Other configurations

The reflecting structure of the present embodiment may include configurations other than the frequency selective reflector and the substrate as required. Examples of the other configurations may include a second adhesive layer, a fixing member, and an interference mitigating layer. These configurations are the same as those of the first embodiment described above.

### III. Third embodiment of reflecting structure

The third embodiment of the reflecting structure in the present disclosure is a reflecting structure including a frequency selective reflector reflecting electromagnetic waves in a particular frequency band in a direction different from a regular reflection direction, the reflecting structure including: a substrate; and a plurality of the frequency selective reflectors disposed side by side on one surface of the substrate, wherein two adjacent sides in at least one of the frequency selective reflectors are aligned with two adjacent sides in the substrate; and a distance between adjacent the frequency selective reflectors is less than 1/2 of a wavelength of the electromagnetic waves.

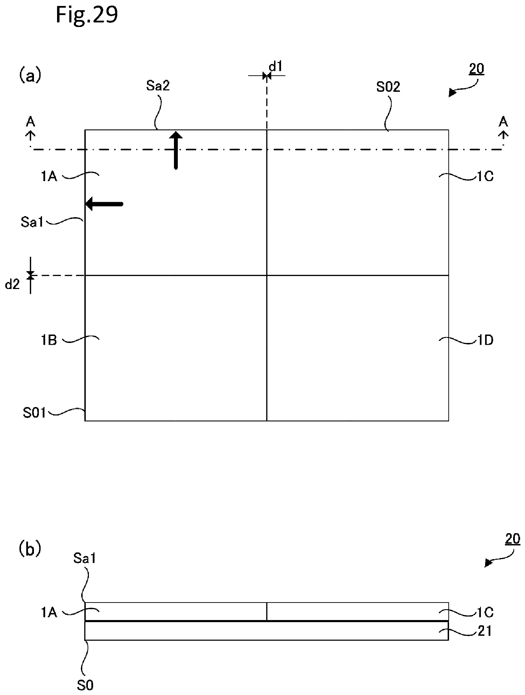

FIG. 29 (a) is a schematic plan view showing an example of the reflecting structure of the present embodiment, and FIG. 29 (b) is a cross-sectional view of A-A line in FIG. 29 (a). As shown in FIG. 29 (a), (b), the reflecting structure 20 is the one including frequency selective reflectors 1A to 1D reflecting electromagnetic waves in a particular frequency band in a direction different from a regular reflection direction, and including a substrate 21, and a plurality of frequency selective reflectors 1A to 1D disposed side by side on one surface of the substrate 21. The distance d1, d2 between the adjacent frequency selective reflectors 1A to 1D is less than 1/2 of a wavelength of the electromagnetic waves in a particular frequency band.

For example, in FIG. 29 (a), (b), two adjacent sides Sa1, Sa2 in the frequency selective reflector 1A are aligned with two adjacent sides S01, S02 in the substrate 21. Thus, for the frequency selective reflector 1A, the position of the frequency selective reflector 1A is matched by matching the positions of the two adjacent sides Sa1, Sa2 of the frequency selective reflector 1A on the basis of the two adjacent sides S01, S02 of the substrate 21.

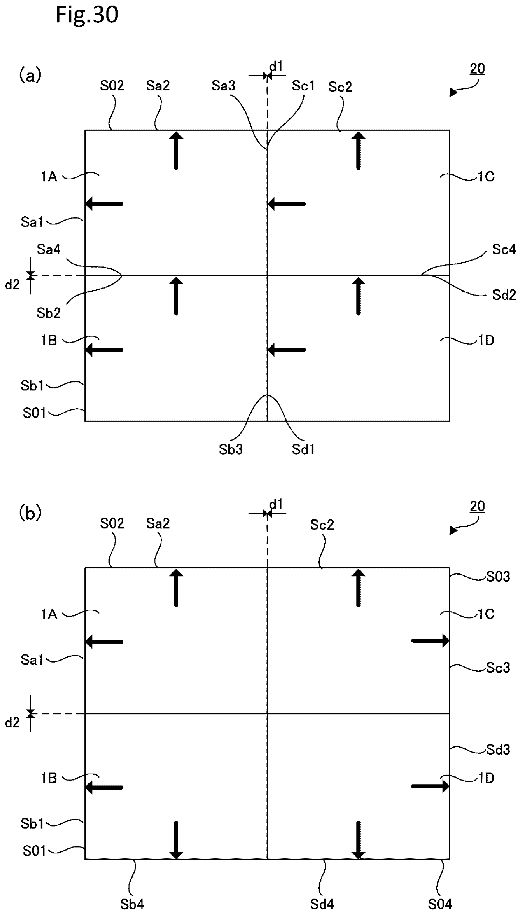

For the frequency selective reflectors 1B to 1D, for example, as shown in FIG. 30 (a), the positions of the frequency selective reflectors 1B to 1D may be matched by butting the edge of the frequency selective reflector against the edge of the adjacent frequency selective reflector, as well as on the basis of the side of the substrate. For example, for the frequency selective reflector 1B, the position of the frequency selective reflector 1B is matched by matching the position of one side Sb1 of the frequency selective reflector 1B on the basis of one side S01 of the substrate 21, and by butting the edge of the frequency selective reflector 1B against the edge of the frequency selective reflector 1A adjacent to the frequency selective reflector 1B. In this case, among the two adjacent sides Sb1, Sb2 of the frequency selective reflector 1B, the side Sb1 of the frequency selective reflector 1B is aligned with the side S01 of the substrate 21, and the side Sb2 of the frequency selective reflector 1B contacts the side Sa4 of the frequency selective reflector 1A. For the frequency selective reflector 1C, the position of the frequency selective reflector 1C is matched by matching the position of one side Sc2 of the frequency selective reflector 1C on the basis of one side S02 of the substrate 21, and by butting the edge of the frequency selective reflector 1C against the edge of the frequency selective reflector 1A adjacent to the frequency selective reflector 1C. In this case, among the two adjacent sides Sc1, Sc2 of the frequency selective reflector 1C, the side Sc2 of the frequency selective reflector 1C is aligned with the side S02 of the substrate 21, and the side Sc1 of the frequency selective reflector 1C contacts the side Sa3 of the frequency selective reflector 1A. For the frequency selective reflector 1D, the position of the frequency selective reflector 1D is matched by butting the edge of the frequency selective reflector 1D against the edges of the frequency selective reflectors 1B, 1C adjacent to the frequency selective reflector 1D. In this case, among the two adjacent sides Sd1, Sd2 of the frequency selective reflector 1D, the side Sd2 of the frequency selective reflector 1D contacts the side Sc4 of the frequency selective reflector 1C, and the side Sd1 of the frequency selective reflector 1D contacts the side Sb3 of the frequency selective reflector 1B.

Also, for the frequency selective reflectors 1B to 1D, for example, as shown in FIG. 30 (b), the positions of the frequency selective reflectors 1B to 1D may be matched on the basis of the side of the substrate. For example, for the frequency selective reflector 1B, the position of the frequency selective reflector 1B is matched by matching the positions of the two adjacent sides Sb1, Sb4 of the frequency selective reflector 1B on the basis of the two adjacent sides S01, S04 of the substrate 21. In this case, the two adjacent sides Sb1, Sb4 of the frequency selective reflector 1B are aligned with the two adjacent sides S01, S04 of the substrate 21. For the frequency selective reflector 1C, the position of the frequency selective reflector 1C is matched by matching the positions of the two adjacent sides Sc2, Sc3 of the frequency selective reflector 1C on the basis of the two adjacent sides S02, S03 of the substrate 21. In this case, the two adjacent sides Sc2, Sc3 of the frequency selective reflector 1C are aligned with the two adjacent sides S02, S03 of the substrate 21. For the frequency selective reflector 1D, the position of the frequency selective reflector 1D is matched by matching the positions of the two adjacent sides Sd3, Sd4 of the frequency selective reflector 1D on the basis of the two adjacent sides S03, S04 of the substrate 21. In this case, the two adjacent sides Sd3, Sd4 of the frequency selective reflector 1D are aligned with the two adjacent sides S03, S04 of the substrate 21.

Also, for the frequency selective reflectors 1B to 1D, although not illustrated, each of the frequency selective reflectors 1A to 1D may include a second alignment mark, and the positions of the frequency selective reflectors 1B, 1C may be matched by matching the positions of the second alignment marks of the frequency selective reflectors 1B, 1C adjacent to the frequency selective reflector 1A on the basis of the second alignment mark of the frequency selective reflector 1A, and the position of the frequency selective reflector 1D may be matched by matching the position of the second alignment mark of the frequency selective reflector 1D adjacent to the frequency selective reflectors 1B, 1C on the basis of the second alignment marks of the frequency selective reflectors 1B, 1C.

Also, for the frequency selective reflectors 1B to 1D, the positional matching by the second alignment mark of the frequency selective reflector and the butting of the edge of the frequency selective reflector may be used in combination. For example, the positions of the frequency selective reflectors 1B, 1C can be matched by using the second alignment marks of the frequency selective reflectors 1A to 1C with respect to the frequency selective reflector 1A, and the position of the frequency selective reflector 1D can be matched by butting the edge of the frequency selective reflector 1D against the edges of the frequency selective reflectors 1B, 1C.

In the reflecting structure of the present embodiment also, similarly to the first embodiment of the reflecting structure described above, in order to inhibit the disturbance of the wavefront of the reflected wave in the whole reflecting structure by, for example, aligning the phase of the reflected wave in each of the frequency selective reflectors and increasing the intensity of the reflected wave, it is considered that the distance between the adjacent frequency selective reflectors is desired to be less than 1/2 of the wavelength of the electromagnetic waves.

In the present embodiment, two adjacent sides in at least one of the frequency selective reflectors are aligned with two adjacent sides in the substrate, and thus the positions of a plurality of the frequency selective reflectors can be accurately matched. Thus, the accuracy of the distance between the adjacent frequency selective reflectors can be secured. For this reason, it is possible to perform tiling of a plurality of frequency selective reflectors with high positional accuracy so as to set the distance between the adjacent frequency selective reflectors to less than 1/2 of the wavelength of the electromagnetic waves in the particular frequency band. Therefore, the disturbance of the wavefront of the reflected wave in the whole reflecting structure can be inhibited to obtain the desired reflection properties, and the reflecting structure can have large area.

Hereinafter, each configuration of the reflecting structure of the present embodiment will be described.

### 1. Substrate

The substrate in the present embodiment is a member that supports the frequency selective reflector. The substrate is the same as the substrate in the first embodiment described above except that the substrate does not include the first alignment mark.

In the present embodiment, the shape of the substrate is not limited to the rectangle shape, and it may be a polygon such as triangle and pentagon. Also, the shape of the substrate may be a shape including an edge part that can be a basis. If there is an edge part that can be a basis such as in a drop shape, a crescent shape, and a shape in which a part of a circle is cut out, profile line extending to both sides from that edge part can be regarded as the two adjacent sides of the substrate.

In the present embodiment, the size of the substrate is preferably about the same as the total size of all the frequency selective reflectors disposed side by side. The size of the substrate being about the same as the total size of all the frequency selective reflectors disposed side by side means that the size difference of inner and outer direction when the profile line of the substrate is overlapped with the profile line of the outer shape of all the frequency selective reflectors disposed side by side is less than 1/2 of the wavelength of the electromagnetic waves in a particular frequency band. The size difference is preferably 1/5 or less, and more preferably 1/10 or less. Note that the profile line of the substrate and the profile line of the outer shape of all the frequency selective reflectors disposed side by side are preferably in a similar shape, but for example, in design terms, there is no particular problem in the point of disposing the frequency selective reflector even when the profile line of the substrate is a shape locally protruding to outside.

### 2. Frequency selective reflector

The frequency selective reflector in the present embodiment is a member reflecting electromagnetic waves in a particular frequency band in a direction different from a regular reflection direction.

The distance between the adjacent frequency selective reflectors is the same as that of the first embodiment described above.

The embodiment of the frequency selective reflector is the same as that of the first embodiment described above.

In the present embodiment, the position of at least one frequency selective reflector can be matched by matching the two adjacent sides of at least one frequency selective reflector on the basis of the two adjacent sides of the substrate. After the positional matching of at least one frequency selective reflector, for the other frequency selective reflectors, for example, the positions of the other frequency selective reflectors may be matched by butting the edge of the frequency selective reflector against the edge of the adjacent frequency selective reflector as well as on the basis of the side of the substrate. Also, for the other frequency selective reflectors, each of the frequency selective reflectors may include a second alignment mark, and the relative position of each of the frequency selective reflectors may be matched by using the second alignment mark. Also, for the other frequency selective reflectors, the positional matching of the frequency selective reflectors by the second alignment mark and the butting of the edge of the frequency selective reflector may be used in combination. Also, for all the frequency selective reflectors, the positions of all the frequency selective reflectors may be matched by matching the position of the adjacent two sides of the frequency selective reflector on the basis of the two adjacent sides of the substrate.

Specific examples of the positional matching of the frequency selective reflectors are as described above.

Also, on the occasion of matching the position of the frequency selective reflector, in the case of butting the edge of the frequency selective reflector against the edge of the adjacent frequency selective reflector, the edge of the frequency selective reflector may be butted against the edge of the adjacent frequency selective reflector through a spacer.

In the present embodiment, the frequency selective reflector may include a second alignment mark. The second alignment mark is a mark for performing the positional matching of the frequency selective reflectors, and is a mark for matching the relative positions of each of the frequency selective reflectors.

The second alignment mark is the same as that of the first embodiment described above. The second alignment mark is preferably disposed in the outer periphery region of the frequency selective reflector. In the case of butting the edge of the frequency selective reflector against the edge of the adjacent frequency selective reflector, the deviation of the direction parallel to the edge of the frequency selective reflector will be easily adjusted.

In the present embodiment, the frequency selective reflectors may include a second identification mark for identifying the frequency selective reflectors. The second identification mark is the same as that of the first embodiment described above.

In the present embodiment, the adjacent frequency selective reflectors may include a concave and convex part capable of fitting each other on side surfaces facing to each other, and the adjacent frequency selective reflectors may be disposed so that the concave and convex part fits each other. By fitting the concave and convex part, the positional matching of a plurality of the frequency selective reflectors can be easily performed. In this case, the concave and convex part substantially works as the second alignment mark. The concave and convex part is the same as the concave and convex part of the reflecting structure of the first embodiment described above.

The size of the frequency selective reflector is the same as that of the first embodiment described above.

In the present embodiment, as described above, the substrate does not include a first alignment mark, but the position of at least one frequency selective reflector is matched by matching the position of the adjacent two sides of at least one frequency selective reflector on the basis of the adjacent two sides of the substrate. Thus, unevenness of the sizes of the outer shapes of the frequency selective reflectors is preferably less than 1/2 of the wavelength of the electromagnetic waves in a particular frequency band, more preferably 1/5 or less thereof, and further preferably 1/10 or less thereof. For example, it varies depending on the kinds of materials and machines or the likes, but the unevenness of the sizes of the cutting process is generally about ± 1 mm. For this reason, the unevenness of the sizes of the outer shapes of the frequency selective reflectors can satisfy less than 1/2 of the wavelength of the electromagnetic waves in a particular frequency band.

In the present embodiment, the reflection properties of a plurality of the frequency selective reflectors may be the same and may be different from one another. The configurations when the reflection properties of a plurality of the frequency selective reflectors differ from one another are the same as those of the first embodiment described above.

The frequency selective reflector in the present embodiment reflects electromagnetic waves in a particular frequency band in a direction different from a regular reflection direction. The frequency band of the electromagnetic waves is the same as in the first embodiment described above. As described above, since the unevenness of the sizes of the outer shapes of the frequency selective reflectors is preferably less than 1/2 of the wavelength of the electromagnetic waves in a particular frequency band, the longer the wavelength of the electromagnetic waves, that is, the shorter the frequency band of the electromagnetic waves, the larger the unevenness of the sizes of the outer shapes is allowed. For this reason, the frequency band of the electromagnetic waves is preferably low in the specified range. In specific, the frequency band of the electromagnetic waves is, preferably 2.5 GHz or more and 149.9 GHz or less, more preferably 2.5 GHz or more and 60.0 GHz or less, and further preferably 2.5 GHz or more and 30.0 GHz or less.

The frequency selective reflector in the present embodiment can be used, for example, as a frequency selective reflector for communication, and is suitable as a frequency selective reflector for mobile communication, among others.

### 3. Other configurations

The reflecting structure of the present embodiment may include configurations other than the frequency selective reflector and the substrate as required. Examples of the other configurations may include an adhesive part, a second adhesive layer, a fixing member, and an interference mitigating layer. These configurations are the same as those of the first embodiment described above.

### IV. Fourth embodiment of reflecting structure

The fourth embodiment of the reflecting structure in the present disclosure is a reflecting structure including a frequency selective reflector reflecting electromagnetic waves in a particular frequency band in a direction different from a regular reflection direction, the reflecting structure including: a substrate; and the frequency selective reflector disposed on one surface of the substrate, wherein the frequency selective reflector includes: a reflecting member that is disposed on one surface of the substrate, and reflects the electromagnetic waves, and a plurality of dielectric layers that is disposed side by side on the reflecting member side surface of the substrate, and transmits the electromagnetic waves, wherein two adjacent sides in at least one of the dielectric layers are aligned with two adjacent sides in the substrate, a distance between adjacent the dielectric layers is less than 1/2 of a wavelength of the electromagnetic waves, the dielectric layers include a concave and convex structure in which a plurality of unit structures with a thickness distribution of increasing thickness in a predetermined direction is disposed, the unit structures of the dielectric layers include a plurality of cell regions with different thicknesses, in each of the unit structures of the dielectric layers, in a graph setting a horizontal axis as a length of the predetermined direction of the unit structures, and setting a vertical axis as a relative reflection phase when the electromagnetic waves are transmitted through the dielectric layers, reflected by the reflecting member and emitted to an incident side of the electromagnetic waves by being transmitted through the dielectric layers again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line, the dielectric layers include, as the unit structure, at least a first unit structure including three or more of the cell regions of which thicknesses differ from one another, and a reflection direction of the electromagnetic waves is controlled by controlling a relative reflection phase distribution of the electromagnetic waves by the thickness distribution of the dielectric layers.

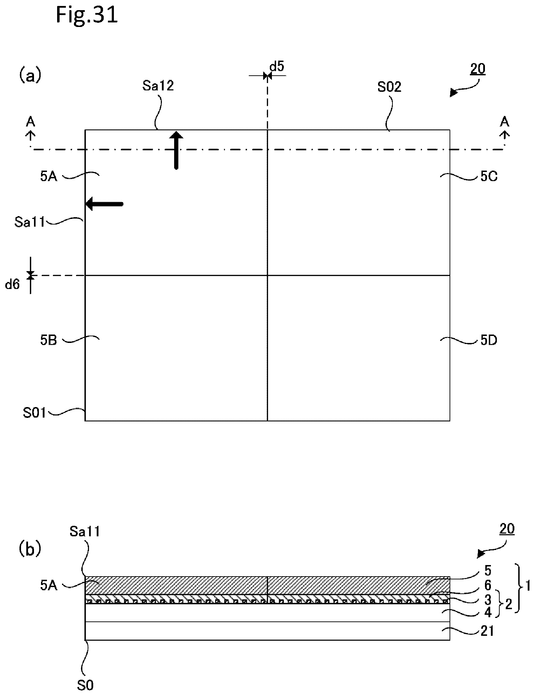

FIG. 31 (a) is a schematic plan view showing an example of the reflecting structure of the present embodiment, and FIG. 31 (b) is a cross-sectional view of A-A line in FIG. 31 (a). As shown in FIG. 31 (a), (b), the reflecting structure 20 is the one including a frequency selective reflector 1 reflecting electromagnetic waves in a particular frequency band in a direction different from a regular reflection direction, and including a substrate 21, and the frequency selective reflector 1 disposed on one surface of the substrate 21. The frequency selective reflector 1 includes a reflecting member 2 that is disposed on one surface of the substrate 21, and reflects electromagnetic waves, and a plurality of dielectric layers 5A to 5D that is disposed side by side on the reflecting member 2 side surface of the substrate 21, and that transmits the electromagnetic waves. The distance d5, d6 between the adjacent dielectric layers 5A to 5D is less than 1/2 of a wavelength of the electromagnetic waves in a particular frequency band.

For example, in FIG. 31 (a), (b), the two adjacent sides Sa11, Sa12 in the dielectric layer 5A are aligned with the two adjacent sides S01, S02 in the substrate 21. For this reason, for the dielectric layer 5A, the position of the dielectric layer 5A is matched by matching the positions of the two adjacent sides Sa11, Sa12 of the dielectric layer 5A on the basis of the two adjacent sides S01, S02 of the substrate 21.

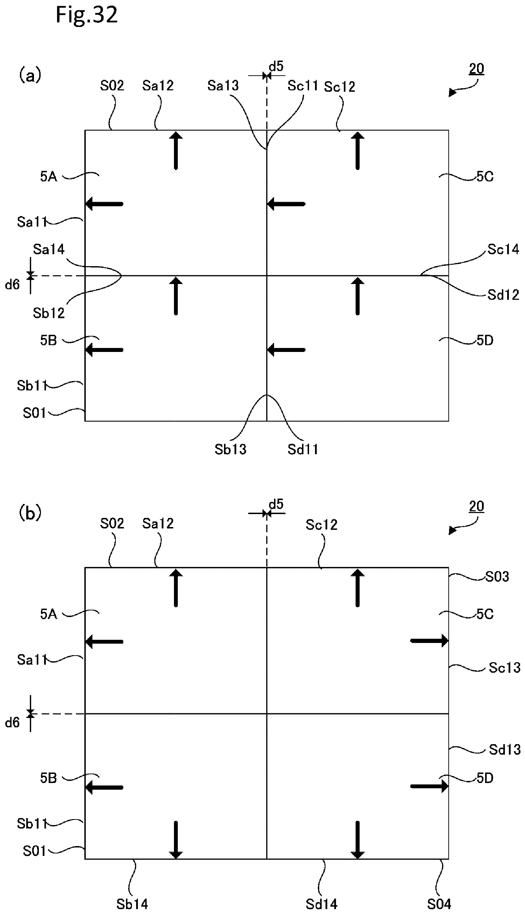

For the dielectric layers 5B to 5D, for example, as shown in FIG. 32 (a), the positions of the dielectric layers 5B to 5D may be matched by butting the edge of the dielectric layer against the edge of the adjacent dielectric layer as well as on the basis of the side of the substrate. For example, for the dielectric layer 5B, the position of the dielectric layer 5B is matched by matching the position of one side Sb11 of the dielectric layer 5B on the basis of one side S01 of the substrate 21, and by butting the edge of the dielectric layer 5B against the edge of the dielectric layer 5A adjacent to the dielectric layer 5B. In this case, among the two adjacent sides Sb11, Sb12 of the dielectric layer 5B, the side Sb11 of the dielectric layer 5B is aligned with the side S01 of the substrate 21, and the side Sb12 of the dielectric layer 5B contacts the side Sa14 of the dielectric layer 5A. For the dielectric layer 5C, the position of the dielectric layer 5C is matched by matching the position of one side Sc12 of the dielectric layer 5C on the basis of one side S02 of the substrate 21, and by butting the edge of the dielectric layer 5C against the edge of the dielectric layer 5A adjacent to the dielectric layer 5C. In this case, among the two adjacent sides Sc11, Sc12 of the dielectric layer 5C, the side Sc12 of the dielectric layer 5C is aligned with the side S02 of the substrate 21, and the side Sc11 of the dielectric layer 5C contacts the side Sa13 of the dielectric layer 5A. For the dielectric layer 5D, the position of the dielectric layer 5D is matched by butting the edge of the dielectric layer 5D against the edges of the dielectric layers 5B, 5C adjacent to the dielectric layer 5D. In this case, among the two adjacent sides Sd11, Sd12 of the dielectric layer 5D, the side Sd12 of the dielectric layer 5D contacts the side Sc14 of the dielectric layer 5C, and the side Sd11 of the dielectric layer 5D contacts the side Sb13 of the dielectric layer 5B.

Also, for the dielectric layers 5B to 5D, for example, as shown in FIG. 32 (b), the positions of the dielectric layers 5B to 5D may be matched on the basis of the sides of the substrate. For example, for the dielectric layer 5B, the position of the dielectric layer 5B is matched by matching the positions of the two adjacent sides Sb11, Sb14 of the dielectric layer 5B on the basis of the two adjacent sides S01, S04 of the substrate 21. In this case, the two adjacent sides Sb11, Sb14 of the dielectric layer 5B are aligned with the two adjacent sides S01, S04 of the substrate 21. For the dielectric layer 5C, the position of the dielectric layer 5C is matched by matching the positions of the two adjacent sides Sc12, Sc13 of the dielectric layer 5C on the basis of the two adjacent sides S02, S03 of the substrate 21. In this case, the two adjacent sides Sc12, Sc13 of the dielectric layer 5C are aligned with the two adjacent sides S02, S03 of the substrate 21. For the dielectric layer 5D, the position of the dielectric layer 5D is matched by matching the positions of the two adjacent sides Sd13, Sd14 of the dielectric layer 5D on the basis of the two adjacent sides S03, S04 of the substrate 21. In this case, the two adjacent sides Sd13, Sd14 of the dielectric layer 5D are aligned with the two adjacent sides S03, S04 of the substrate 21.

Also, for the dielectric layers 5B to 5D, although not illustrated, each of the dielectric layers 5A to 5D may include a third alignment mark, and the positions of the dielectric layers 5B, 5C may be matched by matching the positions of the third alignment marks of the dielectric layers 5B, 5C adjacent to the dielectric layer 5A on the basis of the third alignment mark of the dielectric layer 5A, and the position of the dielectric layer 5D may be matched by matching the position of the third alignment mark of the dielectric layer 5D adjacent to the dielectric layers 5B, 5C on the basis of the third alignment marks of the dielectric layers 5B, 5C.

Also, for the dielectric layers 5B to 5D, the positional matching by the third alignment marks of the dielectric layers and the positional matching by butting the edges of the dielectric layers may be used in combination. For example, the positions of the dielectric layers 5B, 5C may be matched by using the third alignment marks of the dielectric layers 5A to 5C with respect to the dielectric layer 5A, and the position of the dielectric layer 5D may be matched by butting the edge of the dielectric layer 5D against the edges of the dielectric layers 5B, 1C.

In the reflecting structure of the present embodiment also, similarly to the second embodiment of the reflecting structure described above, in order to inhibit the disturbance of the wavefront of the reflected wave in the whole reflecting structure by, for example, aligning the phase of the reflected wave in each of the dielectric layers and increasing the intensity of the reflected wave, it is considered that the distance between the adjacent dielectric layers is desired to be less than 1/2 of the wavelength of the electromagnetic waves.

In the present embodiment, the two adjacent sides in at least one dielectric layer are aligned with the two adjacent sides in the substrate, and thus the positions of a plurality of the dielectric layers can be accurately matched. As a result, the accuracy of the distance between the adjacent dielectric layers can be secured. Thus, tiling of a plurality of the dielectric layers is possible with high positional accuracy, so that the distance between the adjacent dielectric layers becomes less than 1/2 of the wavelength of the electromagnetic waves in a particular frequency band. Therefore, the disturbance of the wavefront of the reflected wave in the whole reflecting structure can be inhibited to obtain the desired reflection properties, and the reflecting structure can have large area.

Hereinafter, each configuration of the reflecting structure of the present embodiment will be described.

### 1. Substrate

The substrate in the present embodiment is a member that supports the frequency selective reflector. The substrate is the same as the substrate of the third embodiment described above.

In the present embodiment, the size of the substrate is preferably about the same as the total size of all the dielectric layers disposed side by side. The size of the substrate being about the same as the total size of all the dielectric layers disposed side by side means that the size difference of inner and outer direction when the profile line of the substrate is overlapped with the profile line of the outer shape of all the dielectric layers disposed side by side is less than 1/2 of the wavelength of the electromagnetic waves in a particular frequency band. The size difference is preferably 1/5 or less, and more preferably 1/10 or less.

### 2. Frequency selective reflector

The frequency selective reflector in the present embodiment is a member reflecting electromagnetic waves in a particular frequency band in a direction different from a regular reflection direction.

The distance between the adjacent dielectric layers is the same as that of the second embodiment described above.

The dielectric layer, the reflecting member and the other configurations are the same as those of the second embodiment described above. Also, the control of the reflection direction of electromagnetic waves is the same as that of the second embodiment described above.

In the present embodiment, the position of at least one dielectric layer can be matched by matching the positions of the two adjacent sides of at least one dielectric layer on the basis of the two adjacent sides of the substrate. After matching the position of at least one dielectric layer, for the other dielectric layers, for example, the positions of the other dielectric layers may be matched by butting the edge of the dielectric layer against the edge of the adjacent dielectric layer as well as on the basis of the side of the substrate. Also, for the other dielectric layers, each of the dielectric layers may include a third alignment mark, and the relative position of each of the dielectric layers may be matched by using the third alignment mark. Also, for the other dielectric layers, the positional matching by the third alignment marks of the dielectric layers and the positional matching by butting the edges of the dielectric layers may be used in combination. Also, for all the dielectric layers, positions of all the dielectric layers may be matched by matching the positions of the two adjacent sides of the dielectric layer on the basis of the two adjacent sides of the substrate.

Specific examples of the positional matching of the dielectric layers are as described above.

Also, on the occasion of matching the positions of the dielectric layers, in the case of butting the edge of the dielectric layer against the edge of the adjacent dielectric layer, the edge of the dielectric layer may be butted against the edge of the adjacent dielectric layer through a spacer.

In the present embodiment, the dielectric layer may include a third alignment mark. The third alignment mark is a mark for matching the positions of the dielectric layers, and is a mark for matching the relative position of each of the dielectric layers.

The third alignment mark is the same as that of the second embodiment described above. The third alignment mark is preferably disposed in the outer periphery region of the dielectric layer. In the case of butting the edge of the dielectric layer against the edge of the adjacent dielectric layer, deviation in a parallel direction to the edge of the dielectric layer will be easily adjusted.

In the present embodiment, the dielectric layer may include a fourth identification mark for identifying the dielectric layer. The fourth identification mark is the same as that of the second embodiment described above.

In the present embodiment, the adjacent dielectric layers may include a concave and convex part capable of fitting each other on side surfaces facing to each other, and the adjacent dielectric layers may be disposed so that the concave and convex part fits each other. Fitting of the concave and convex part may facilitate the positional matching of a plurality of the dielectric layers. In this case, the concave and convex part substantially works like the third alignment mark. The concave and convex part is the same as the concave and convex part of the reflecting structure of the second embodiment described above.

The size of the dielectric layer is the same as the second embodiment described above.

In the present embodiment, as described above, the substrate does not include a first alignment mark, but the positions of the two adjacent sides of at least one dielectric layer are matched on the basis of the two adjacent sides of the substrate, and thereby the position of at least one dielectric layer is matched. Thus, unevenness of the sizes of the outer shapes of the dielectric layers is preferably less than 1/2 of the wavelength of the electromagnetic waves in a particular frequency band, more preferably 1/5 or less thereof, and further preferably 1/10 or less thereof. For example, it varies depending on the kinds of materials and machines or the likes, but the unevenness of the sizes of the cutting process is generally about ± 1 mm. For this reason, the unevenness of the sizes of the outer shapes of the dielectric layers can satisfy less than 1/2 of the wavelength of the electromagnetic waves in a particular frequency band.

In the present embodiment, the reflection properties of a plurality of the dielectric layers may be the same and may be different from one another. The configurations when the reflection properties of a plurality of the dielectric layers differ from one another are the same as those of the second embodiment described above.

The frequency selective reflector in the present embodiment reflects electromagnetic waves in a particular frequency band in a direction different from a regular reflection direction. The frequency band of the electromagnetic waves is the same as in the first embodiment described above. As described above, since the unevenness of the sizes of the outer shapes of the dielectric layers is preferably less than 1/2 of the wavelength of the electromagnetic waves in a particular frequency band, the longer the wavelength of the electromagnetic waves, that is, the shorter the frequency band of the electromagnetic waves, the larger the unevenness of the sizes of the outer shapes is allowed. For this reason, the frequency band of the electromagnetic waves is preferably low in the specified range. The specifics of the frequency band of the electromagnetic waves are the same as those of the third embodiment described above.

The frequency selective reflector in the present embodiment can be used, for example, as a frequency selective reflector for communication, and is suitable as a frequency selective reflector for mobile communication, among others.

### 3. Other configurations

The reflecting structure of the present embodiment may include configurations other than the frequency selective reflector and the substrate as required. Examples of the other configurations may include a second adhesive layer, a fixing member, and an interference mitigating layer. These configurations are the same as those of the first embodiment described above.

### B. Method for producing reflecting structure

The method for producing a reflecting structure in the present disclosure is a method for producing a reflecting structure producing a reflecting structure including a plurality of frequency selective reflectors reflecting electromagnetic waves in a particular frequency band in a direction different from a regular reflection direction, the method including: a disposing step of disposing the plurality of frequency selective reflectors side by side on one surface of a supporting body including a first alignment mark, so that a distance between adjacent the frequency selective reflectors becomes less than 1/2 of a wavelength of the electromagnetic waves.

The present disclosure exhibits the same effect as that of the first embodiment of the reflecting structure described above.

The frequency selective reflector is the same as the frequency selective reflector in the first embodiment of the reflecting structure described above.

The supporting body is a member that supports the frequency selective reflector, and includes a first alignment mark. The supporting body may be the substrate in the first embodiment of the reflecting structure, and may be a wall, a window, a ceiling, a floor, a signboard and the like.

The first alignment mark is the same as the first alignment mark in the first embodiment of the reflecting structure described above. As the method for forming the first alignment mark, the first alignment mark may be directly formed on the supporting body, and a film including the first alignment mark may be disposed on one surface of the supporting body.

Also, the plan view shape of the first alignment mark may include a horizontal line and a vertical line. The horizontal line and the vertical line of the first alignment mark can be referred to as the two adjacent two sides of the substrate in the third embodiment of the reflecting structure.

The disposing step is in the same contents as those described in the first embodiment or the third embodiment of the reflecting structure described above.

### C. Frequency selective reflector set

The frequency selective reflector set in the present disclosure has three embodiments. In the following, each embodiment will be explained separately.

### I. First embodiment of frequency selective reflector set

The first embodiment of the frequency selective reflector set in the present disclosure is a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; and the frequency selective reflectors include a second identification mark configured to identify the frequency selective reflectors.

The present disclosure exhibits the same effect as that when the frequency selective reflector includes the second identification mark in the first embodiment of the reflecting structure, or when the frequency selective reflector includes the second identification mark in the third embodiment of the reflecting structure.

The frequency selective reflector is the same as the frequency selective reflector in the first embodiment of the reflecting structure or the frequency selective reflector in the third embodiment of the reflecting structure described above.

### II. Second embodiment of frequency selective reflector set

The second embodiment of the frequency selective reflector set in the present disclosure is a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; the frequency selective reflectors include a reflecting member reflecting the electromagnetic waves; in the reflecting member, a plurality of reflective elements with different sizes is arranged; and an arrangement of the reflective elements in the plurality of frequency selective reflectors differs from one another.

The present disclosure exhibits an effect same as when the frequency selective reflector is the first aspect in the first embodiment of the reflecting structure and the reflection properties of the plurality of the frequency selective reflectors differ from one another, or when the frequency selective reflector is the first aspect in the third embodiment of the reflecting structure and the reflection properties of the plurality of frequency selective reflectors differ from one another.

The frequency selective reflector is the same as the frequency selective reflector in the first embodiment of the reflecting structure or the frequency selective reflector in the third embodiment of the reflecting structure described above.

### III. Third embodiment of frequency selective reflector set

The third embodiment of the frequency selective reflector set in the present disclosure is a frequency selective reflector set including a plurality of frequency selective reflectors reflecting electromagnetic waves in a particular frequency band in a direction different from a regular reflection direction, wherein the plurality of frequency selective reflectors is used by being disposed side by side on an installation surface; the frequency selective reflectors include, in an order from the installation surface side, a reflecting member reflecting the electromagnetic waves, and a dielectric layer transmitting the electromagnetic waves; in the dielectric layer, a plurality of cell regions with different thicknesses is arranged; and an arrangement of the cell regions in the plurality of frequency selective reflectors differs from one another.

The present disclosure exhibits an effect same as when the frequency selective reflector is the second aspect in the first embodiment of the reflecting structure and the reflection properties of the plurality of frequency selective reflectors differ from one another, or when the frequency selective reflector is the second aspect in the third embodiment of the reflecting structure and the reflection properties of the plurality of frequency selective reflectors differ from one another.

The frequency selective reflector is the same as the frequency selective reflector in the first embodiment of the reflecting structure or the frequency selective reflector in the third embodiment of the reflecting structure described above.

Incidentally, the present disclosure is not limited to the embodiments. The embodiments are exemplification, and any other variations are intended to be included in the technical scope of the present disclosure if they have substantially the same constitution as the technical idea described in the claims of the present disclosure and have similar operation and effect thereto.

### Examples

The present disclosure will be hereinafter explained in details with reference to Examples.

### [Comparative Example 1]

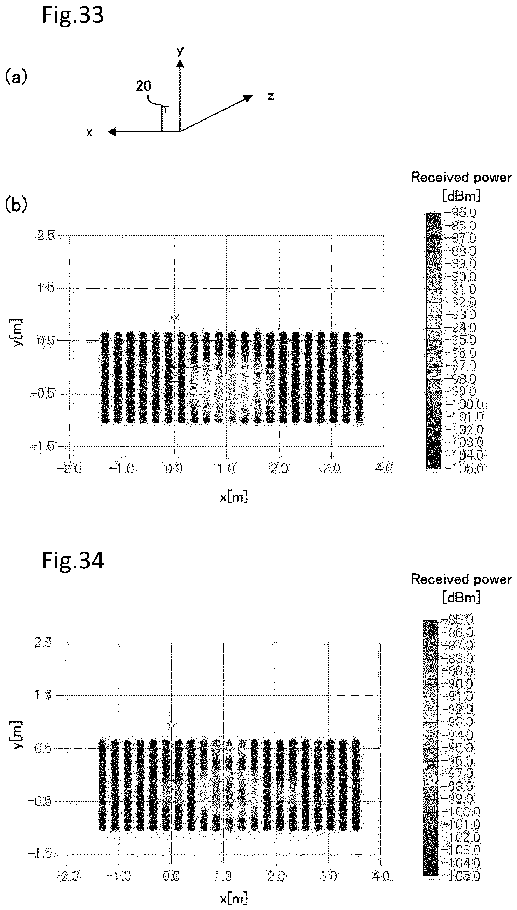

Simulation of the reflection properties of a reflecting structure including a frequency selective reflector was performed. In the simulation, a model of the reflecting structure in which one frequency selective reflector was disposed on a substrate having a A5 size was used. The frequency selective reflector had a structure including, in an order from the substrate side, a reflecting member, and a dielectric layer with a specified thickness distribution. Also, as shown in FIG. 33 (a), a reflection electric power when the reflecting structure 20 was placed at the origin, and when designed to reflect the electromagnetic wave of 28 GHz incident from the direction (xᵢₙ, yᵢₙ, zᵢₙ) = (-9, 2, 8.4) [m] was reflected in (xₒᵤₜ, yₒᵤₜ, zₒᵤₜ) = (1, -0.5, 14.9), was calculated at the position of zₒᵤₜ = 14.9 [m]. Also, the gain of the frequency selective reflector was 0 dBi. The result of the simulation of the distribution of the received power (dBm) is shown in FIG. 33 (b).

### [Example 1]

Simulation of the reflection properties of a reflecting structure including a frequency selective reflector was performed. In the simulation, a model of the reflecting structure in which two frequency selective reflectors having A5 size were disposed side by side on a substrate having A5 size was used. In the reflecting structure, a distance between the adjacent frequency selective reflectors was 1/2 of a wavelength of the electromagnetic wave of 28 GHz. Also, the frequency selective reflector had a structure including, in an order from the substrate side, a reflecting member, and a dielectric layer with a specified thickness distribution. Also, as shown in FIG. 33 (a), a reflection electric power when the reflecting structure 20 was placed at the origin, and when designed to reflect the electromagnetic wave of 28 GHz incident from the direction (xᵢₙ, yᵢₙ, zᵢₙ) = (-9, 2, 8.4) [m] was reflected in (xₒᵤₜ, Yₒᵤₜ, zₒᵤᵣ) = (1, -0.5, 14.9), was calculated at the position of zₒᵤₜ = 14.9 [m]. Also, of the gain of the frequency selective reflector was 0 dBi. The result of the simulation of the distribution of the received power (dBm) is shown in FIG. 34.

To Comparative Example 1, in Example 1, the power of the main reflection direction increased in 3 to 6 [dB] since a plurality of frequency selective reflectors was tiled so that the distance between the adjacent frequency selective reflectors became 1/2 of the wavelength of the electromagnetic wave. This is equal to a behavior of reflection power intensity by metal flat plates with different sizes, including the change in the power intensity distribution, which is concentration of the power in the main reflection direction when the area of the frequency selective reflector is increased. Thereby, it has been found that the reflection power meeting the area ratio of the frequency selective reflector was obtained.

### [Reference Example 1]

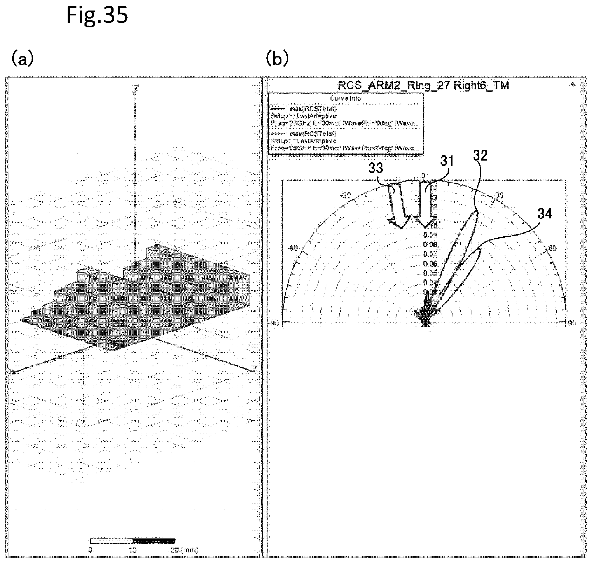

Simulation of the reflection properties of the frequency selective reflector was performed. As the model used in the simulation, as shown in FIG. 35 (a), the unit structure of the dielectric layer included a thickness distribution in which the thickness increases in one direction, and included six cell regions of which thickness differs from one another, and the dielectric layer was the one in which the unit structure had a periodic structure repeatedly arranged in one direction. Also, in the simulation, the reflecting member was a model in which ring-shaped reflective elements were regularly arranged, resonated at the frequency of the incident wave, and reflected the electromagnetic waves at that frequency. The following parameters were also used in the simulation.

Frequency of the incident wave: 28 GHz
Incident angle of the incident wave: 0°, -10°
The desired reflection angle of the reflected wave: 27°, 37°
The difference in relative reflection phase in neighboring cell regions: 60°.

The results of the simulation are shown in FIG. 35 (b). When the incident angle was 0°, which means the reflection to the incident from the front surface direction 31, was shown in solid line indicated as reference sign 32, and if the incident angle was -10°, which means the reflection to incidence from -10° direction 33, was shown in solid line indicated as reference sign 34. It can be seen that when the incident angle was 0°, it was reflected to the +27° direction from the regular reflection direction, and when the incident angle was -10°, it was reflected to the +37° direction from the regular reflection direction.

### [Reference Example 2]

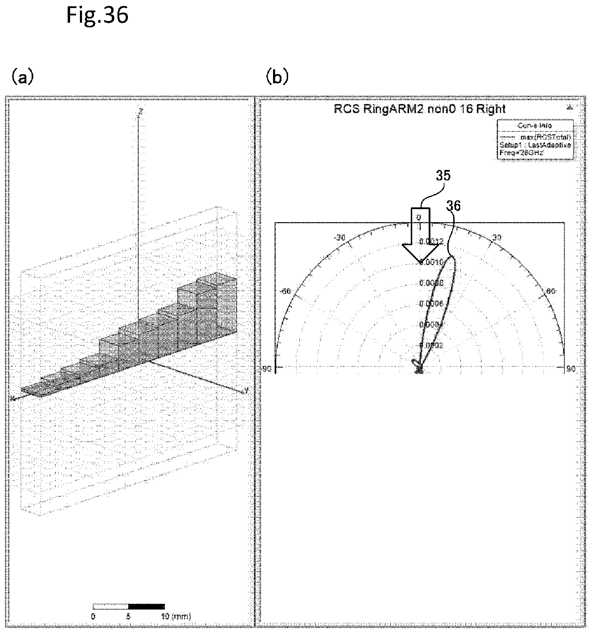

Simulation of the reflection properties of the frequency selective reflector was performed. As the model used in the simulation, as shown in FIG. 36 (a), the unit structure of the dielectric layer included a thickness distribution in which the thickness increases in one direction, and included ten cell regions of which thickness differs from one another, and the dielectric layer was the one in which the unit structure had a periodic structure repeatedly arranged in one direction. Also, in the simulation, the reflecting member was a model in which ring-shaped reflective elements were regularly arranged, resonated at the frequency of the incident wave, and reflected the electromagnetic waves at that frequency. The following parameters were also used in the simulation.

Frequency of the incident wave: 28 GHz
Incident angle of the incident wave: 0°
The desired reflection angle of the reflected wave: 16°
The difference in relative reflection phase in neighboring cell regions: 36°.

The results of the simulation are shown in FIG. 36 (b). If the incident angle was 0°, which means the reflection to incidence from the front direction 35, was shown in solid line indicated as reference sign 36. It can be seen that when the incident angle was 0°, it was reflected to +16° direction from the regular reflection direction. Also, the reflection direction of FIG. 36 (b) was closer to the regular reflection direction compared to that of FIG. 35 (b), but this is because the unit structure of the dielectric layer in FIG. 35 (a) had six cell regions, whereas there were ten cell regions in FIG. 36 (a), and the length of the unit structure in the predetermined direction of increasing thickness was long.

### [Reference Example 3]

First, in accordance with the model of the reflecting member of Reference Example 1, a copper foil-attached PET film was etched to create a reflecting member in which ring-shaped reflective elements are regularly arranged. Also, a dielectric layer was formed by a 3D printer in accordance with the model of the dielectric layer of Reference Example 1. The dielectric layer was then applied on the reflecting member to create a frequency selective reflector.

The reflection properties of the frequency selective reflector were measured using a compact range measurement system and a network analyzer. The reflection properties of the frequency selective reflector of Reference Example 3 substantially matched with the simulation results of Reference Example 1.

### [Reference Example 4]

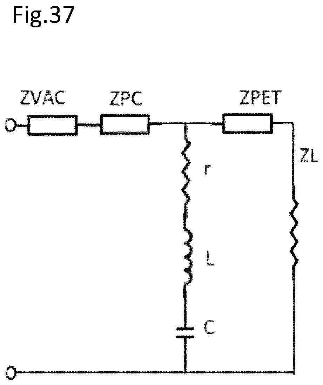

The reflection phase was calculated for a frequency selective reflector with a reflecting member including frequency selective surface (FSS) and a dielectric layer, using a general transmission line equivalent circuit, as shown in FIG. 37, in the analysis of the reflect array. The symbols in FIG. 37 are as follows:
ZVAC: A transmission line with a characteristic impedance of air. The line length is a length obtained by subtracting the thickness of the dielectric layer from a phase observation surface set at any distance farther than the top surface of the dielectric layer.
ZPC: A transmission line with a characteristic impedance of a dielectric layer. The line length is the thickness of the dielectric layer h.
r: Resistance of the ring-shaped reflective element of the FSS.
L: The inductance of the ring-shaped reflective element of the FSS.
C: Capacity of the ring-shaped reflective element of the FSS.
ZPET: A transmission line having a dielectric constant of a dielectric substrate on which the ring-shaped reflective element of FSS is arranged. The line length is the thickness of the dielectric substrate.
ZL: The characteristic impedance of the space on the back surface of the dielectric substrate.

As a result, the reflection phase change due to the resonance frequency shift caused by the superposition of the dielectric layers of different thicknesses in the reflection phase was at most several tens of degrees, which was around 25% of the maximum reflection phase 360°, and other reflection phase changes were calculated to be due to wavelength shortening in the dielectric layer. Further, even if the positions of the reflecting member including the frequency selective surface and the dielectric layer are misaligned, the shift is equalized throughout the frequency selective reflector, but it can be concluded that there is little effect on the reflection direction given that the reflection phase with the neighboring cell region may be equal to make the reflected wave to be a plane wave.

The present disclosure provides the following inventions.
[1] A reflecting structure including a frequency selective reflector reflecting electromagnetic waves in a particular frequency band in a direction different from a regular reflection direction, the reflecting structure comprising:
   a substrate including a first alignment mark; and
   a plurality of the frequency selective reflectors disposed side by side on one surface of the substrate, wherein
   a distance between adjacent the frequency selective reflectors is less than 1/2 of a wavelength of the electromagnetic waves.
[2] The reflecting structure according to [1], wherein the frequency selective reflector includes a second alignment mark.
[3] The reflecting structure according to [1], wherein the substrate includes a light transmittance, and
   an outer periphery region of the frequency selective reflector includes a light non-transmittance.
[4] The reflecting structure according to any one of [1] to [4], wherein each of the adjacent the frequency selective reflectors includes a concave and convex part capable of fitting each other on side surfaces facing to each other, and the adjacent the frequency selective reflectors are disposed so that the concave and convex part fits each other.
[5] The reflecting structure according to [5], wherein a thickness of the concave and convex part of the adjacent the frequency selective reflectors is equal.
[6] A reflecting structure including a frequency selective reflector reflecting electromagnetic waves in a particular frequency band in a direction different from a regular reflection direction, the reflecting structure comprising:
   a substrate; and
   a plurality of the frequency selective reflectors disposed side by side on one surface of the substrate, wherein
   two adjacent sides in at least one of the frequency selective reflectors are aligned with two adjacent sides in the substrate; and
   a distance between adjacent the frequency selective reflectors is less than 1/2 of a wavelength of the electromagnetic waves.
[7] The reflecting structure according to any one of [1] to [6], wherein an adhesive part is disposed between adjacent the frequency selective reflectors.
[8] The reflecting structure according to any one of [1] to [7], wherein the frequency selective reflector includes a reflecting member reflecting the electromagnetic waves; and
   in the reflecting member, a plurality of reflective elements with different sizes is arranged; and
   an arrangement of the reflective elements in the plurality of the frequency selective reflectors differs from one another.
[9] The reflecting structure according to any one of [1] to [7], the frequency selective reflector includes, in an order from the substrate side, a reflecting member reflecting the electromagnetic waves, and a dielectric layer transmitting the electromagnetic waves,
   in the dielectric layer, a plurality of cell regions with different thicknesses is arranged; and
   an arrangement of the cell regions in the plurality of the frequency selective reflectors differs from one another.
[10] The reflecting structure according to any one of [1] to [9], wherein the frequency selective reflector includes a second identification mark configured to identify the frequency selective reflector.
[11] The reflecting structure according to any one of [1] to [10], wherein the substrate includes a first identification mark configured to identify a position of the frequency selective reflector.
[12] The reflecting structure according to any one of [1] to [11], the frequency selective reflector includes, in an order from the substrate side,
   a dielectric layer that includes a concave and convex structure in which a plurality of unit structures with a thickness distribution of increasing thickness in a predetermined direction is disposed, and that transmits the electromagnetic waves, wherein
   the unit structure of the dielectric layer includes a plurality of cell region of which thickness differs from one another;
   in each of the unit structure of the dielectric layer, in a graph setting a horizontal axis as a length of the predetermined direction of the unit structure, and setting a vertical axis as a relative reflection phase when the electromagnetic waves are transmitted through the dielectric layer, reflected by the reflecting member and emitted to the incident side of the electromagnetic wave by being transmitted through the dielectric layer again, in the graph, a value of the relative reflection phase of the electromagnetic waves is over -360° and 0° or less, when a point corresponding to a central position of the predetermined direction in each cell region and corresponding to the relative reflection phase of the electromagnetic waves in each cell region are plotted, and a straight line passing through a point corresponding to a minimum thickness cell region having a minimum thickness is drawn, each point is on a same straight line;
   the dielectric layer includes, as the unit structure, at least a first unit structure including three or more of the cell region of which thickness differs from one another; and
   a reflection direction of the electromagnetic waves is controlled by controlling a relative reflection phase distribution of the electromagnetic waves by the thickness distribution of the dielectric layer.
[13] The reflecting structure according to [12], wherein the reflecting member is a frequency selective plate reflecting only the electromagnetic waves.
[14] The reflecting structure according to [13], wherein the reflecting member includes a reflection phase controlling function controlling a reflection phase of the electromagnetic waves.
[15] The reflecting structure according to any one of [1] to [11], wherein the frequency selective reflector includes a reflecting member reflecting the electromagnetic waves; and
   the reflecting member includes a reflection phase control function controlling a reflection phase of the electromagnetic waves.
[16] The reflecting structure according to [15], the reflecting member includes a dielectric substrate and a plurality of reflective elements disposed on at least one surface of the dielectric substrate, and
   the reflective elements are not disposed on an end part region where adjacent the frequency selective reflectors face to each other.
[17] The reflecting structure according to [16], wherein, when a reflection intensity of the electromagnetic waves in a reflecting structure in which the reflective elements are disposed in the end part region where adjacent the frequency selective reflectors face to each other is regarded as 100%, a reflection intensity of the electromagnetic waves is over 85%.
[18] A reflecting structure including a frequency selective reflector reflecting electromagnetic waves in a particular frequency band in a direction different from a regular reflection direction, the reflecting structure comprising:
   a substrate including a first alignment mark; and
   the frequency selective reflector disposed on one surface of the substrate, wherein
   the frequency selective reflector includes:
      a reflecting member that is disposed on one surface of the substrate, and reflects the electromagnetic waves, and
      a plurality of dielectric layers that is disposed side by side on the reflecting member side surface of the substrate, and transmits the electromagnetic waves, wherein
   a distance between adjacent the dielectric layers is less than 1/2 of a wavelength of the electromagnetic waves,
   the dielectric layers include a concave and convex structure in which a plurality of unit structures with a thickness distribution of increasing thickness in a predetermined direction is disposed,
   the unit structure of the dielectric layer includes a plurality of cell region of which thickness differs from one another;
   in each of the unit structure of the dielectric layer, in a graph setting a horizontal axis as a length of the predetermined direction of the unit structure, and setting a vertical axis as a relative reflection phase when the electromagnetic waves are transmitted through the dielectric layer, reflected by the reflecting member and emitted to the incident side of the electromagnetic wave by being transmitted through the dielectric layer again, in the graph, a value of the relative reflection phase of the electromagnetic waves is over -360° and 0° or less, when a point corresponding to a central position of the predetermined direction in each cell region and corresponding to the relative reflection phase of the electromagnetic waves in each cell region are plotted, and a straight line passing through a point corresponding to a minimum thickness cell region having a minimum thickness is drawn, each point is on a same straight line;
   the dielectric layer includes, as the unit structure, at least a first unit structure including three or more of the cell region of which thickness differs from one another; and
   a reflection direction of the electromagnetic waves is controlled by controlling a relative reflection phase distribution of the electromagnetic waves by the thickness distribution of the dielectric layers.
[19] A reflecting structure including a frequency selective reflector reflecting electromagnetic waves in a particular frequency band in a direction different from a regular reflection direction, the reflecting structure comprising:
   a substrate; and
   the frequency selective reflector disposed on one surface of the substrate, wherein
   the frequency selective reflector includes:
      a reflecting member that is disposed on one surface of the substrate, and reflects the electromagnetic waves, and
      a plurality of dielectric layers that is disposed side by side on the reflecting member side surface of the substrate, and transmits the electromagnetic waves, wherein
   two adjacent sides in at least one of the dielectric layers are aligned with two adjacent sides in the substrate,
   a distance between adjacent the dielectric layers is less than 1/2 of a wavelength of the electromagnetic waves,
   the dielectric layers include a concave and convex structure in which a plurality of unit structures with a thickness distribution of increasing thickness in a predetermined direction is disposed,
   the unit structure of the dielectric layer includes a plurality of cell region of which thickness differs from one another;
   in each of the unit structure of the dielectric layer, in a graph setting a horizontal axis as a length of the predetermined direction of the unit structure, and setting a vertical axis as a relative reflection phase when the electromagnetic waves are transmitted through the dielectric layer, reflected by the reflecting member and emitted to the incident side of the electromagnetic wave by being transmitted through the dielectric layer again, in the graph, a value of the relative reflection phase of the electromagnetic waves is over -360° and 0° or less, when a point corresponding to a central position of the predetermined direction in each cell region and corresponding to the relative reflection phase of the electromagnetic waves in each cell region are plotted, and a straight line passing through a point corresponding to a minimum thickness cell region having a minimum thickness is drawn, each point is on a same straight line;
   the dielectric layer includes, as the unit structure, at least a first unit structure including three or more of the cell region of which thickness differs from one another; and
   a reflection direction of the electromagnetic waves is controlled by controlling a relative reflection phase distribution of the electromagnetic waves by the thickness distribution of the dielectric layers.
[20] The reflecting structure according to [18] or [19], wherein the reflecting member includes a dielectric substrate, and a plurality of reflective elements disposed on at least one surface of the dielectric substrate, and
   the dielectric substrate is a different member from the substrate, and
   the dielectric substrate is disposed one with respect to the substrate.
[21] The reflecting structure according to [18] or [19], wherein the reflecting member includes a dielectric substrate, and a plurality of reflective elements disposed on at least one surface of the dielectric substrate, and the dielectric substrate also works as the substrate.
[22] The reflecting structure according to [18] or [19], wherein the reflecting member includes a plurality of reflective elements disposed in contact with the substrate.
[23] The reflecting structure according to any one of [18] to [22], wherein the dielectric layers include a third alignment mark.
[24] The reflecting structure according to any one of [18] to [23], wherein a second adhesive part is disposed between adjacent the dielectric layers.
[25] The reflecting structure according to any one of [18] to [24], wherein adjacent the dielectric layers include a concave and convex part capable of fitting each other on side surfaces facing to each other, and the adjacent the dielectric layers are disposed so that the concave and convex part fits each other.
[26] The reflecting structure according to [25], wherein a thickness of the concave and convex part of the adjacent the dielectric layers is equal.
[27] The reflecting structure according to any one of [18] to [26], wherein the dielectric layer includes a fourth identification mark configured to identify the dielectric layer.
[28] The reflecting structure according to any one of [18] to [27], wherein the substrate includes a third identification mark configured to identify a position of the dielectric layers.
[29] The reflecting structure according to any one of [18] to [28], wherein the reflecting member is a frequency selective plate reflecting only the electromagnetic waves.
[30] The reflecting structure according to [29], wherein the reflecting member includes a reflection phase controlling function controlling a reflection phase of the electromagnetic waves.
[31] A method for producing a reflecting structure producing a reflecting structure including a plurality of frequency selective reflectors reflecting electromagnetic waves in a particular frequency band in a direction different from a regular reflection direction, the method comprising:
   a disposing step of disposing the plurality of frequency selective reflectors side by side on one surface of a supporting body including a first alignment mark, so that a distance between adjacent the frequency selective reflectors becomes less than 1/2 of a wavelength of the electromagnetic waves.
[32] A method for producing the reflecting structure according to [31], wherein the frequency selective reflector includes a second alignment mark.
[33] A method for producing the reflecting structure according to [31], wherein the supporting body includes a light transmittance, and
   an outer periphery region of the frequency selective reflector includes light non-transmittance.
[34] A frequency selective reflector set including a plurality of frequency selective reflectors reflecting electromagnetic waves in a particular frequency band in a direction different from a regular reflection direction, wherein
   the plurality of frequency selective reflectors is used by being disposed side by side on an installation surface;
   the frequency selective reflectors include a second identification mark configured to identify the frequency selective reflectors.
[35] A frequency selective reflector set including a plurality of frequency selective reflectors reflecting electromagnetic waves in a particular frequency band in a direction different from a regular reflection direction, wherein
   the plurality of frequency selective reflectors is used by being disposed side by side on an installation surface;
   the frequency selective reflectors include a reflecting member reflecting the electromagnetic waves;
   in the reflecting member, a plurality of reflective elements with different sizes is arranged; and
   an arrangement of the reflective elements in the plurality of frequency selective reflectors differs from one another.
[36] A frequency selective reflector set including a plurality of frequency selective reflectors reflecting electromagnetic waves in a particular frequency band in a direction different from a regular reflection direction, wherein
   the plurality of frequency selective reflectors is used by being disposed side by side on an installation surface;
   the frequency selective reflectors include, in an order from the installation surface side, a reflecting member reflecting the electromagnetic waves, and a dielectric layer transmitting the electromagnetic waves;
   in the dielectric layer, a plurality of cell regions with different thicknesses is arranged; and
   an arrangement of the cell regions in the plurality of frequency selective reflectors differs from one another.

### Reference Sings List

1 frequency selective reflector
2 reflecting member
3 reflective element
4 dielectric substrate
5 dielectric layer
6 adhesive layer
7 reflective layer
8 space
10, 10a, 10b unit structure
11a to 11g, 12a to 12f, 13a to 13e cell region
20 reflecting structure
21 substrate
22 first alignment mark
23 first identification mark
24 second alignment mark
25 second identification mark
26 concave and convex part
27 end part region
28 adhesive part
D1 predetermined direction
L length of unit structure in predetermined direction in which thickness increases
d1, d2 distance between adjacent frequency selective reflectors
d5, d6 distance between adjacent dielectric layers
t1, t2, t3, t4, t5, t6 thickness of cell region

## Claims

1. A reflecting structure including a frequency selective reflector reflecting electromagnetic waves in a particular frequency band in a direction different from a regular reflection direction, the reflecting structure comprising:
a substrate including a first alignment mark; and
a plurality of the frequency selective reflectors disposed side by side on one surface of a z substrate, wherein
a distance between adjacent the frequency selective reflectors is less than 1/2 of a wavelength of the electromagnetic waves.

2. The reflecting structure according to claim 1, wherein the frequency selective reflector includes a second alignment mark.

3. The reflecting structure according to claim 1, wherein
the substrate includes a light transmittance, and
an outer periphery region of the frequency selective reflector includes a light non-transmittance.

4. The reflecting structure according to any one of claims 1 to 3, wherein each of the adjacent the frequency selective reflectors includes a concave and convex part capable of fitting each other on side surfaces facing to each other, and the adjacent the frequency selective reflectors are disposed so that the concave and convex part fits each other.

5. The reflecting structure according to claim 4, wherein a thickness of the concave and convex part of the adjacent the frequency selective reflectors is equal.

6. A reflecting structure including a frequency selective reflector reflecting electromagnetic waves in a particular frequency band in a direction different from a regular reflection direction, the reflecting structure comprising:
a substrate; and
a plurality of the frequency selective reflectors disposed side by side on one surface of the substrate, wherein
two adjacent sides in at least one of the frequency selective reflectors are aligned with two adjacent sides in the substrate; and
a distance between adjacent the frequency selective reflectors is less than 1/2 of a wavelength of the electromagnetic waves.

7. The reflecting structure according to claim **1,** claim **2,** claim 3 or claim **6,** wherein an adhesive part is disposed between adjacent the frequency selective reflectors.

8. The reflecting structure according to claim **1,** claim **2,** claim 3 or claim **6,**
the frequency selective reflector includes a reflecting member reflecting the electromagnetic waves,
in the reflecting member, a plurality of reflective elements with different sizes is arranged, and
an arrangement of the reflective elements in the plurality of the frequency selective reflectors differs from one another.

9. The reflecting structure according to claim **1,** claim **2,** claim 3 or claim **6,**
the frequency selective reflector includes, in an order from the substrate side, a reflecting member reflecting the electromagnetic waves, and a dielectric layer transmitting the electromagnetic waves,
in the dielectric layer, a plurality of cell regions with different thicknesses is arranged, and
an arrangement of the cell regions in the plurality of the frequency selective reflectors differs from one another.

10. The reflecting structure according to claim 1, claim 2, claim 3 or claim 6, wherein the frequency selective reflector includes a second identification mark configured to identify the frequency selective reflector.

11. The reflecting structure according to claim 10, wherein the substrate includes a first identification mark configured to identify a position of the frequency selective reflector.

12. The reflecting structure according to claim 1, claim 2, claim 3 or claim 6,
the frequency selective reflector includes, in an order from the substrate side,
a reflecting member reflecting the electromagnetic waves,
a dielectric layer that includes a concave and convex structure in which a plurality of unit structures with a thickness distribution of increasing thickness in a predetermined direction is disposed, and that transmits the electromagnetic waves, wherein
the unit structures of the dielectric layer include a plurality of cell regions with different thicknesses,
in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line,
the dielectric layer includes, as the unit structure, at least a first unit structure including three or more of the cell regions of which thicknesses differ from one another, and
a reflection direction of the electromagnetic waves is controlled by controlling a relative reflection phase distribution of the electromagnetic waves by the thickness distribution of the dielectric layer.

13. The reflecting structure according to claim 12, wherein the reflecting member is a frequency selective plate reflecting only the electromagnetic waves.

14. The reflecting structure according to claim 13, wherein the reflecting member includes a reflection phase controlling function controlling a reflection phase of the electromagnetic waves.

15. The reflecting structure according to claim 1, claim 2, claim 3 or claim 6,
the frequency selective reflector includes a reflecting member reflecting the electromagnetic waves, and
the reflecting member includes a reflection phase controlling function controlling a reflection phase of the electromagnetic waves.

16. The reflecting structure according to claim 15,
the reflecting member includes a dielectric substrate and a plurality of reflective elements disposed on at least one surface of the dielectric substrate, and
the reflective elements are not disposed on an end part region where adjacent the frequency selective reflectors face to each other.

17. The reflecting structure according to claim 16, wherein, when a reflection intensity of the electromagnetic waves in a reflecting structure in which the reflective elements are disposed in the end part region where adjacent the frequency selective reflectors face to each other is regarded as 100%, a reflection intensity of the electromagnetic waves is over 85%.

18. A reflecting structure including a frequency selective reflector reflecting electromagnetic waves in a particular frequency band in a direction different from a regular reflection direction, the reflecting structure comprising:
a substrate including a first alignment mark; and
the frequency selective reflector disposed on one surface of the substrate, wherein
the frequency selective reflector includes:
a reflecting member that is disposed on one surface of the substrate and reflects the electromagnetic waves, and
a plurality of dielectric layers that is disposed side by side on the reflecting member side surface of the substrate, and transmits the electromagnetic waves, wherein
a distance between adjacent the dielectric layers is less than 1/2 of a wavelength of the electromagnetic waves,
the dielectric layer includes a concave and convex structure in which a plurality of unit structures with a thickness distribution of increasing thickness in a predetermined direction is disposed,
the unit structures of the dielectric layer include a plurality of cell regions with different thicknesses,
in each of the unit structures of the dielectric layer, in a graph setting a horizontal axis as a length of the predetermined direction of the unit structures, and setting a vertical axis as a relative reflection phase when the electromagnetic waves are transmitted through the dielectric layer, reflected by the reflecting member and emitted to an incident side of the electromagnetic waves by being transmitted through the dielectric layer again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line,
the dielectric layer includes, as the unit structure, at least a first unit structure including three or more of the cell regions of which thicknesses differ from one another, and
a reflection direction of the electromagnetic waves is controlled by controlling a relative reflection phase distribution of the electromagnetic waves by the thickness distribution of the dielectric layer.

19. A reflecting structure including a frequency selective reflector reflecting electromagnetic waves in a particular frequency band in a direction different from a regular reflection direction, the reflecting structure comprising:
a substrate; and
the frequency selective reflector disposed on one surface of the substrate, wherein
the frequency selective reflector includes:
a reflecting member that is disposed on one surface of the substrate, and reflects the electromagnetic waves, and
a plurality of dielectric layers that is disposed side by side on the reflecting member side surface of the substrate, and transmits the electromagnetic waves, wherein
two adjacent sides in at least one of the dielectric layers are aligned with two adjacent sides in the substrate, a distance between adjacent the dielectric layers is less than 1/2 of a wavelength of the electromagnetic waves,
the dielectric layers include a concave and convex structure in which a plurality of unit structures with a thickness distribution of increasing thickness in a predetermined direction is disposed,
the unit structures of the dielectric layers include a plurality of cell regions with different thicknesses,
in each of the unit structures of the dielectric layers, in a graph setting a horizontal axis as a length of the predetermined direction of the unit structures, and setting a vertical axis as a relative reflection phase when the electromagnetic waves are transmitted through the dielectric layers, reflected by the reflecting member and emitted to an incident side of the electromagnetic waves by being transmitted through the dielectric layers again, in the graph, a value of the relative reflection phase of the electromagnetic waves is over -360° and 0° or less, when a point corresponding to a central position of the predetermined direction in each cell regions and corresponding to the relative reflection phase of the electromagnetic waves in each cell regions are plotted, and a straight line passing through a point corresponding to a minimum thickness cell region having a minimum thickness is drawn, each point is on a same straight line,
the dielectric layers include, as the unit structure, at least a first unit structure including three or more of the cell regions of which thicknesses differ from one another, and
a reflection direction of the electromagnetic waves is controlled by controlling a relative reflection phase distribution of the electromagnetic waves by the thickness distribution of the dielectric layers.

20. The reflecting structure according to claim 18 or claim 19, wherein
the reflecting member includes a dielectric substrate, and a plurality of reflective elements disposed on at least one surface of the dielectric substrate,
the dielectric substrate is a different member from the substrate, and
the dielectric substrate is disposed one with respect to the substrate.

21. The reflecting structure according to claim 18 or claim 19, wherein
the reflecting member includes a dielectric substrate, and a plurality of reflective elements disposed on at least one surface of the dielectric substrate, and
the dielectric substrate also works as the substrate.

22. The reflecting structure according to claim 18 or claim 19, wherein the reflecting member includes a plurality of reflective elements disposed in contact with the substrate.

23. The reflecting structure according to claim 18 or claim 19, wherein the dielectric layers include a third alignment mark.

24. The reflecting structure according to claim 18 or claim 19, wherein a second adhesive part is disposed between adjacent the dielectric layers.

25. The reflecting structure according to claim 18 or claim 19, wherein adjacent the dielectric layers include a concave and convex part capable of fitting each other on side surfaces facing to each other, and the adjacent the dielectric layers are disposed so that the concave and convex part fits each other.

26. The reflecting structure according to claim 25, wherein a thickness of the concave and convex part of the adjacent the dielectric layers is equal.

27. The reflecting structure according to claim 18 or claim 19, wherein the dielectric layer includes a fourth identification mark configured to identify the dielectric layer.

28. The reflecting structure according to claim 27, wherein the substrate includes a third identification mark configured to identify a position of the dielectric layers.

29. The reflecting structure according to claim 18 or claim 19, wherein the reflecting member is a frequency selective plate reflecting only the electromagnetic waves.

30. The reflecting structure according to claim 29, wherein the reflecting member includes a reflection phase controlling function controlling a reflection phase of the electromagnetic waves.

31. A method for producing a reflecting structure producing a reflecting structure including a plurality of frequency selective reflectors reflecting electromagnetic waves in a particular frequency band in a direction different from a regular reflection direction, the method comprising:
a disposing step of disposing the plurality of frequency selective reflectors side by side on one surface of a supporting body including a first alignment mark, so that a distance between adjacent the frequency selective reflectors becomes less than 1/2 of a wavelength of the electromagnetic waves.

32. A method for producing the reflecting structure according to claim 30, wherein the frequency selective reflector includes a second alignment mark.

33. A method for producing the reflecting structure according to claim 30, wherein
the supporting body includes a light transmittance, and
an outer periphery region of the frequency selective reflector includes light non-transmittance.

34. A frequency selective reflector set including a plurality of frequency selective reflectors reflecting electromagnetic waves in a particular frequency band in a direction different from a regular reflection direction, wherein
the plurality of frequency selective reflectors is used by being disposed side by side on an installation surface; and
the frequency selective reflectors include a second identification mark configured to identify the frequency selective reflectors.

35. A frequency selective reflector set including a plurality of frequency selective reflectors reflecting electromagnetic waves in a particular frequency band in a direction different from a regular reflection direction, wherein
the plurality of frequency selective reflectors is used by being disposed side by side on an installation surface;
the frequency selective reflectors include a reflecting member reflecting the electromagnetic waves;
in the reflecting member, a plurality of reflective elements with different sizes is arranged; and
an arrangement of the reflective elements in the plurality of frequency selective reflectors differs from one another.

36. A frequency selective reflector set including a plurality of frequency selective reflectors reflecting electromagnetic waves in a particular frequency band in a direction different from a regular reflection direction, wherein
the plurality of frequency selective reflectors is used by being disposed side by side on an installation surface;
the frequency selective reflectors include, in an order from the installation surface side, a reflecting member reflecting the electromagnetic waves, and a dielectric layer transmitting the electromagnetic waves;
in the dielectric layer, a plurality of cell regions with different thicknesses is arranged; and
an arrangement of the cell regions in the plurality of frequency selective reflectors differs from one another.
